# EUROPEAN PATENT APPLICATION

(11) **EP 4 349 934 A1**
(43) Date of publication of application: **10.04.2024**
(21) Application number: 22199528.5
(22) Date of filing: 04.10.2022
(51) Int. Cl.: C09K 11/06, H10K 50/11

(54) **A HIGHLY EFFICIENT BLUE FLUORESCENT ORGANIC EMITTER HAVING A HIGH HOMO LEVEL AND AN ORGANIC ELECTROLUMINESCENCE DEVICE COMPRISING THE SAME**

(71) Applicant: Idemitsu Kosan Co., Ltd, Tokyo 100-8321 (JP)
(72) Inventor: Lin, Chao-Chen, 4058 Basel (CH); Boufflet, Pierre, 4058 Basel (CH); Beierlein, Tilman, 4058 Basel (CH); Schäfer, Thomas, 4058 Basel (CH); Murer, Peter, 4058 Basel (CH)
(74) Representative: Hollah, Dorothee

(57) **Abstract**

A highly efficient blue fluorescent organic emitter represented by formula (I) 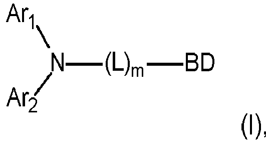 having a highest occupied molecular orbital (HOMO) of more than 70% electron density localized on the Ar₁Ar₂N-L unit and having an energy of lower than 4.9 eV in absolute numbers, a HOMO-1 having more than 70% electron density localized on the BD unit and has an energy of higher than 4.75 eV in absolute numbers, and a lowest unoccupied molecular orbital (LUMO) having more than 70% electron density localized on the BD unit; a compound represented by formula (I), wherein BD is a group selected from the groups consisting of 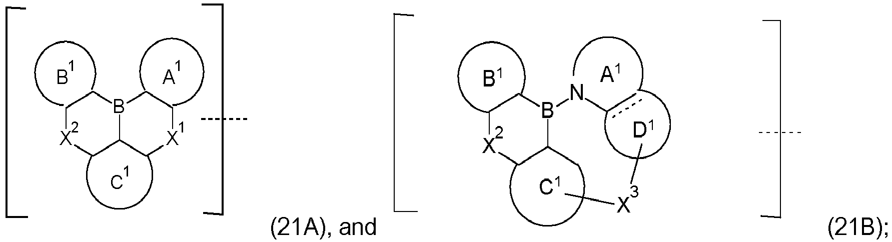 a material for an organic electroluminescence device, comprising at least one inventive compound; an organic electroluminescence device comprising at least one inventive compound; an electronic equipment comprising the inventive organic electroluminescence device; a light emitting layer comprising at least one host and at least one dopant, wherein the dopant comprises at least one inventive compound; and the use of the inventive compound in an organic electroluminescence device.

## Description

The present invention relates to a highly efficient blue fluorescent organic emitter represented by formula (I) 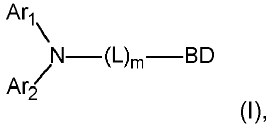 having a highest occupied molecular orbital (HOMO) of more than 70% electron density localized on the Ar₁Ar₂N-L unit and having an energy of lower than 4.9 eV in absolute numbers, a HOMO-1 having more than 70% electron density localized on the BD unit and has an energy of higher than 4.75 eV in absolute numbers, and a lowest unoccupied molecular orbital (LUMO) having more than 70% electron density localized on the BD unit; a compound represented by formula (I), wherein BD is a group selected from the groups consisting of 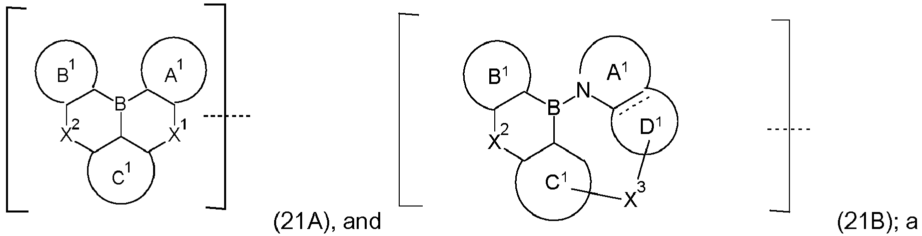 a material for an organic electroluminescence device, comprising at least one inventive compound; an organic electroluminescence device comprising at least one inventive compound; an electronic equipment comprising the inventive organic electroluminescence device; a light emitting layer comprising at least one host and at least one dopant, wherein the dopant comprises at least one inventive compound; and the use of the inventive compound in an organic electroluminescence device.

When a voltage is applied to an organic electroluminescence device (hereinafter may be referred to as an organic EL device or OLED), holes are injected to an emitting layer from an anode and electrons are injected to an emitting layer from a cathode. In the emitting layer, injected holes and electrons are re-combined and excitons are formed.

An organic EL device essentially comprises an emitting layer between the anode and the cathode. Further, there may be a case where it has a stacked layer structure comprising one or more additional organic layers.

JP2021095342A1 relates to a polycyclic aromatic compound of formula (1) or a multimer thereof and an organic EL element using the same, wherein A ring to C ring is an aryl ring or a heteroaryl ring which may be substituted; X¹ and X² are >O or >N-R or the like; the R may be bonded to A- to C-rings by a single bond or a linking group and the compound represented by the formula (1) may be substituted with a halogen or the like.

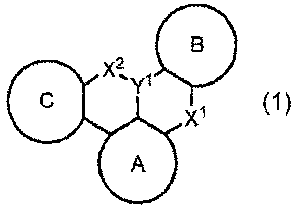

WO2020135953A1 relates to an organic compound, in particular for the application in optoelectronic devices. According to the invention, the organic compound has a structure of formula (I), wherein n is 0 or 1, m = 1-n, X is N or CR", V is N or CR^{XV}, and W is selected from the group consisting of a single bond, Si(R₃)₂, C(R₃)₂ and BR₃.

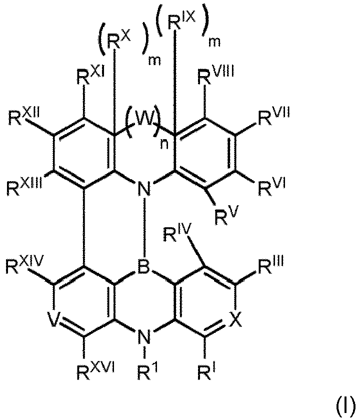

US2020052212A1 relates to an organic electroluminescence device comprising a cathode, an anode and an organic layer disposed between the cathode and the anode, wherein the organic layer comprises a fluorescent emitting layer and the fluorescent emitting layer comprises at least one dopant material selected from the compounds represented by formulae (D1) and (D2), at least one first host compound, and at least one second co-host compound.

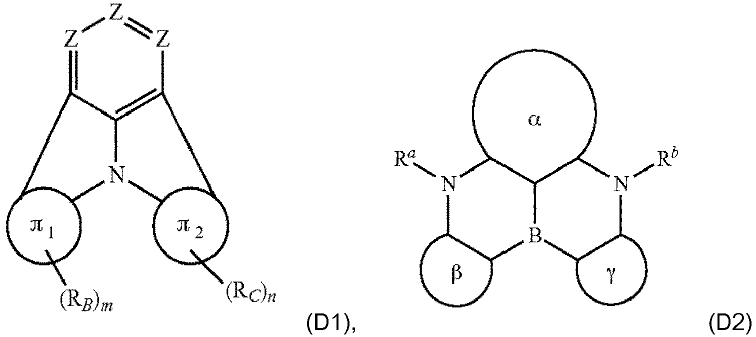

For an easy control of the brightness of the organic EL device panel, stable EQE (external quantum efficiency) over current density is required. Generally, a polar anthracene compound is used as a host material to obtain the stable EQE over current density. Or alternatively, an anthracene compound or a pyrene compound as a host material, is used together with an EBL (electron-blocking layer) or HTL (hole transport layer) having a deep IP (ionization potential) and therefore a small energy difference to the IP of the host material is used to obtain the stable EQE over current density. Generally, non-polar host materials are used in this case. Known deep IP emitter in polar host materials or in non-polar host materials combined with deep IP EBL or HTL lead to devices having a low EQE and a short lifetime (LT). One reason therefore is that in case of a deep IP emitter (e.g. an IP larger than 5.3 eV in absolute numbers), holes cannot be trapped on the HOMO. This leads to devices having a short lifetime and lower EQE.

A solution for this problem is provided in the non published application EP 21166293.7 with the title "An organic electroluminescence device comprising a light emitting layer comprising three different compounds and an electronic equipment comprising said organic electroluminescence device" filed by the applicant on March 31, 2021 concerning
an organic electroluminescence device comprising a cathode, an anode and an emitting layer disposed between the cathode and the anode, wherein the emitting layer comprises
(i) At least one anthracene compound with a dipole moment of larger than 1.0 · 10⁻³⁰ Cm (0.3 debye), as component (1);
(ii) At least one organic fluorescent compound whose onset of fluorescence is at lower energies than that of component (1) and at an energy higher than 2.6 eV, whose photoluminescence quantum yield is higher than 70% and whose ionization potential is higher than 5.3 eV, as component (2);
(iii) At least one organic compound whose ionization potential is lower than 5.3 eV and whose onset of fluorescence is at higher energies than that of component (2), as component (3).

This problem is further solved in the non published application EP 21214611.2 with the title "An organic electroluminescence device comprising a light emitting layer comprising three different compounds and an electronic equipment comprising said organic electroluminescence device" filed by the applicant on December 15, 2021 concerning
an organic electroluminescence device comprising a cathode, an anode and an emitting layer having an anode side and a cathode side disposed between the cathode and the anode, and a further layer next to the anode side of the emitting layer wherein
the emitting layer comprises
   (i) At least one compound with a dipole moment of less than 1.7 · 10⁻³⁰ Cm (0.5 debye), preferably less than 1.3 · 10⁻³⁰ Cm (0.4 debye), more preferably 1.0 · 10⁻³⁰ Cm (0.3 debye), as component (1), preferably having a fluorescence onset of >2.75 eV;
   (ii) At least one organic fluorescent compound whose onset of fluorescence is at lower energies than that of component (1) and at an energy higher than 2.6 eV, whose photoluminescence quantum yield is higher than 70% and whose ionization potential in absolute values is higher than 5.33 eV, as component (2);
   (iii) At least one organic compound whose ionization potential in absolute values is lower than 5.33 eV and whose onset of fluorescence is at higher energies than that of component (2), as component (3);
   and
the further layer comprising a compound fulfilling the following requirement:
   Ionization potential in absolute values of component (1) - Ionization potential in absolute values of component (4) ≤ 0.35 eV, as component (4);
   wherein
   the dipole moment is computed using the DFT method with the Gaussian 16 software;
   the onset of fluorescence is determined by linear fitting of the high energy side of the spectra; the photoluminescence quantum yield is measured with an integrating sphere;
   the ionization potential of component (2) and component (3) is measured by cyclic voltammetry; and
   the ionization potential of component (1) and component (4) is measured by photoelectron spectroscopy.

In EP 21166293.7 and EP 21214611.2 the problem is therefore solved by introducing a hole transporting dopant (compound (3)) with a small IP value allowing holes to be trapped.

Generally, in EP 21166293.7 and EP 21214611.2, component (1) is a host material, component (2) ist a dopant material and component (3) is an additive. The light emitting layer of the inventive organic electroluminescence device therefore preferably comprises at least one host material represented by component (1), at least one dopant represented by component (2) and at least one additive represented by component (3).

However, in EP 21166293.7 and EP 21214611.2 an additional component, additive (3), is needed in the light emitting layer. Without the additive (3), the OLED device has shorter lifetime and/or lower efficiency, due to high ionization potential of component (2). Therefore, component (3) is necessary to utilize desirable spectral features of component (2) as the fluorescent emitter. The higher number of components in the emitting layer means, for example, that an additional source of evaporation is required for deposition of component (3), or difference of evaporation temperatures of preferably less than 10°C is required for components (2) and (3), in order to be evaporated from a simple mixture or an organic alloy with a constant pre-defined ratio. From a commercial viewpoint, a fewer number of evaporation sources is even more desirable.

It is therefore an object of the present invention to improve the performance of deep IP emitter in polar host materials or non-polar host materials combined with deep IP EBL or HTL in an organic electroluminescence device, allowing for organic electroluminescence devices, having stable EQE over current density and at the same time good lifetimes (LT) without need for an additional component (additive) (in addition to host and dopant).

This object is solved by a compound represented by formula (I) 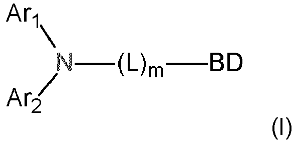 wherein
BD represents an organic fluorescent chromophore whose fluorescence peak maximum is found between 435 nm and 470 nm, preferably between 440 nm and 465 nm and more preferably between 445 nm and 460 nm, whose fluorescence full width at half maximum (FWHM) is smaller than 30 nm and whose photoluminescence quantum yield (PLQY) is higher than 70%, preferably higher than 80%;
wherein the compound of formula (I) having a highest occupied molecular orbital (HOMO) computed by density-functional theory (DFT) using the Gaussian 16 software, B3LYP as the functional and 6-31g(d) as the basis set of more than 70%, preferably more than 80% electron density localized on the Ar₁Ar₂N-(L)ₘ unit and having an energy of lower than 4.9 eV in absolute numbers, in vacuum at the optimized ground state geometry;
a HOMO-1 having more than 70%, preferably more than 80% electron density localized on the BD unit and has an energy of higher than 4.75 eV in absolute numbers; and
a lowest unoccupied molecular orbital (LUMO) having more than 70%, preferably more than 80% electron density localized on the BD unit;
L represents a direct bond or a linking group; L in a form of the linking group is preferably selected from the group consisting of a substituted or unsubstituted aromatic hydrocarbon group having 6 to 30 ring carbon atoms; a substituted or unsubstituted heterocyclic group having 5 to 30 ring atoms and a substituted or unsubstituted group 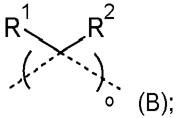
o is 1, 2 or 3, preferably 1; wherein in the case that o is 2 or 3, group (B) is in each case the same or different;
R¹ and R² each independently represents hydrogen, an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
   and/or
two residues R¹ and R² together form a ring structure which is unsubstituted or substituted; the dotted lines in group (B) are bonding sites;
m is 1, 2 or 3, preferably 1; wherein in the case that m is 2 or 3 L is in each case the same or different;
Ar₁ and Ar₂ each independently represents a substituted or unsubstituted aryl group having 6 to 50 ring carbon atoms, a substituted or unsubstituted heterocyclic ring group having 5 to 50 ring atoms, a substituted or unsubstituted alkyl group having 1 to 30 carbon atoms, a substituted or unsubstituted aralkyl group having 7 to 50 ring carbon atoms; Ar₁ and Ar₂ may be connected together to form a saturated or unsaturated ring,
wherein the photoluminescence quantum yield is measured in toluene solution at a concentration of 5 × 10⁻⁶ M with an integrating sphere at a temperature of 295K.

In the present application, the absolue values of the HOMO and LUMO energies are given, to improve readybility. However, the HOMO and LUMO energies are negative values.

With the connectivity between BD and Ar₁Ar₂N in the inventive compounds, Ar₁Ar₂N serves to give a low ionization potential, while the desirable spectral feature of BD, such as narrow FWHM (full width at half maximum) and high PLQY (photoluminescence quantum yield), are maintained. The covalently linked group Ar₁Ar₂N accommodates holes and improves the lifetime and/or efficiency while the spectral features of the fluorescent emitter are maintained.

With the compound of the present invention, no triple mix of compounds in the emitting layer is needed, which involves co-evaporation of 3 materials, which requires either 3 simultaneous evaporation sources, or an organic alloy.

Two key points of the invention are:
- Tethering of the blue dopant (BD) whose ionization potential in absolute values is high and Ar₁Ar₂N whose ionization potential in absolute values is low which allows for consistent and equimolar ratio of dopant and Ar₁Ar₂N;
- Frontier molecular orbital and excited state design according to the above parameters ensures that the beneficial aspects of Ar₁Ar₂N can be exploited while maintaining the desirable spectral features of the blue dopant (BD).

It should be considered that it is not sufficient to connect any group Ar₁Ar₂N and any group BD for achieving the object of the present invention. This is shown in the example part of the present application (see especially comparative compound 1).

In a further embodiment, said object is solved by a compound represented by formula (I), 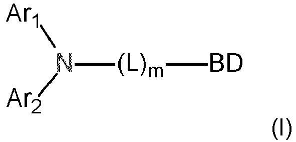 wherein
BD is a group selected from the groups consisting of 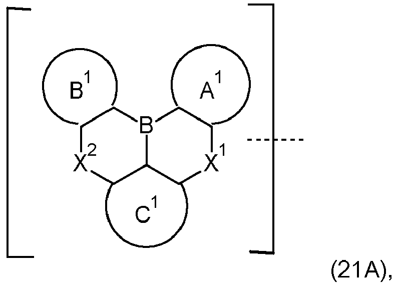
preferably a compound of formula (21Aa) or (21Ab) 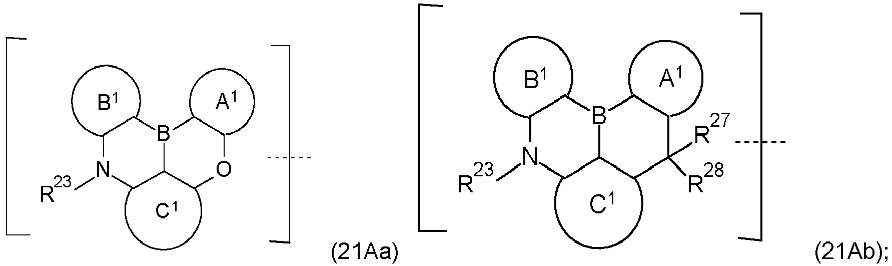 and 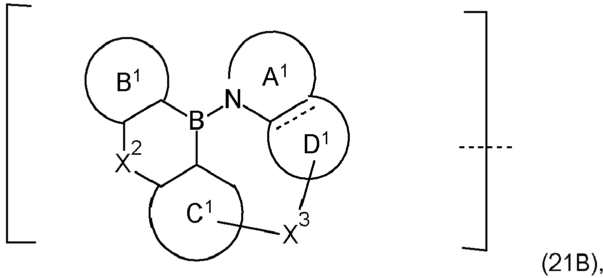 preferably a compound of (21 Ba) or (21 Bb) 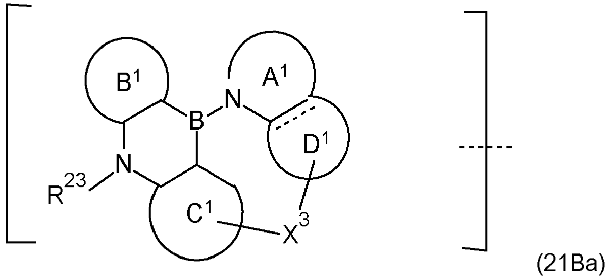 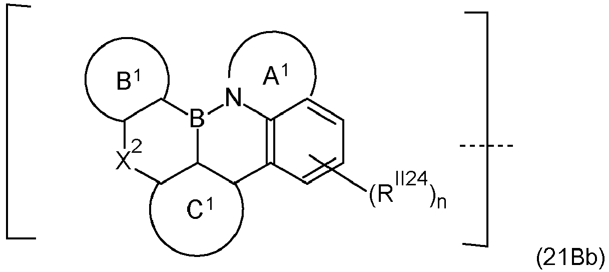 wherein
A¹ ring and B¹ ring each independently represents a substituted or unsubstituted aromatic hydrocarbon ring having 6 to 50 ring carbon atoms, or a substituted or unsubstituted heterocyclic ring having 5 to 50 ring atoms;
C¹ represents a substituted or unsubstituted aromatic hydrocarbon ring having 6 to 50 ring carbon atoms, or a substituted or unsubstituted heterocyclic ring having 5 to 50 ring atoms;
X¹ and X² are each O, S, NR²³, SiR²⁴R²⁵ or CR²⁷R²⁸; preferably X² is NR²³ and X¹ is O, S, SiR²⁴R²⁵ or CR²⁷R²⁸, more preferably X² is NR²³ and X¹ is O or CR²⁷R²⁸;
X³ represents a direct bond or O, S, NR²³, SiR²⁴R²⁵ or CR²⁷R²⁸; preferably a direct bond;
R^{II24} represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
ring D¹ represents a substituted or unsubstituted aromatic hydrocarbon ring having 6 to 50 ring carbon atoms, or a substituted or unsubstituted heterocyclic ring having 5 to 50 ring atoms, which is fused via a single bond or via a double bond with ring A¹;
n is 0, 1, 2 or 3, preferably 0 or 1;
R²³, R²⁴, R²⁵, R²⁷ and R²⁸ each independently represents an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
   and/or
two residues R²⁴ and R²⁵ and/or two residues R²⁷ and R²⁸ together form a ring structure which is unsubstituted or substituted,
   and/or
one or more residues R²³ may be bonded to the ring B₁ and/or to the ring C₁ and/or to the ring A₁ to form a ring structure which is unsubstituted or substituted;
in the case that X¹ and X² are NR²³, exactly one residue R²³ may be bonded to the ring B₁ or to the ring C₁ or to the ring A₁ to form a ring structure which is unsubstituted or substituted;
wherein the dotted line in formula (21A) and (21B) is a bonding site to L;
L represents a linking group, preferably selected from the group consisting of a substituted or unsubstituted aromatic hydrocarbon group having 6 to 30 ring carbon atoms, a substituted or unsubstituted heterocyclic group having 5 to 30 ring atoms, and a substituted or unsubstituted group 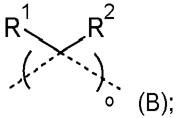
o is 1, 2 or 3, preferably 1; wherein in the case that o is 2 or 3, group (B) is in each case the same or different;
R¹ and R² each independently represents hydrogen, an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
   and/or
two residues R¹ and R² together form a ring structure which is unsubstituted or substituted; the dotted lines in group B are bonding sites;
   or
in the case that N of the group NAr¹Ar² is part of a 6-membered ring, L represents a direct bond or a linking group as defined above;
m is 1, 2 or 3, preferably 1; wherein in the case that m is 2 or 3 L is in each case the same or different;
Ar₁ and Ar₂ each independently represents a substituted or unsubstituted aryl group having 6 to 50 ring carbon atoms, a substituted or unsubstituted heterocyclic ring group having 5 to 50 ring atoms, a substituted or unsubstituted alkyl group having 1 to 30 carbon atoms, a substituted or unsubstituted aralkyl group having 7 to 50 ring carbon atoms; Ar₁ and Ar₂ may be bonded together to form a saturated or unsaturated ring.

The object is further solved by a material, preferably an emitter material, for an organic electroluminescence device, comprising at least one inventive compound and an organic electroluminescence device comprising at least one inventive compound.

The object is further solved by an electronic equipment comprising the inventive organic electroluminescence device, a light emitting layer comprising at least one host and at least one dopant, wherein the dopant comprises at least one inventive compound, and the use of an inventive compound of formula (I) in an organic electroluminescence device.

The term organic EL device (organic electroluminescence device) is used interchangeably with the term organic light-emitting diode (OLED) in the present application.

The terms unsubstituted or substituted aromatic hydrocarbon group containing 6 to 50 ring atoms, an unsubstituted or substituted heteroaromatic group containing 5 to 50 ring atoms, heterocyclic group having 5 to 50 ring atoms, an unsubstituted or substituted alkyl group having 1 to 50 carbon atoms, an unsubstituted or substituted cycloalkyl group having 3 to 50 ring carbon atoms, are known in the art and generally have the following meaning, if said groups are not further specified in specific embodiments mentioned below:
The unsubstituted or substituted aromatic hydrocarbon group containing 6 to 50 ring atoms, preferably 6 to 30 ring atoms, more preferably 6 to 24 ring atoms, most preferably 6 to 18 ring atoms, may be a non-condensed aryl group or a condensed aryl group. Specific examples thereof include phenyl group, naphthyl group, phenanthryl group, biphenyl group, terphenyl group, quaterphenyl group, fluoranthenyl group, triphenylenyl group, phenanthrenyl group, fluorenyl group, anthracenyl, chrysenyl, spirofluorenyl group, 9,9-diphenylfluorenyl group, 9,9'-spirobi[9H-fluorene]-2-yl group, 9,9-dimethylfluorenyl group, benzo[c]phenanthrenyl group, benzo[a]triphenylenyl group, naphtho[1,2-c]phenanthrenyl group, naphtho[1,2-a]triphenylenyl group, dibenzo[a,c]triphenylenyl group, benzo[a]fluoranthenyl group, benzo[j]fluoranthenyl group, benzo[k]fluoranthenyl group and benzo[b]fluoranthenyl group, with phenyl group, naphthyl group, biphenyl group, terphenyl group, phenanthryl group, triphenylenyl group, fluorenyl group, spirobifluorenyl group anthracenyl, and fluoranthenyl group being preferred, and phenyl group, 1-naphthyl group, 2-naphthyl group, biphenyl-2-yl group, biphenyl-3-yl group, biphenyl-4-yl group, phenanthrene-9-yl group, phenanthrene-3-yl group, phenanthrene-2-yl group, triphenylene-2-yl group, 9,9-dimethylfluorene-2-yl group, 9,9-dimethylfluorene-4-yl group, 9,9-diphenylfluorene-2-yl group, 9,9-diphenylfluorene-4-yl group, fluoranthene-3-yl group, fluoranthene-2-yl group, fluoranthene-8-yl, anthracen-3-yl and anthracen-9-yl group being most preferred.

In the case that linkers represent an unsubstituted or substituted aromatic hydrocarbon group containing 6 to 50 ring atoms, the linkers are divalent aromatic hydrocarbon groups containing 6 to 50 ring atoms, which are unsubstituted or (further) substituted.

The unsubstituted or (further) substituted divalent aromatic hydrocarbon group containing 6 to 50 ring atoms, preferably 6 to 30 ring atoms, more preferably 6 to 18 ring atoms, most preferably 6 to 14 ring atoms, may be a non-condensed or a condensed divalent aromatic hydrocarbon group. Specific examples thereof include phenylene group, naphthylene group, biphenylene group, terphenylene group, quaterphenylene group, fluoranthene-diyl group, triphenylene-diyl group, phenanthrene-diyl group, fluorene-diyl group, anthracene-diyl, chrysene-diyl, spirofluorene-diyl group, 9,9-diphenylfluorene-diyl group, 9,9'-spirobi[9H-fluorene]-2-diyl group, 9,9-dimethylfluorene-diyl group, benzo[c]phenanthrene-diyl group, benzo[a]triphenylene-diyl group, naphtho[1,2-c]phenanthrene-diyl group, naphtho[1,2-a]triphenylene-diyl group, dibenzo[a,c]triphenylene-diyl group, benzo[a]fluoranthene-diyl group, benzo[j]fluoranthene-diyl group, benzo[k]fluoranthene-diyl group and benzo[b]fluoranthene-diyl group, with phenylene group, naphthylene group, biphenylene group, terphenylene group, phenanthrene-diyl group, triphenylene-diyl group, fluorene-diyl group, spirobifluorene-diyl group, anthracene-diyl and fluoranthene-diyl group being preferred.

The unsubstituted or substituted heterocyclic group having 5 to 50 ring atoms, preferably 5 to 30 ring atoms, more preferably 5 to 18 ring atoms, is preferably an unsubstituted or substituted heteroaromatic group containing 5 to 50 ring atoms, preferably 5 to 30 ring atoms, more preferably 5 to 18 ring atoms, may be a non-condensed heteroaromatic group or a condensed heteroaromatic group. Specific examples thereof include the residues of pyrrole ring, isoindole ring, imidazopyridine ring, imidazopyrimidine ring, imidazopyrazin ring, benzofuran ring, isobenzofuran ring, benzothiophene, dibenzothiophene ring, isoquinoline ring, quinoxaline ring, quinazoline, phenanthridine ring, phenanthroline ring, pyridine ring, pyrazine ring, pyrimidine ring, pyridazine ring, indole ring, quinoline ring, acridine ring, carbazole ring, furan ring, thiophene ring, benzoxazole ring, benzothiazole ring, benzimidazole ring, dibenzofuran ring, triazine ring, oxazole ring, oxadiazole ring, thiazole ring, thiadiazole ring, triazole ring, azadibenzofuran, aza-dibenzothiophene, aza-carbazole, and imidazole ring with the residues of dibenzofuran ring, carbazole ring, benzimidazole ring, pyridine ring, and dibenzothiophene ring being preferred, and the residues of imidazo[1,2-a]pyridine, imidazo[1,5-a]pyridine, dibenzofuran-1-yl group, dibenzofuran-3-yl group, dibenzofuran-2-yl group, dibenzofuran-4-yl group, 9-phenylcarbazole-3-yl group, 9-phenylcarbazole-2-yl group, 9-phenylcarbazole-4-yl group, dibenzothiophene-2-yl group, and dibenzothiophene-4-yl, dibenzothiophene-1-yl group, and dibenzothiophene-3-yl group being more preferred.

In the case that the linkers represent an unsubstituted or substituted heteroaromatic group containing 5 to 50 ring atoms, the linkers are a divalent aromatic heteroaromatic group containing 5 to 50 ring atoms, which is unsubstituted or (further) substituted.

The unsubstituted or (further) substituted divalent heteroaromatic group containing 5 to 50 ring atoms, preferably 5 to 30 ring atoms, more preferably 5 to 18 ring atoms, may be a non-condensed heteroaromatic group or a condensed heteroaromatic group. Specific examples thereof include pyrrole-diyl, isoindole-diyl, benzofuran-diyl, isobenzofuran-diyl, benzothiophene-diyl, dibenzothiophene-diyl, isoquinoline-diyl, quinoxaline -diyl, quinazoline-diyl, phenanthridine-diyl, phenanthroline-diyl, pyridine-diyl, pyrazine-diyl, pyrimidine-diyl, pyridazine-diyl, indole-diyl, quinoline-diyl, acridine-diyl, carbazole-diyl, furan-diyl, thiophene-diyl, benzoxazole-diyl, benzothiazole-diyl, benzimidazole-diyl, dibenzofuran-diyl, triazine-diyl, oxazole-diyl, oxadiazole-diyl, thiazole-diyl, thiadiazole-diyl, triazole-diyl, aza-dibenzothiophene-diyl, azadibenzofuran-diyl, aza-carbazole-diyl, and imidazole-diyl.

Examples of the unsubstituted or substituted alkyl group having 1 to 50 carbon atoms, preferably 1 to 25 carbon atoms, more preferably 1 to 8 carbon atoms, are methyl group, ethyl group, n-propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group and 1-methylpentyl group.

Further preferred are alkyl groups having 1 to 6 carbon atoms. Examples of the alkyl group having 1 to 6 carbon atoms are methyl group, ethyl group, n-propyl group, isopropyl group, n-butyl group, s-butyl group, isobutyl group, t-butyl group, n-pentyl group, n-hexyl group, neopentyl group and 1-methylpentyl group, with methyl group, ethyl group, n-propyl group, isopropyl group, n-butyl group, s-butyl group, isobutyl group and t-butyl group being preferred.

Examples of the unsubstituted or substituted cycloalkyl group having 3 to 50 ring carbon atoms, preferably 3 to 18 ring carbon atoms, more preferably 3 to 12 ring carbon atoms, include cyclopropyl group, cyclobutyl group, cyclopentyl group, cyclohexyl group, cyclooctyl group, and adamantyl group. Most preferred are cycloalkyl groups having 3 to 6 ring carbon atoms, i.e. a cyclopropyl group, a cyclobutyl group, a cyclopentyl group or a cyclohexyl group.

Examples of the optional substituent(s) indicated by "substituted or unsubstituted" and "may be substituted" referred to above or hereinafter include a halogen atom, a cyano group, R^{a}R^{b}PO, an alkyl group having 1 to 50, preferably 1 to 25 carbon atoms, more preferably 1 to 8 carbon atoms, a cycloalkyl group having 3 to 50, preferably 3 to 18 ring carbon atoms, more preferably 3 to 12 ring carbon atoms, an alkoxy group having 1 to 50, preferably 1 to 25 carbon atoms, more preferably 1 to 8 carbon atoms, an alkylamino group having 1 to 50 carbon atoms, preferably 1 to 25 carbon atoms, more preferably 1 to 5 carbon atoms, a carboxyalkyl group having 1 to 50 carbon atoms, preferably 1 to 25 carbon atoms, more preferably 1 to 5 carbon atoms, a carboxamidalkyl group having 1 to 50 carbon atoms, preferably 1 to 25 carbon atoms, more preferably 1 to 5 carbon atoms, a silyl group, a C₆ to C₅₀ aryl group, preferfably a C₆ to C₂₄ aryl group, more preferfably a C₆ to C₁₈ aryl group, an aryloxy group having 6 to 50, preferably 6 to 24 ring carbon atoms, more preferably 6 to 18 ring carbon atoms, an aralkyl group having 7 to 50, preferably 7 to 24 carbon atoms, more preferably 7 to 20 carbon atoms, an alkylthio group having 1 to 50, preferably 1 to 25 carbon atoms, more preferably 1 to 5 carbon atoms, an arylthio group having 6 to 50, preferably 6 to 24 ring carbon atoms, more preferably 6 to 18 ring carbon atoms, an arylamino group having 6 to 50 carbon atoms, preferably 6 to 30 carbon atoms, more preferably 6 to 18 carbon atoms, a carboxyaryl group having 6 to 50 carbon atoms, preferably 6 to 24 carbon atoms, more preferably 6 to 18 carbon atoms, a carboxamidaryl group having 6 to 50 carbon atoms, preferably 6 to 24 carbon atoms, more preferably 6 to 18 carbon atoms, and a heteroaromatic group having 5 to 50 ring atoms, preferably 5 to 30 ring atoms, more preferably 5 to 18 ring atoms. The substituents may in turn be unsubstituted or substituted, preferably unsubstituted.

The alkyl group having 1 to 50, preferably 1 to 25 carbon atoms, more preferably 1 to 8 carbon atoms, the C₆ to C₅₀ aryl group, preferably C₆ to C₂₄ aryl group, more preferably C₆ to C₁₈ aryl group, and cycloalkyl group having 3 to 50 ring carbon atoms, preferably 3 to 18 ring carbon atoms, preferably 3 to 12 ring carbon atoms, and the heterocyclic group having 5 to 50 ring atoms, preferably 5 to 30 ring atoms, more preferably 5 to 18 ring atoms, are defined above.

Examples of the alkenyl group having 2 to 50 carbon atoms include those disclosed as alkyl groups having 2 to 50 carbon atoms but comprising at least one double bond, preferably one, or where possible, two or three double bonds.

Examples of the alkynyl group having 2 to 50 carbon atoms include those disclosed as alkyl groups having 2 to 50 carbon atoms but comprising at least one triple bond, preferably one, or where possible, two or three triple bonds.

The silyl group is an alkyl and/or aryl substituted silyl group. Examples of alkyl and/or aryl substituted silyl groups include alkylsilyl groups having 1 to 10 carbon atoms, preferably 1 to 5 carbon atoms, including trimethylsilyl group, triethylsilyl group, tributylsilyl group, dimethylethylsilyl group, t-butyldimethylsilyl group, propyldimethylsilyl group, dimethylisopropylsilyl group, dimethylpropylsilyl group, dimethylbutylsilyl group, dimethyltertiarybutylsilyl group, diethylisopropylsilyl group, alkylarylsilyl groups having 6 to 50 carbon atoms, preferably 6 to 30 carbon atoms, more preferably 6 to 18 carbon atoms, in the aryl part and 1 to 10 carbon atoms, preferably 1 to 5 carbon atoms, in the alkyl part including phenyldimethylsilyl group, diphenylmethylsilyl group, diphenyltertiarybutylsilyl group, and arylsilyl groups having 6 to 50 carbon atoms, preferably 6 to 30 carbon atoms, more preferably 6 to 18 carbon atoms, including a triphenylsilyl group, with trimethylsilyl, triphenylsilyl, diphenyltertiarybutylsilyl group and t-butyldimethylsilyl group being preferred.

Examples of halogen atoms include fluorine, chlorine, bromine, and iodine.

Examples of an alkylamino group (alkyl substituted amino group), preferably an alkylamino group having 1 to 50 ring carbon atoms include those having an alkyl portion selected from the alkyl groups mentioned above.

Examples of an arylamino group (aryl substituted amino group), preferably an arylamino group having 6 to 50 ring carbon atoms include those having an aryl portion selected from the aromatic hydrocarbon groups mentioned above.

Examples of the optional aralkyl group having 7 to 50 ring carbon atoms include benzyl group, 2-phenylpropane-2-yl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, and 1-chloro-2-phenylisopropyl group.

Examples of a carboxyalkyl group (alkyl substituted carboxyl group), preferably a carboxyalkyl group having 1 to 50 carbon atoms, preferably 1 to 25 carbon atoms, more preferably 1 to 5 carbon atoms, include those having an alkyl portion selected from the alkyl groups mentioned above.

Examples of a carboxyaryl group (aryl substituted carboxyl group), preferably a carboxyaryl group having 6 to 50 carbon atoms, preferably 6 to 24 carbon atoms, more preferably 6 to 18 carbon atoms, include those having an aryl portion selected from the aromatic hydrocarbon groups mentioned above.

Examples of a carboxamidalkyl group (alkyl substituted amide group), preferably a carboxamidalkyl group having 1 to 50 carbon atoms, preferably 1 to 25 carbon atoms, more preferably 1 to 5 carbon atoms, include those having an alkyl portion selected from the alkyl groups mentioned above.

Examples of a carboxamidaryl group (aryl substituted amide group), preferably a carboxamidaryl group having 6 to 50 carbon atoms, preferably 6 to 24 carbon atoms, preferably 6 to 18 carbon atoms, include those having an aryl portion selected from the aromatic hydrocarbon groups mentioned above.

The optional substituent is preferably a halogen atom, a cyano group, an alkyl group having 1 to 25 carbon atoms, an aryl group having 6 to 24 ring carbon atoms, preferably 6 to 18 ring carbon atoms, and an heterocyclic group having 5 to 50 ring atoms, preferably 5 to 18 ring atoms; more preferably a cyano group, a phenyl group, a naphthyl group, a biphenyl group, a terphenyl group, a phenanthryl group, a triphenylenyl group, a fluorenyl group, a spirobifluorenyl group, a fluoranthenyl group, a residue based on a dibenzofuran ring, a residue based on a carbazole ring, and a residue based on a dibenzothiophene ring, a methyl group, an ethyl group, a n-propyl group, an isopropyl group, a n-butyl group, a s-butyl group, an isobutyl group, a t-butyl group, a cyclopentyl group, and a cyclohexyl group.

The optional substituent mentioned above may be further substituted by one or more of the optional substituents mentioned above.

The number of the optional substituents depends on the group which is substituted by said substituent(s). Preferred are 1, 2, 3 or 4 optional substituents, more preferred are 1, 2 or 3 optional substituents, most preferred are 1 or 2 optional substituents. In a further preferred embodiment, the groups mentioned above are unsubstituted.

In the case that N of the group NAr₁Ar₂ is part of a 6-membered ring, NAr₁Ar₂ preferably forms the following group 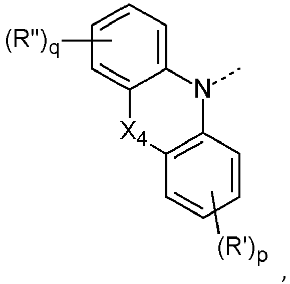 wherein X₄ represents a O, S, SiR²⁴R²⁵ or CR²⁷R²⁸, preferably O or S;
R' and R" each independently represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
p and q each independently represents 0, 1, 2 or 3, preferably 0 or 1; and
the dotted line is a bonding site to L.

The "carbon number of a to b" in the expression of "substituted or unsubstituted X group having a to b carbon atoms" is the carbon number of the unsubstituted X group and does not include the carbon atom(s) of an optional substituent.

The hydrogen atom referred to herein includes isotopes different from neutron numbers, i.e., light hydrogen (protium), heavy hydrogen (deuterium) and tritium.

In chemical formulae herein, it is assumed that a hydrogen atom (i.e. protium, deuterium, or tritium) is bonded to each of bondable positions that are not annexed with symbols "R" etc., or a "D" representing a deuterium.

The term "unsubstituted" referred to by "unsubstituted or substituted" means that a hydrogen atom is not substituted by one of the groups mentioned above. The hydrogen atom(s) in the "unsubstituted" group is protium, deuterium, or tritium.

### Compound of formula (I)

The present invention relates to a compound represented by formula (I) 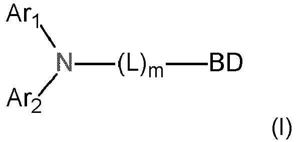 wherein
BD represents an organic fluorescent chromophore whose fluorescence peak maximum is found between 435 nm and 470 nm, preferably between 440 nm and 465 nm and more preferably between 445 nm and 460 nm, whose fluorescence full width at half maximum (FWHM) is smaller than 30 nm, preferably 10 to < 30 nm, more preferably 15 to <30 nm, and whose photoluminescence quantum yield (PLQY) is higher than 70%, preferably higher than 80%;
wherein the compound of formula (I) having a highest occupied molecular orbital (HOMO) computed by density-functional theory (DFT) using the Gaussian 16 software, B3LYP as the functional and 6-31g(d) as the basis set of more than 70%, preferably more than 80% electron density localized on the Ar₁Ar₂N-(L)ₘ unit and having an energy of lower than 4.9 eV in absolute numbers, in vacuum at the optimized ground state geometry;
a HOMO-1 having more than 70%, preferably more than 80% electron density localized on the BD unit and has an energy of higher than 4.75 eV in absolute numbers; and
a lowest unoccupied molecular orbital (LUMO) having more than 70%, preferably more than 80% electron density localized on the BD unit;
L represents a direct bond or a linking group; L in a form of the linking group is preferably selected from the group consisting of a substituted or unsubstituted aromatic hydrocarbon group having 6 to 30 ring carbon atoms; a substituted or unsubstituted heterocyclic group having 5 to 30 ring atoms and a substituted or unsubstituted group 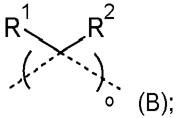
o is 1, 2 or 3, preferably 1; wherein in the case that o is 2 or 3, group (B) is in each case the same or different;
R¹ and R² each independently represents hydrogen, an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
   and/or
two residues R¹ and R² together form a ring structure which is unsubstituted or substituted;
the dotted lines in group (B) are bonding sites;
m is 1, 2 or 3, preferably 1; wherein in the case that m is 2 or 3 L is in each case the same or different;
Ar₁ and Ar₂ each independently represents a substituted or unsubstituted aryl group having 6 to 50 ring carbon atoms, a substituted or unsubstituted heterocyclic ring group having 5 to 50 ring atoms, a substituted or unsubstituted alkyl group having 1 to 30 carbon atoms, a substituted or unsubstituted aralkyl group having 7 to 50 ring carbon atoms; Ar₁ and Ar₂ may be connected together to form a saturated or unsaturated ring,
wherein the photoluminescence quantum yield is measured in toluene solution at a concentration of 5 × 10⁻⁶ M with an integrating sphere at a temperature of 295K.

The FWHM is determined as known by a person skilled in the art and shown in the examples.

The Gaussian 16 software, B3LYP as the functional and 6-31g(d) as the basis set is a standard software which is for example also used in US10950799B2, Angew. Chem. Int. Ed. 2016, 55, 3017 - 3021, J. Mater. Chem. C 2022, 10, 7866 - 7874, Angew. Chem. Int. Ed. 2019, 58, 16912 - 16917, Chem. Sci. 2022, 13, 5622 - 5630 and Angew. Chem. Int. Ed. 2021, 60, 2882 -2886.

Preferably, the inventive compound has a lowest energy singlet emissive state computed by time-dependent DFT (TD-DFT) with an oscillator strength larger than 0.15 (f > 0.15), preferably larger than 0.2 and more preferably larger than 0.25, which is characterized by HOMO-1→LUMO transition with a contribution of larger than 72% (HOMO-1→LUMO coefficient of larger than 0.6), preferably larger than 80% (coefficient 0.63) and more preferably larger than 90% (coefficient 0.67) in vacuum from the optimized ground state geometry; and whose singlet excited state characterized by HOMO→LUMO transition with a contribution of larger than 72% (HOMO→LUMO coefficient of larger than 0.6), preferably larger than 80% (coefficient 0.63) and more preferably larger than 90% (coefficient 0.67) is non-emissive, having an oscillator strength smaller than 0.05 (f < 0.05), preferably smaller than 0.03 and more preferably smaller than 0.01.

The calculations mentioned above are based on standard calculation methods for example also used in Angew. Chem. Int. Ed. 2016, 55, 3017 - 3021, J. Mater. Chem. C 2022, 10, 7866 - 7874, Angew. Chem. Int. Ed. 2021, 60, 2882 -2886, Angew. Chem. Int. Ed. 2019, 58, 16912 - 16917 and Chem. Sci. 2022, 13, 5622 - 5630.

### The group BD

The goup BD is preferably represented by formula (21) 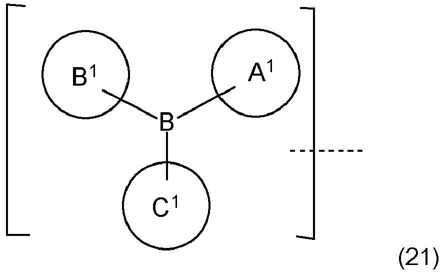 wherein, in the formula (21),
ring A¹ and ring B¹ each independently represents a substituted or unsubstituted aromatic hydrocarbon ring having 6 to 50 ring carbon atoms, or a substituted or unsubstituted heterocyclic ring having 5 to 50 ring atoms;
ring C¹ represents a substituted or unsubstituted aromatic hydrocarbon ring having 6 to 50 ring carbon atoms, or a substituted or unsubstituted heterocyclic ring having 5 to 50 ring atoms; wherein the ring C¹ is connected
   (i) via a group X¹ to the ring A¹; or C¹ and A¹ are connected and form the following group 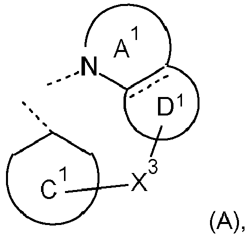 and
   (ii) via a group X² to the ring B¹;
X¹ and X² are each O, S, NR²³, SiR²⁴R²⁵ or CR²⁷R²⁸; preferably X² is NR²³ and X¹ is O, S, SiR²⁴R²⁵ or CR²⁷R²⁸, more preferably X² is NR²³ and X¹ is O or CR²⁷R²⁸;
X³ represents a direct bond or O, S, NR²³, SiR²⁴R²⁵ or CR²⁷R²⁸; preferably a direct bond;
R²³, R24, R25, R27 and R²⁸ each independently represents an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
   and/or
two residues R²⁴ and R²⁵ and/or two residues R²⁷ and R²⁸ together form a ring structure which is unsubstituted or substituted,
   and/or
one or more residues R²³ may be bonded to the ring B¹ and/or to the ring C¹ and/or to the ring A¹ to form a ring structure which is unsubstituted or substituted; and
in the case that X¹ and X² are NR²³, exactly one residue R²³ may be bonded to the ring B¹ or to the ring C¹ or to the ring A¹ to form a ring structure which is unsubstituted or substituted;
wherein the dotted lines in formula (A) are bonding sites to B;
wherein the dotted line in formula (21) is a bonding site to L.

Preferably, BD is a group selected from the group consisting of 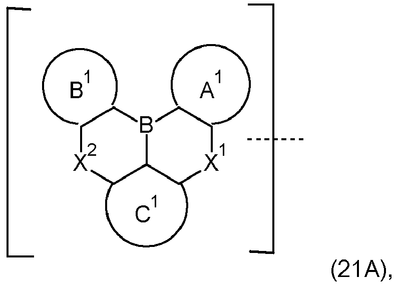 preferably a compound of formula (21Aa) or (21Ab) 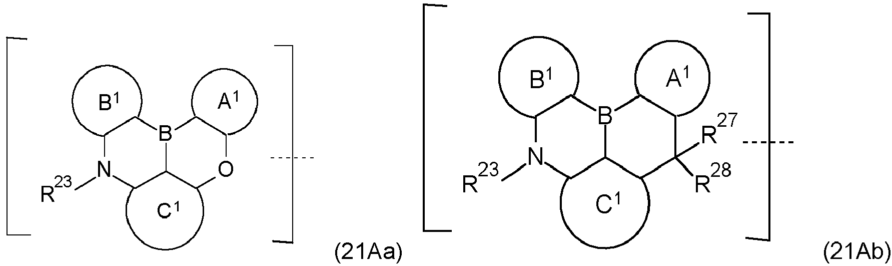 ; and 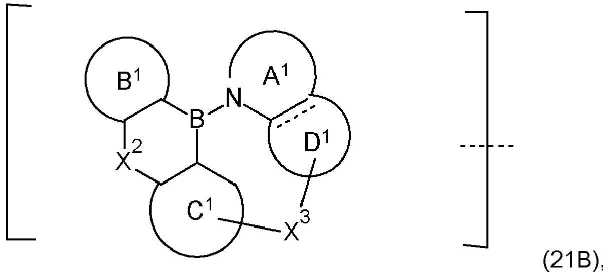 , preferably a compound of formula (21Ba) or (21 Bb) 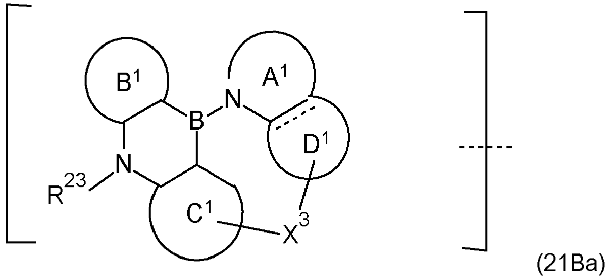 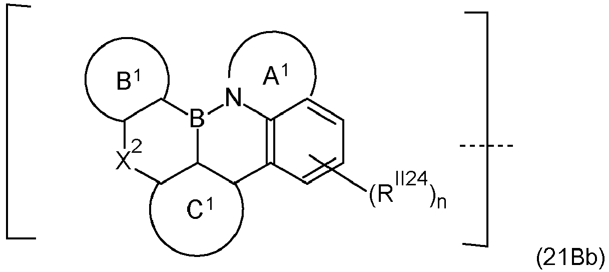 wherein,
the dotted line is a bonding site to L, and
ring D¹ represents a substituted or unsubstituted aromatic hydrocarbon ring having 6 to 50 ring carbon atoms, or a substituted or unsubstituted heterocyclic ring having 5 to 50 ring atoms, which is fused via a single bond or via a double bond with ring A¹;
R^{II24} represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
n is 0, 1, 2 or 3, preferably 0 or 1.

More preferably, BD is a group selected from the groups consisting of 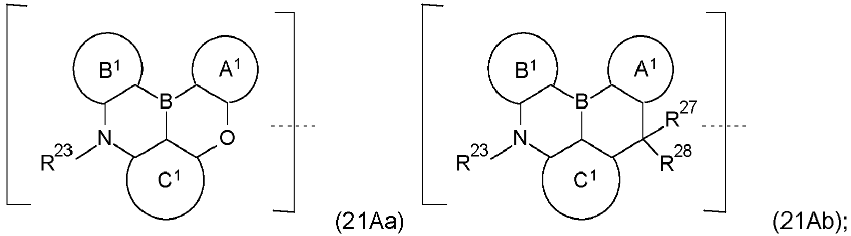 and 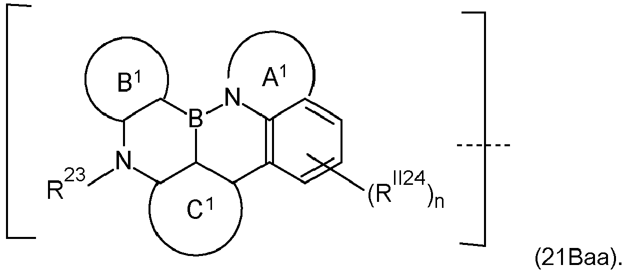
Ring A¹ and ring B¹ each independently represents a substituted or unsubstituted aromatic hydrocarbon ring having 6 to 50 ring carbon atoms, or a substituted or unsubstituted heterocyclic ring having 5 to 50 ring atoms;
ring C¹ represents a substituted or unsubstituted aromatic hydrocarbon ring having 6 to 50 ring carbon atoms, or a substituted or unsubstituted heterocyclic ring having 5 to 50 ring atoms.

Preferably, the rings B¹ and C¹ each independently represents a substituted or unsubstituted aromatic hydrocarbon ring having 6 to 50 ring carbon atoms, preferably 6 to 30 ring atoms, more preferably 6 to 24 ring atoms, most preferably 6 to 18 ring atoms, which may be a non-condensed aryl group or a condensed aryl group. More preferably, the rings B¹ and C¹ each independently represents a substituted or unsubstituted aromatic hydrocarbon ring having 6 ring carbon atoms, which may be a non-condensed C6-aryl group or a C6-aryl group condensed with a further C6-aryl group.

Ring A¹ represents a substituted or unsubstituted aromatic hydrocarbon ring having 6 to 50 ring carbon atoms, preferably 6 to 30 ring atoms, more preferably 6 to 24 ring atoms, most preferably 6 to 18 ring atoms, which may be a non-condensed aryl group or a condensed aryl group; or a substituted or unsubstituted heterocyclic ring having 5 to 50 ring atoms, preferably 5 to 30 ring atoms, more preferably 5 to 18 ring atoms, which may be a non-condensed heteroaromatic group or a condensed heteroaromatic group. More preferably, the ring A¹ represents a substituted or unsubstituted aromatic hydrocarbon ring having 6 ring carbon atoms, which may be a non-condensed C6-aryl group or a C6-aryl group condensed with a further C6-aryl group; or a substituted or unsubstituted heterocyclic ring having 5 ring atoms, which may be a non-condensed heteroaromatic group or a condensed heteroaromatic group.

Ring D¹ represents a substituted or unsubstituted aromatic hydrocarbon ring having 6 to 50 ring carbon atoms, or a substituted or unsubstituted heterocyclic ring having 5 to 50 ring atoms, preferably 6 to 30 ring atoms, more preferably 6 to 24 ring atoms, most preferably 6 to 18 ring atoms which is fused via a single bond or via a double bond with ring A¹. Preferably, the ring D¹ represents a substituted or unsubstituted aromatic hydrocarbon ring having 6 ring carbon atoms.

Most preferably, rings A¹, B¹, C¹ and D¹ are each independently unsubstituted or substituted by one substituent.

Suitable substituents are mentioned above. Most preferred substituents are substituted or unsubstituted C₆-aryl groups and C₁-C₄ alkyl groups.

Most preferred groups BD are non symmetrical groups, i.e. in formula (21) X¹ and X² are not at the same time an identical group selected from O, S, NR²³, SiR²⁴R²⁵ and CR²⁷R²⁸, preferably, in the case that X¹ and X² are NR²³, exactly one residue R²³ may be bonded to the ring B₁ or to the ring C₁ or to the ring A¹ to form a ring structure which is unsubstituted or substituted and the other residue R²³ is not bonded to the ring B¹ or to the ring C¹ or to the ring A¹.

### The group (L)ₘ

m is 1, 2 or 3, preferably 1; wherein in the case that m is 2 or 3 L is in each case the same or different.

L represents a direct bond, an unsubstituted or substituted aromatic hydrocarbon group containing 6 to 25 ring atoms, preferably 6 to 18 ring atoms, or an unsubstituted or substituted heteroaromatic group containing 3 to 24 ring atoms, preferably 3 to 18 ring atoms or a substituted or unsubstituted group 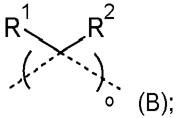
o is 1, 2 or 3, preferably 1; wherein in the case that o is 2 or 3, group (B) is in each case the same or different;
R¹ and R² each independently represents hydrogen or an alkyl group having from 1 to 50 carbon atoms preferably 1 to 25 carbon atoms, more preferably 1 to 8 carbon atoms which is unsubstituted or substituted;
the dotted lines in group (B) are bonding sites;
preferably, L represents a direct bond, an unsubstituted or substituted phenylene group, an unsubstituted or substituted naphthylene group, an unsubstituted or substituted divalent anthryl group, an unsubstituted or substituted divalent phenanthryl group, an unsubstituted or substituted divalent triphenylenyl group, an unsubstituted or substituted divalent 9,9-dimethyl fluorene group, an unsubstituted or substituted divalent 9,9-diphenyl fluorene group, an unsubstituted or substituted divalent 9,9-spirobifluorene group, an unsubstituted or substituted divalent heteroaromatic group containing 3 to 24 ring atoms, preferably 3 to 14 ring atoms or - C(CH₃)₂-; more preferably, L represents a direct bond, unsubstituted or substituted phenylene, e.g. unsubstituted or substituted 1,2-phenylene, unsubstituted or substituted 1,4-phenylene, unsubstituted or substituted 1,3-phenylene, unsubstituted or substituted naphthalene, e.g. unsubstituted or substituted 1,4-naphthalene, unsubstituted or substituted 1,5-naphthalene, unsubstituted or substituted 1,6-naphthalene, unsubstituted or substituted 2,6-naphthalene, unsubstituted 2,7-9,9-diphenyl-fluorene, unsubstituted 2,5-9,9-diphenyl-fluorene, unsubstituted 2,7-9,9-dimethyl-fluorene, unsubstituted 2,5-9,9-dimethyl-fluorene, unsubstituted 2,7-triphenylene, or an unsubstituted or substituted divalent heteroaromatic group containing 3 to 24 ring atoms, preferably 3 to 14 ring atoms; most preferably, L represents a direct bond, unsubstituted or substituted phenylene, e.g. unsubstituted 1,2-phenylene, unsubstituted 1,4-phenylene, unsubstituted 1,3-phenylene, 1,2-phenylene substituted with phenyl, naphthyl or phenanthryl, 1,4-phenylene substituted with phenyl, naphthyl or phenanthryl, 1,3-phenylene substituted with phenyl, naphthyl or phenanthryl, unsubstituted or substituted naphthalene, e.g. unsubstituted 1,4-naphthalene, unsubstituted 1,5-naphthalene, unsubstituted 1,6-naphthalene, unsubstituted 2,6-naphthalene, unsubstituted 2,7-9,9-diphenyl-fluorene, unsubstituted 2,5-9,9-diphenyl-fluorene, unsubstituted 2,7-9,9-dimethyl-fluorene, unsubstituted 2,5-9,9-dimethylfluorene, unsubstituted 2,7-triphenylene, or an unsubstituted divalent heteroaromatic group containing 3 to 24 ring atoms, preferably 3 to 14 ring atoms; further most preferably, L represents a direct bond, or unsubstituted or substituted phenylene, e.g. unsubstituted or substituted 1,2-phenylene, substituted 1,4-phenylene, unsubstituted or substituted 1,3-phenylene, even further most preferably, L represents substituted 1,4-phenylene, or unsubstituted or substituted 1,3-phenylene, even further most preferably, L represents unsubstituted or substituted 1,3-phenylene.

Most preferably, m is 1 and the group (L)ₘ represents a direct bond, unsubstituted or substituted phenylene, e.g. unsubstituted 1,2-phenylene, unsubstituted 1,4-phenylene, unsubstituted 1,3-phenylene, 1,2-phenylene substituted with phenyl, naphthyl or phenanthryl, 1,4-phenylene substituted with phenyl, naphthyl or phenanthryl, 1,3-phenylene substituted with phenyl, naphthyl or phenanthryl, unsubstituted or substituted naphthalene, e.g. unsubstituted 1,4-naphthalene, unsubstituted 1,5-naphthalene, unsubstituted 1,6-naphthalene, unsubstituted 2,6-naphthalene, unsubstituted 2,7-9,9-diphenyl-fluorene, unsubstituted 2,5-9,9-diphenyl-fluorene, unsubstituted 2,7-9,9-dimethyl-fluorene, unsubstituted 2,5-9,9-dimethyl-fluorene, unsubstituted 2,7-triphenylene, or an unsubstituted divalent heteroaromatic group containing 3 to 24 ring atoms, preferably 3 to 14 ring atoms; further most preferably, (L)ₘ represents a direct bond, or unsubstituted or substituted phenylene, e.g. unsubstituted or substituted 1,2-phenylene, substituted 1,4-phenylene, unsubstituted or substituted 1,3-phenylene, even further most preferably, L represents substituted 1,4-phenylene, or unsubstituted or substituted 1,3-phenylene, even further most preferably, L represents unsubstituted or substituted 1,3-phenylene.

### The group NAr₁Ar₂

Ar₁ and Ar₂ each independently represents a substituted or unsubstituted aryl group having 6 to 50 ring carbon atoms, preferably 6 to 30 ring atoms, more preferably 6 to 24 ring atoms, most preferably 6 to 18 ring atoms; a substituted or unsubstituted heterocyclic ring group having 5 to 50 ring atoms, preferably 5 to 30 ring atoms, more preferably 5 to 18 ring atoms; a substituted or unsubstituted alkyl group having 1 to 30 carbon atoms, preferably 1 to 25 carbon atoms, more preferably 1 to 8 carbon atoms; a substituted or unsubstituted aralkyl group having 7 to 50 ring carbon atoms; or Ar₁ and Ar₂ may be connected together to form a saturated or unsaturated ring.

Preferably, Ar₁ and Ar₂ each independently represents a substituted or unsubstituted phenyl group, a substituted or unsubstituted biphenyl group, a substituted or unsubstituted terphenyl group, a substituted or unsubstituted naphthyl group, a substituted or unsubstituted phenanthryl group, a substituted or unsubstituted triphenylenyl group, a substituted or unsubstituted fluorenyl group, a substituted or unsubstituted spirobifluorenyl group, a substituted or unsubstituted indenofluorenyl group, a substituted or unsubstituted carbazolyl group, a substituted or unsubstituted dibenzofuranyl group, a substituted or unsubstituted dibenzothiophenyl group,
or
the groups Ar₁ and Ar₂ are bonded to each other to form together with N the following ring structure 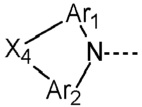 , preferably the following group 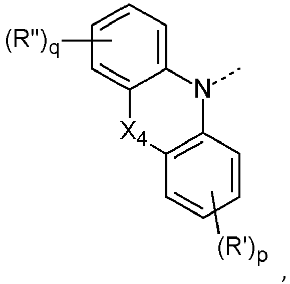 wherein X₄ represents a direct bond, O, S, SiR²⁴R²⁵ or CR²⁷R²⁸, preferably O, S, SiR²⁴R²⁵ or CR²⁷R²⁸, more preferably O or S;
R' and R" each independently represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
p and q each independently represents 0, 1, 2 or 3, preferably 0 or 1; and
the dotted line is a bonding site to L.

Examples for suitable ring structures are a phenoxazine ring structure, a phenothiazine ring structure, a carbazole ring structure, or a acridane ring structure.

In one embodiment, in the case that the group NAr₁Ar₂ is part of a 5-membered ring (e.g. X₄ represents a direct bond) or does nor form a ring, L does not represent a direct bond.

In a further embodiment, the present invention relates to a compound represented by formula (I), 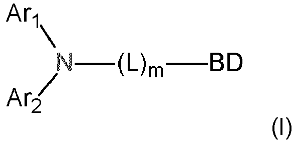 wherein
BD is a group selected from the groups consisting of 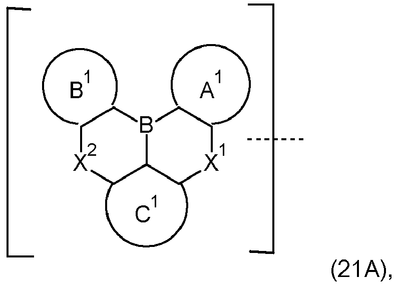
preferably a compound of formula (21Aa) or (21Ab) 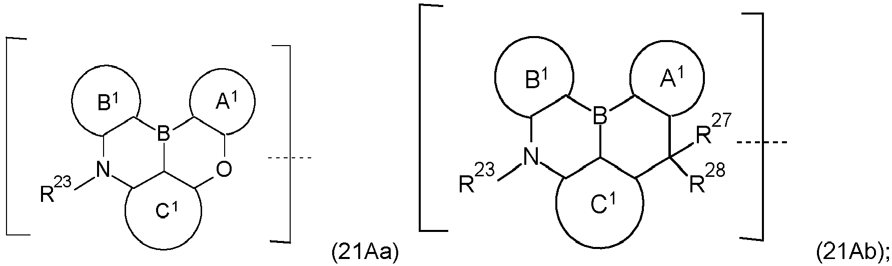 and 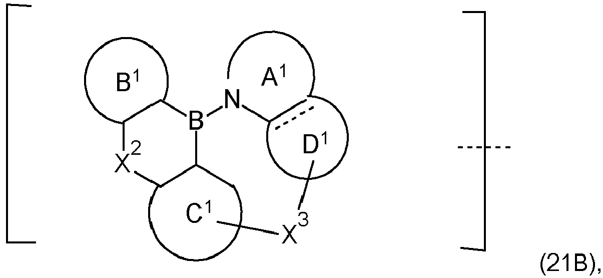 preferably a compound of (21 Ba) or (21 Bb) 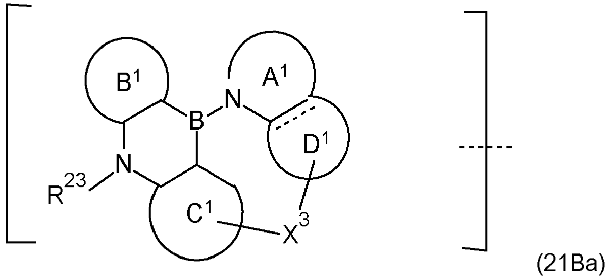 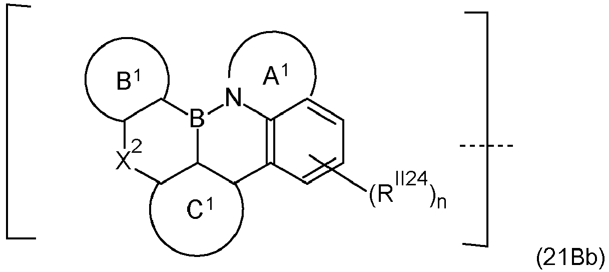 wherein
A¹ ring and B¹ ring each independently represents a substituted or unsubstituted aromatic hydrocarbon ring having 6 to 50 ring carbon atoms, or a substituted or unsubstituted heterocyclic ring having 5 to 50 ring atoms;
C¹ represents a substituted or unsubstituted aromatic hydrocarbon ring having 6 to 50 ring carbon atoms, or a substituted or unsubstituted heterocyclic ring having 5 to 50 ring atoms;
X¹ and X² are each O, S, NR²³, SiR²⁴R²⁵ or CR²⁷R²⁸; preferably X² is NR²³ and X¹ is O, S, SiR²⁴R²⁵ or CR²⁷R²⁸, more preferably X² is NR²³ and X¹ is O or CR²⁷R²⁸;
X³ represents a direct bond or O, S, NR²³, SiR²⁴R²⁵ or CR²⁷R²⁸; preferably a direct bond;
R^{II24} represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
ring D¹ represents a substituted or unsubstituted aromatic hydrocarbon ring having 6 to 50 ring carbon atoms, or a substituted or unsubstituted heterocyclic ring having 5 to 50 ring atoms, which is fused via a single bond or via a double bond with ring A¹;
n is 0, 1, 2 or 3, preferably 0 or 1;R²³, R²⁴, R²⁵, R²⁷ and R²⁸ each independently represents an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
   and/or
two residues R²⁴ and R²⁵ and/or two residues R²⁷ and R²⁸ together form a ring structure which is unsubstituted or substituted,
   and/or
one or more residues R²³ may be bonded to the ring B¹ and/or to the ring C¹ and/or to the ring A¹ to form a ring structure which is unsubstituted or substituted;
in the case that X¹ and X² are NR²³, exactly one residue R²³ may be bonded to the ring B¹ or to the ring C¹ or to the ring A¹ to form a ring structure which is unsubstituted or substituted;;
wherein the dotted line in formula (21A) and (21B) is a bonding site to L;
L represents a linking group, preferably selected from the group consisting of a substituted or unsubstituted aromatic hydrocarbon group having 6 to 30 ring carbon atoms, a substituted or unsubstituted heterocyclic group having 5 to 30 ring atoms, and a substituted or unsubstituted group 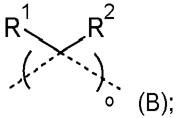
o is 1, 2 or 3, preferably 1; wherein in the case that o is 2 or 3, group (B) is in each case the same or different;
R¹ and R² each independently represents hydrogen, an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
   and/or
two residues R¹ and R² together form a ring structure which is unsubstituted or substituted; the dotted lines in group (B) are bonding sites;
   or
in the case that N of the group NAr₁Ar₂ is part of a 6-membered ring, L represents a direct bond or a linking group as defined above;
m is 1, 2 or 3, preferably 1; wherein in the case that m is 2 or 3 L is in each case the same or different;
Ar₁ and Ar₂ each independently represents a substituted or unsubstituted aryl group having 6 to 50 ring carbon atoms, a substituted or unsubstituted heterocyclic ring group having 5 to 50 ring atoms, a substituted or unsubstituted alkyl group having 1 to 30 carbon atoms, a substituted or unsubstituted aralkyl group having 7 to 50 ring carbon atoms; Ar₁ and Ar₂ may be bonded together to form a saturated or unsaturated ring.

"in the case that N of the group NAr₁Ar₂ is part of a 6-membered ring, L represents a direct bond or a linking group as defined above;" preferably means that in the case that the group NAr₁Ar₂ is part of a 5-membered ring or does nor form a ring, L does not represent a direct bond.

Preferred groups, residues and indices in the inventive compounds of the further embodiment are the same as the preferred groups, residues and indices as mentioned above, unless otherwise indicated.

The inventive compounds preferably have a molecular weight of at most 1500, preferably less than 1350 and more more preferably less than 1200.

Examples for compounds of formula (I) are shown below:

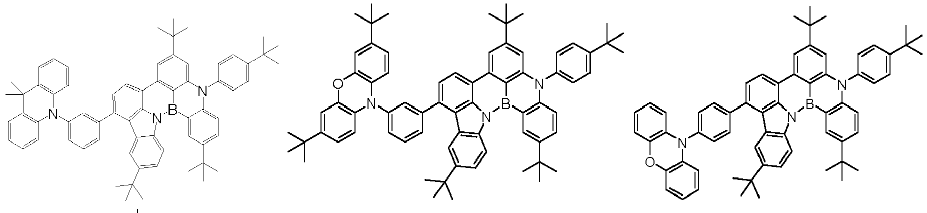

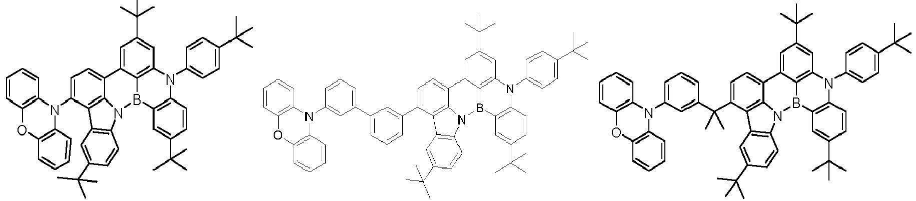

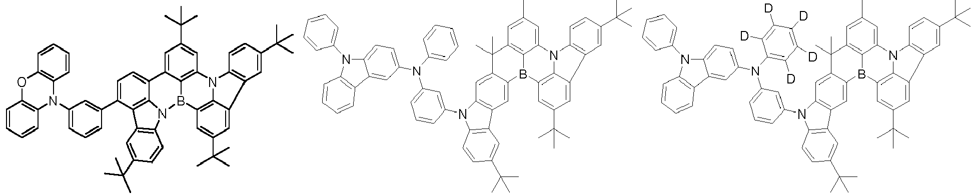

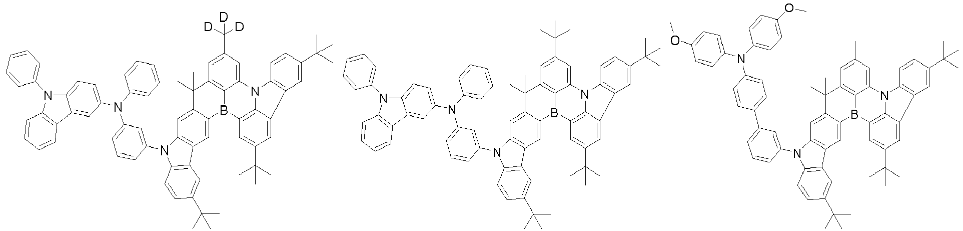

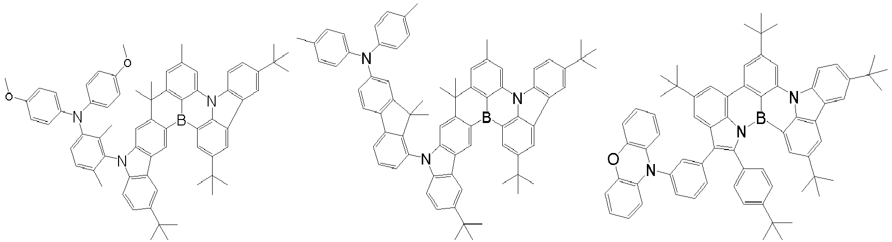

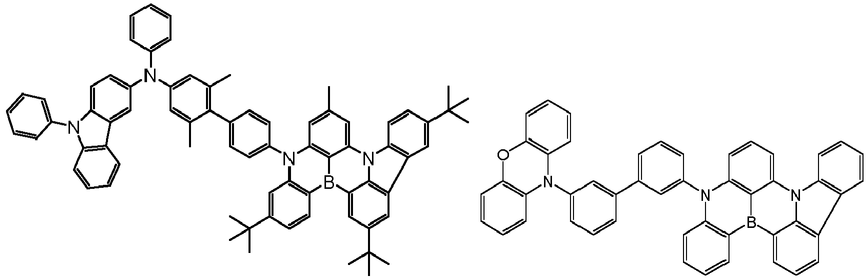

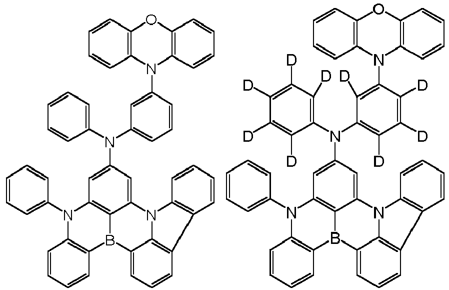

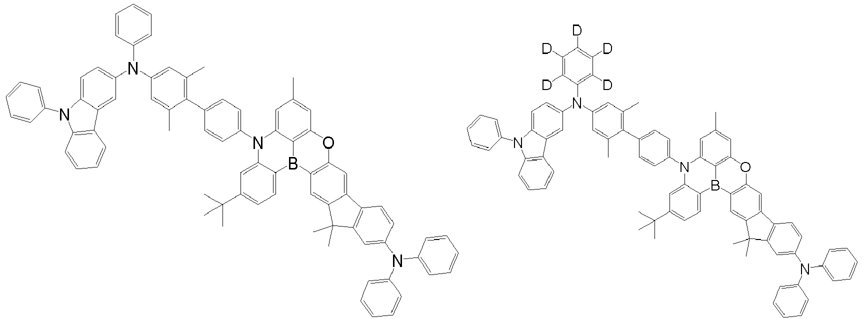

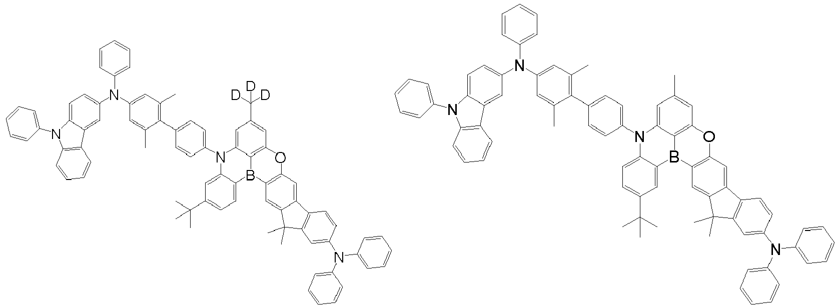

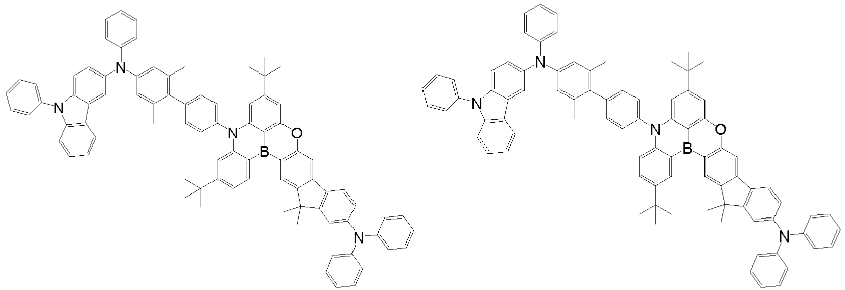

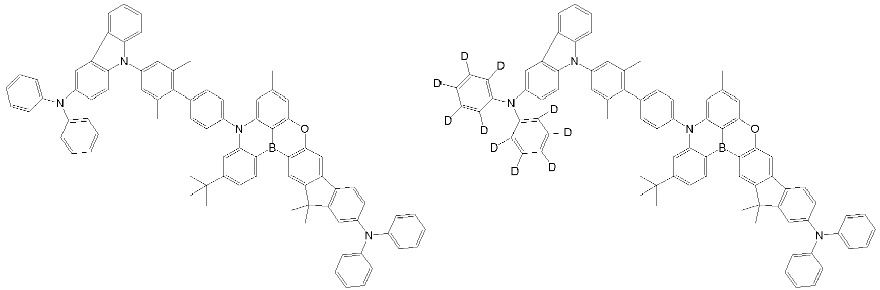

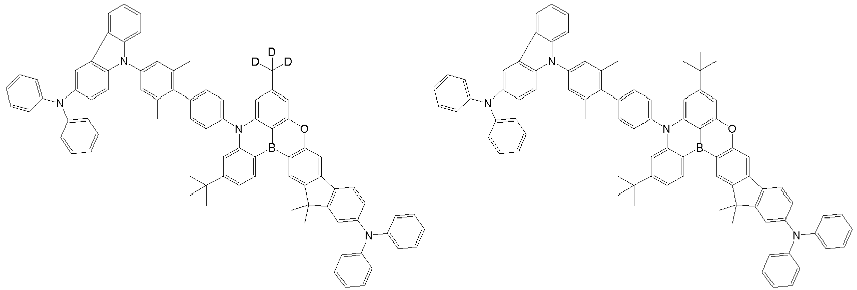

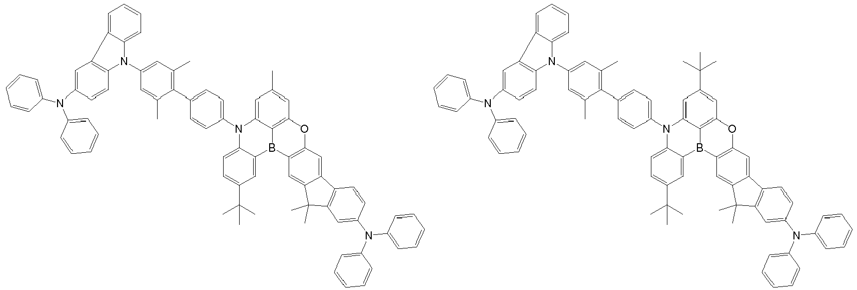

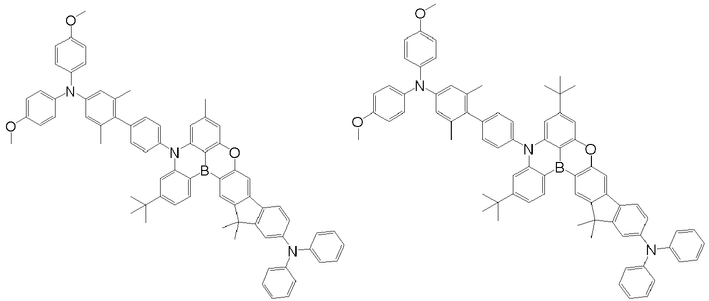

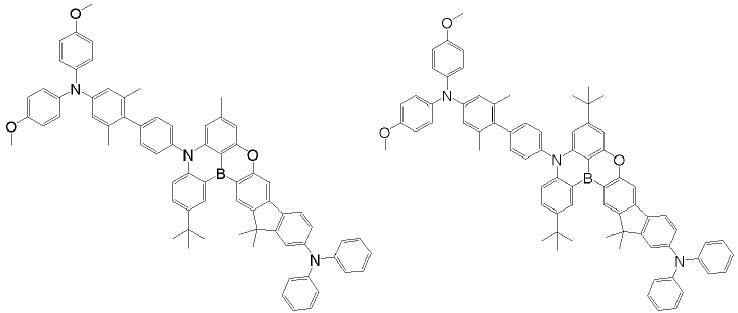

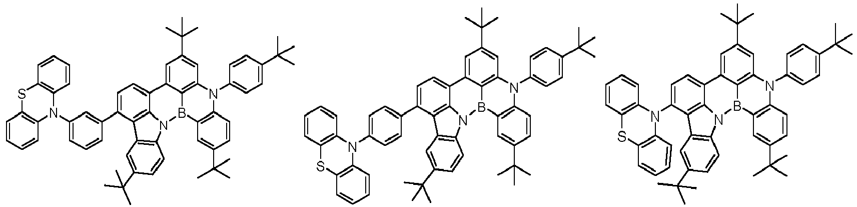

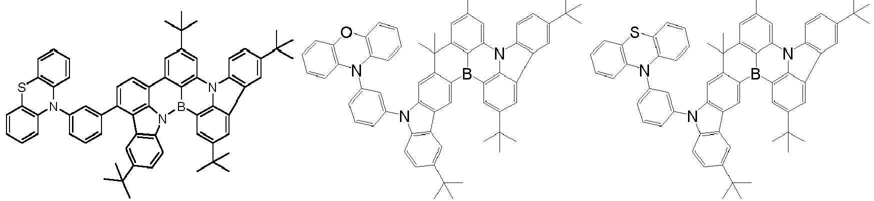

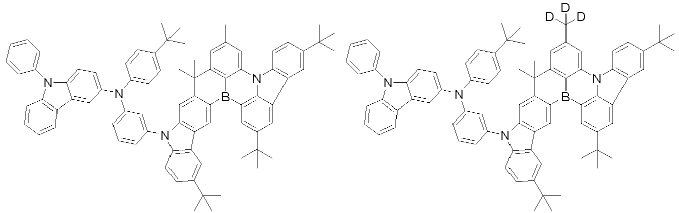

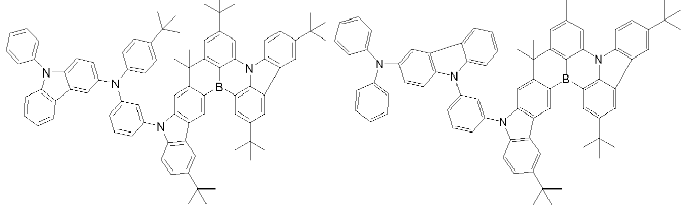

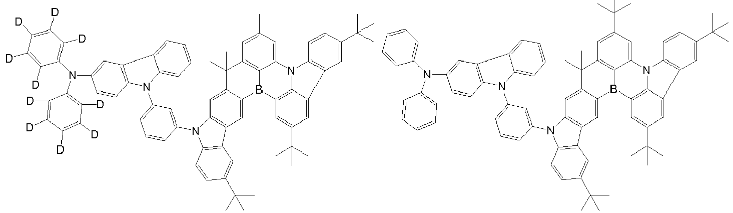

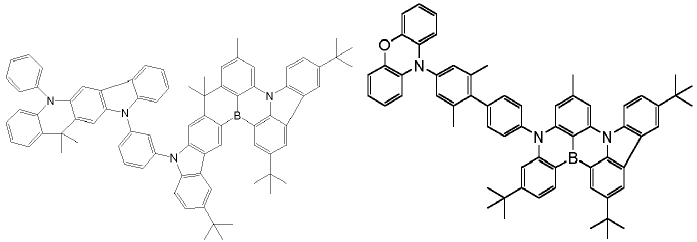

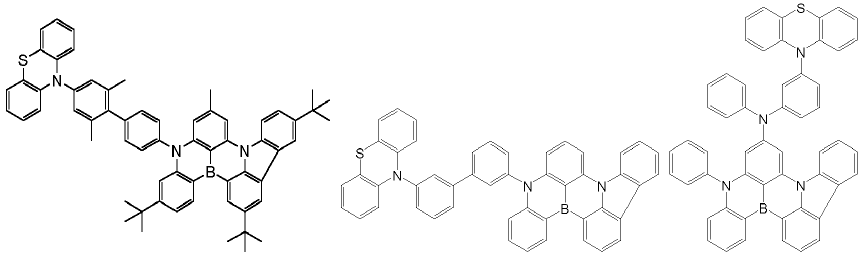

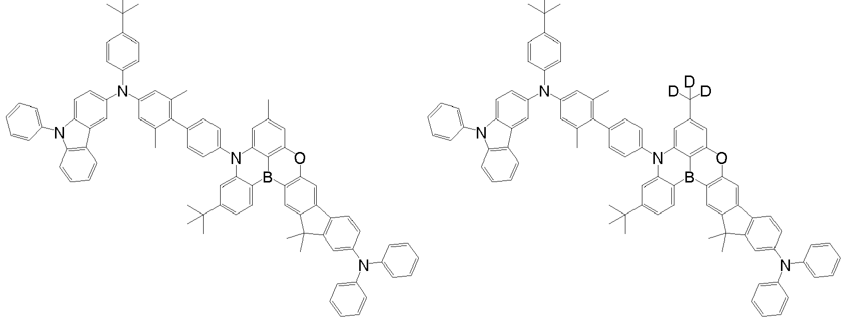

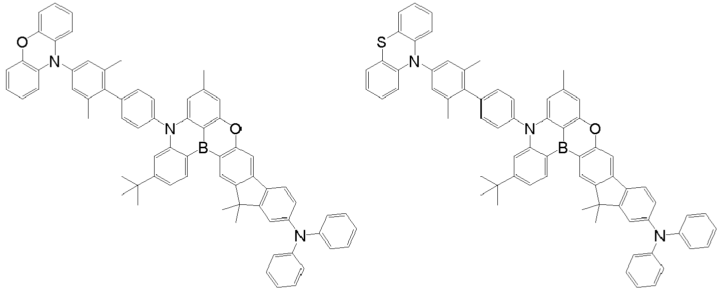

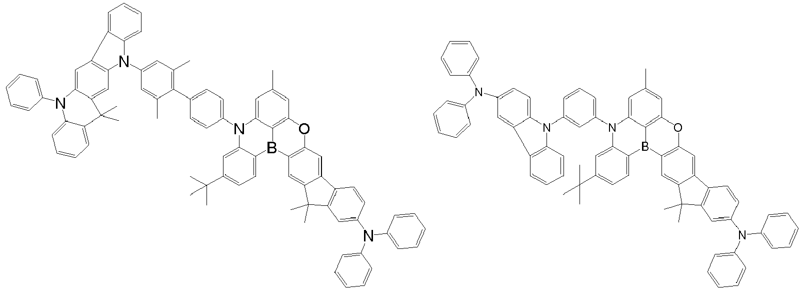

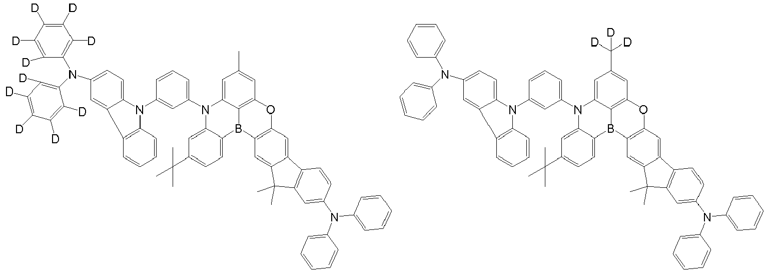

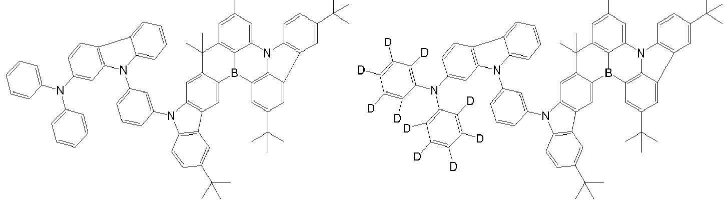

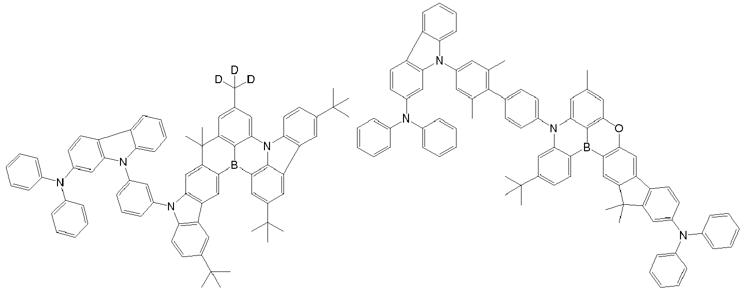

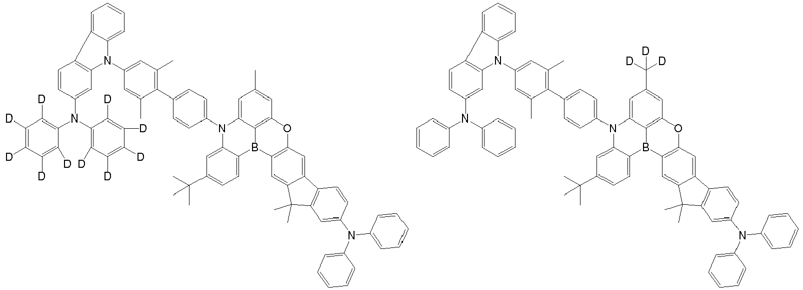

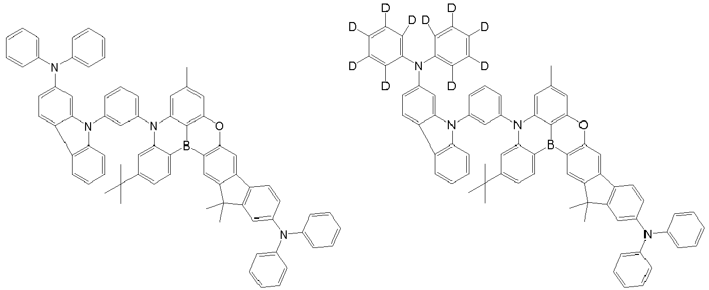

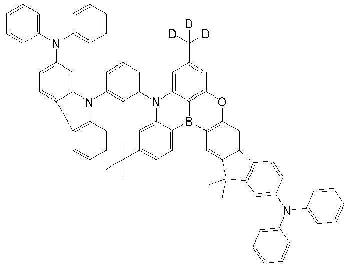

### Preparation of the compounds of formula (I)

The compounds represented by formula (I) can be synthesized in accordance with the reactions conducted in the examples of the present application, and by using alternative reactions or raw materials suited to an intended product, in analogy to reactions and raw materials known in the art.

### Organic electroluminescence device

According to one aspect of the present invention a material for an organic electroluminescence device comprising at least one compound of formula (I) is provided.

According to another aspect of the present invention, an organic electroluminescence device comprising at least one compound of formula (I) is provided.

According to another aspect of the invention, the following organic electroluminescence device is provided: An organic electroluminescence device comprising a cathode, an anode, and one or more organic thin film layers comprising a light emitting layer disposed between the cathode and the anode, wherein at least one layer of the organic thin film layers comprises at least one compound of formula (I).

According to another aspect of the invention an organic electroluminescence device is provided, wherein the light emitting layer comprises at least one compound of formula (I).

According to another aspect of the invention an organic electroluminescence device is provided, wherein the light emitting layer comprises at least one compound of formula (I) as a dopant material and an anthracene compound as a host material.

According to another aspect of the invention an electronic equipment provided with the organic electroluminescence device according to the present invention is provided.

According to another aspect of the invention an emitter material is provided comprising at least one compound of formula (I).

According to another aspect of the invention a light emitting layer is provided comprising at least one host and at least one dopant, wherein the dopant comprises at least one compound of formula (I).

According to another aspect of the invention the use of a compound of formula (I) according to the present invention in an organic electroluminescence device is provided.

In one embodiment, the organic EL device comprises a hole-transporting layer between the anode and the emitting layer.

In one embodiment, the organic EL device comprises an electron-transporting layer between the cathode and the emitting layer.

In the present specification, regarding the "one or more organic thin film layers between the emitting layer and the anode", if only one organic layer is present between the emitting layer and the anode, it means that layer, and if plural organic layers are present, it means at least one layer thereof. For example, if two or more organic layers are present between the emitting layer and the anode, an organic layer nearer to the emitting layer is called the "hole-transporting layer", and an organic layer nearer to the anode is called the "hole-injecting layer". Each of the "hole-transporting layer" and the "hole-injecting layer" may be a single layer or may be formed of two or more layers. One of these layers may be a single layer and the other may be formed of two or more layers.

Similarly, regarding the "one or more organic thin film layers between the emitting layer and the cathode", if only one organic layer is present between the emitting layer and the cathode, it means that layer, and if plural organic layers are present, it means at least one layer thereof. For example, if two or more organic layers are present between the emitting layer and the cathode, an organic layer nearer to the emitting layer is called the "electron-transporting layer", and an organic layer nearer to the cathode is called the "electron-injecting layer". Each of the "electron-transporting layer" and the "electron-injecting layer" may be a single layer or may be formed of two or more layers. One of these layers may be a single layer and the other may be formed of two or more layers.

The "one or more organic thin film layers comprising an emitting layer" mentioned above, preferably the emitting layer, comprises a compound represented by formula (I). The compound represented by formula (I) preferably functions as an emitter material, more preferably as a fluorescent emitter material, most preferably as a blue fluorescent emitter material. By the presence of a compound of formula (I) in the organic EL device, preferably in the emitting layer, organic EL devices characterized by high external quantum efficiencies (EQE) and long lifetimes are provided.

According to another aspect of the invention, an emitting layer of the organic electroluminescence device is provided which comprises at least one compound of formula (I).

Preferably, the emitting layer comprises at least one emitting material (dopant material) and at least one host material, wherein the emitting material is at least one compound of formula (I).

### Host material

Suitable host materials are substituted or unsubstituted polycyclic aromatic hydrocarbon (PAH) compounds or substituted or unsubstituted polycyclic heteroaromatic compounds.

Preferably, the organic electroluminescence device according to the present invention comprises in the emitting layer at least one compound of formula (I) and at least one host material selected substituted or unsubstituted polycyclic aromatic hydrocarbon (PAH) compounds and substituted or unsubstituted polycyclic heteroaromatic compounds.

Preferably, the at least one host material is a substituted or unsubstituted anthracene compound, a substituted or unsubstituted chrysene compound, a substituted or unsubstituted pyrene compound, a substituted or unsubstituted fluorene compound or a substituted or unsubstituted fluoranthene compound, with a substituted or unsubstituted pyrene compound and a substituted or unsubstituted anthracene compound being more preferred and a substituted or unsubstituted anthracene compound being most preferred.

According to another aspect of the invention, an organic electroluminescence device is provided comprising an emitting layer which comprises at least one compound of formula (I) and an anthracene compound as a host material.

Suitable anthracene skeleton-containing compounds exclusively comprising carbon and hydrogen are for example described in US 2021/005826 A1 and US 2019/0280209 A1.

Suitable anthracene compounds are represented by the following formula (10): 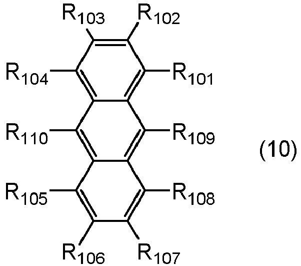 wherein
one or more pairs of two or more adjacent R₁₀₁ to R₁₁₀ may form a substituted or unsubstituted, saturated or unsaturated ring;
R₁₀₁ to R₁₁₀ that do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R₁₂₁)(R₁₂₂)(R₁₂₃), - C(=O)R₁₂₄, -COOR₁₂₅, -N(R₁₂₆)(R₁₂₇), a halogen atom, a cyano group, a nitro group, a substituted or unsubstituted aryl group including 6 to 50 ring carbon atoms, a substituted or unsubstituted monovalent heterocyclic group including 5 to 50 ring atoms, or a group represented by the following formula (31);
R₁₂₁ to R₁₂₇ are independently a hydrogen atom, a substituted or unsubstituted alkyl group including 1 to 50 carbon atoms, a substituted or unsubstituted cycloalkyl group including 3 to 50 ring carbon atoms, a substituted or unsubstituted aryl group including 6 to 50 ring carbon atoms or a substituted or unsubstituted monovalent heterocyclic group including 5 to 50 ring atoms; when each of R₁₂₁ to R₁₂₇ is present in plural, each of the plural R₁₂₁ to R₁₂₇ may be the same or different;
provided that at least one of R₁₀₁ to R₁₁₀ that do not form the substituted or unsubstituted, saturated or unsaturated ring is a group represented by the following formula (31). If two or more groups represented by the formula (31) are present, each of these groups may be the same or different;

   -L₁₀₁-Ar₁₀₁ (31)

   wherein in the formula (31),
L₁₀₁ is a single bond, a substituted or unsubstituted arylene group including 6 to 30 ring carbon atoms or a substituted or unsubstituted divalent heterocyclic group including 5 to 30 ring atoms; Ar₁₀₁ is a substituted or unsubstituted aryl group including 6 to 50 ring carbon atoms or a substituted or unsubstituted monovalent heterocyclic group including 5 to 50 ring atoms.

Specific examples of each substituent, substituents for "substituted or unsubstituted" and the halogen atom in the compound (10) are the same as those mentioned above.

An explanation will be given on "one or more pairs of two or more adjacent R₁₀₁ to R₁₁₀ may form a substituted or unsubstituted, saturated or unsaturated ring".

The "one pair of two or more adjacent R₁₀₁ to R₁₁₀" is a combination of R₁₀₁ and R₁₀₂, R₁₀₂ and R₁₀₃, R₁₀₃ and R₁₀₄, R₁₀₅ and R₁₀₆, R₁₀₆ and R₁₀₇, R₁₀₇ and R₁₀₈, R₁₀₈ and R₁₀₉, R₁₀₁ and R₁₀₂ and R₁₀₃ or the like, for example.

The substituent in "substituted" in the "substituted or unsubstituted" for the saturated or unsaturated ring is the same as those for "substituted or unsubstituted" mentioned in the formula (10).

The "saturated or unsaturated ring" means, when R₁₀₁ and R₁₀₂ form a ring, for example, a ring formed by a carbon atom with which R₁₀₁ is bonded, a carbon atom with which R₁₀₂ is bonded and one or more arbitrary elements. Specifically, when a ring is formed by R₁₀₁ and R₁₀₂, when an unsaturated ring is formed by a carbon atom with which R₁₀₁ is bonded, a carbon atom with R₁₀₂ is bonded and four carbon atoms, the ring formed by R₁₀₁ and R₁₀₂ is a benzene ring.

The "arbitrary element" is preferably a C element, a N element, an O element or a S element. In the arbitrary element (C element or N element, for example), atomic bondings that do not form a ring may be terminated by a hydrogen atom, or the like.

The "one or more arbitrary element" is preferably 2 or more and 15 or less, more preferably 3 or more and 12 or less, and further preferably 3 or more and 5 or less arbitrary elements.

For example, R₁₀₁ and R₁₀₂ may form a ring, and simultaneously, R₁₀₅ and R₁₀₆ may form a ring. In this case, the compound represented by the formula (10) is a compound represented by the following formula (10A), for example:

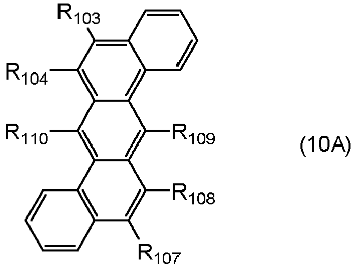

In one embodiment, R₁₀₁ to R₁₁₀ are independently a hydrogen atom, a substituted or unsubstituted alkyl group including 1 to 50 carbon atoms, a substituted or unsubstituted aryl group including 6 to 50 ring carbon atoms, a substituted or unsubstituted heterocyclic group including 5 to 50 ring atoms or a group represented by the formula (31).

Preferably, R₁₀₁ to R₁₁₀ are independently a hydrogen atom, a substituted or unsubstituted aryl group including 6 to 50 ring carbon atoms, a substituted or unsubstituted heterocyclic group including 5 to 50 ring atoms or a group represented by the formula (31).

More preferably, R₁₀₁ to R₁₁₀ are independently a hydrogen atom, a substituted or unsubstituted aryl group including 6 to 18 ring carbon atoms, a substituted or unsubstituted heterocyclic group including 5 to 18 ring atoms or a group represented by the formula (31).

Most preferably, at least one of R₁₀₉ and R₁₁₀ is a group represented by the formula (31).

Further most preferably, R₁₀₉ and R₁₁₀ are independently a group represented by the formula (31).

In one embodiment, the compound (10) is a compound represented by the following formula (10-1): 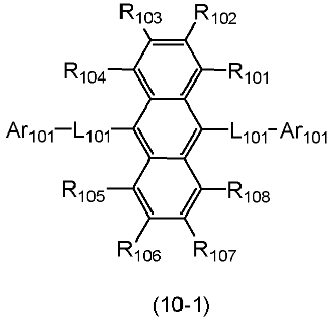 wherein in the formula (10-1), R₁₀₁ to R₁₀₈, L₁₀₁ and Ar₁₀₁ are as defined in the formula (10).

In one embodiment, the compound (10) is a compound represented by the following formula (10-2): 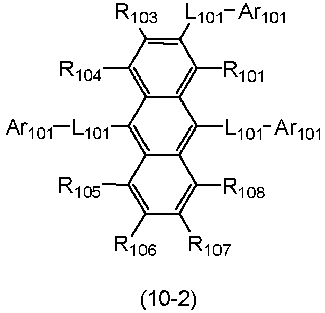 wherein in the formula (10-2), R₁₀₁, R₁₀₃ to R₁₀₈, L₁₀₁ and Ar₁₀₁ are as defined in the formula (10).

In one embodiment, the compound (10) is a compound represented by the following formula (10-3): 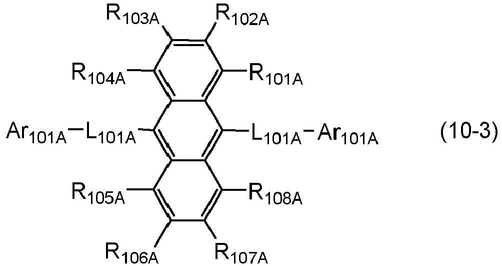 wherein in the formula (10-3),
R_{101A} to R_{108A} are independently a hydrogen atom or a substituted or unsubstituted aryl group including 6 to 50 ring carbon atoms;
L_{101A} is a single bond or a substituted or unsubstituted arylene group including 6 to 30 ring carbon atoms, and the two L_{101A}s may be the same or different;
Ar_{101A} is a substituted or unsubstituted aryl group including 6 to 50 ring carbon atoms, and the two Ar_{101A}s may be the same or different.

In one embodiment, the compound (10) is a compound represented by the following formula (10-4): 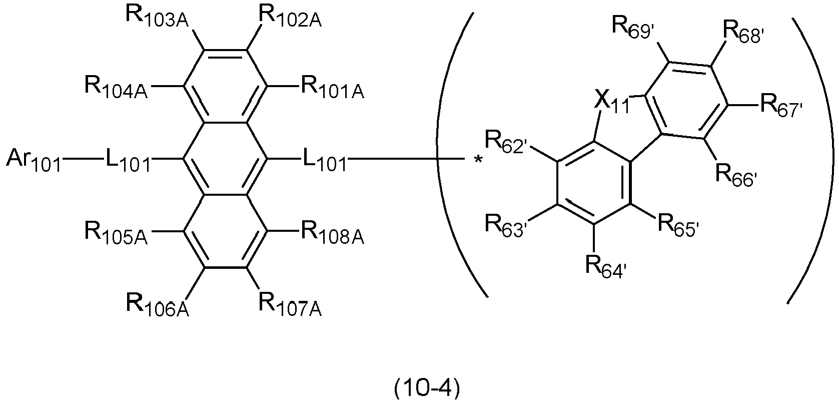 wherein in the formula (10-4),
L₁₀₁ and Ar₁₀₁ are as defined in the formula (10);
R_{101A} to R_{108A} are independently a hydrogen atom or a substituted or unsubstituted aryl group including 6 to 50 ring carbon atoms;
X₁₁ is O, S, or N(R_{61'});
R_{61'} is a hydrogen atom, a substituted or unsubstituted alkyl group including 1 to 50 carbon atoms or a substituted or unsubstituted aryl group including 6 to 50 ring carbon atoms;
one of R_{62'} to R_{69'} is an atomic bonding that is bonded with L₁₀₁;
one or more pairs of adjacent R_{62'} to R_{69'} that are not bonded with L₁₀₁ may be bonded with each other to form a substituted or unsubstituted, saturated or unsaturated ring; and
R_{62'} to R_{69'} that are not bonded with L₁₀₁ and do not form the substituted or unsubstituted, saturated or unsaturated ring are independently a hydrogen atom, a substituted or unsubstituted alkyl group including 1 to 50 carbon atoms or a substituted or unsubstituted aryl group including 6 to 50 ring carbon atoms.

In one embodiment, the compound (10) is a compound represented by the following formula (10-4A): 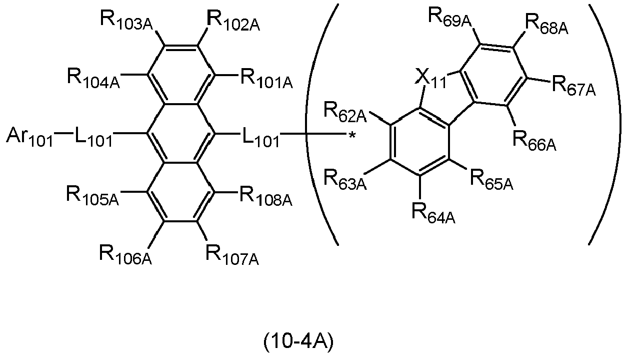 wherein in the formula (10-4A),
L₁₀₁ and Ar₁₀₁ are as defined in the formula (10);
R_{101A} to R_{108A} are independently a hydrogen atom or a substituted or unsubstituted aryl group including 6 to 50 ring carbon atoms;
X₁₁ is O, S or N(R₆₁);
R₆₁ is a hydrogen atom, a substituted or unsubstituted alkyl group including 1 to 50 carbon atoms or a substituted or unsubstituted aryl group including 6 to 50 ring carbon atoms;
one or more pairs of adjacent two or more of R_{62A} to R_{69A} may form a substituted or unsubstituted, saturated or unsaturated ring, and adjacent two of R_{62A} to R_{69A} form a ring represented by the following formula (10-4A-1); and
R_{62A} to R_{69A} that do not form a substituted or unsubstituted, saturated or unsaturated ring are independently a hydrogen atom, a substituted or unsubstituted alkyl group including 1 to 50 carbon atoms or a substituted or unsubstituted aryl group including 6 to 50 ring carbon atoms. 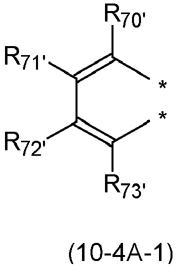 wherein in the formula (10-4A-1),
each of the two atomic bondings * is bonded with adjacent two of R_{62A} to R_{69A};
one of R_{70'} to R_{73'} is an atomic bonding that is bonded with L₁₀₁; and
R_{70'} to R_{73'} that are not bonded with L₁₀₁ are independently a hydrogen atom, a substituted or unsubstituted alkyl group including 1 to 50 carbon atoms or a substituted or unsubstituted aryl group including 6 to 50 ring carbon atoms.

In one embodiment, the compound (10) is a compound represented by the following formula (10-6): 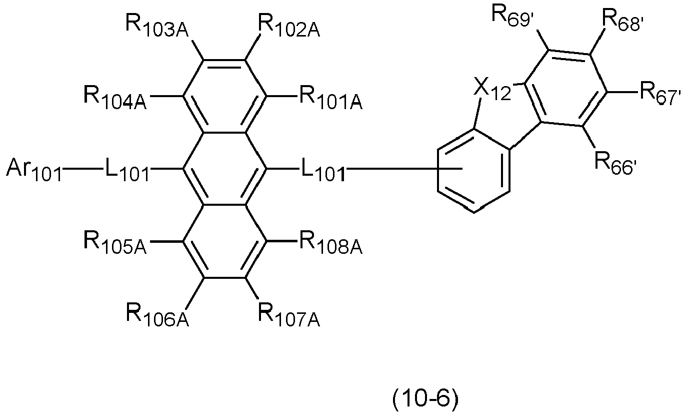 wherein in the formula (10-6),
L₁₀₁ and Ar₁₀₁ are as defined in the formula (10);
R_{101A} to R_{108A} are as defined in the formula (10-4);
R_{66'} to R_{69'} are as defined in the formula (10-4); and
X₁₂ is O or S.

In one embodiment, the compound represented by the formula (10-6) is a compound represented by the following formula (10-6H): 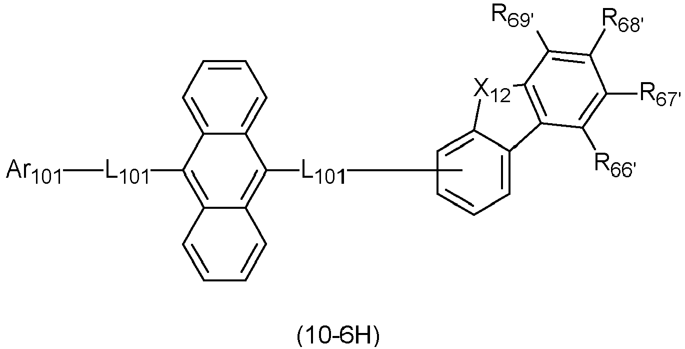 wherein in the formula (10-6H),
L₁₀₁ and Ar₁₀₁ are as defined in the formula (10);
R_{66'} to R_{69'} are as defined in the formula (10-4); and
X₁₂ is O or S.

In one embodiment, the compound represented by the formulae (10-6) and (10-6H) is a compound represented by the following formula (10-6Ha): 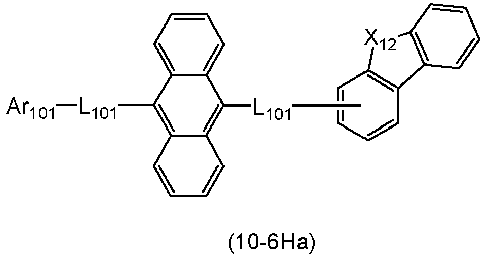 wherein in the formula (10-6Ha),
L₁₀₁ and Ar₁₀₁ are as defined in the formula (10); and
X₁₂ is O or S.

In one embodiment, the compound represented by the formulae (10-6), (10-6H) and (10-6Ha) is a compound represented by the following formula (10-6Ha-1) or (10-6Ha-2): 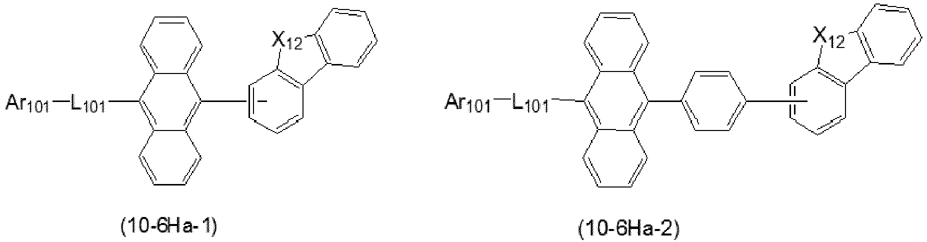 wherein in the formula (10-6Ha-1) and (10-6Ha-2),
L₁₀₁ and Ar₁₀₁ are as defined in the formula (10); and
X₁₂ is O or S.

In one embodiment, the compound (10) is a compound represented by the following formula (10-7): 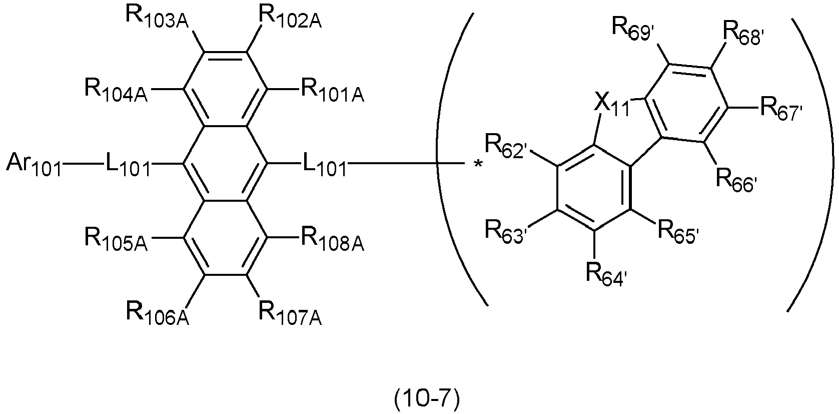 wherein in the formula (10-7),
L₁₀₁ and Ar₁₀₁ are as defined in the formula (10);
R_{101A} to R_{108A} are as defined in the formula (10-4);
X₁₁ is as defined in the formula (10-4); and
R_{62'} to R_{69'} are as defined in the formula (10-4), provided that any one pair of R_{66'} and R_{67'}, R_{67'} and R_{68'}, and R_{68'} and R_{69'} are bonded with each other to form a substituted or unsubstituted, saturated or unsaturated ring.

In one embodiment, the compound (10) is a compound represented by the following formula (10-7H): 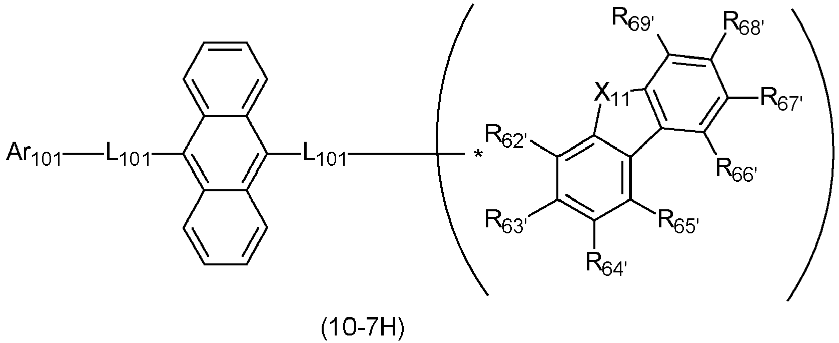 wherein in the formula (10-7H),
L₁₀₁ and Ar₁₀₁ are as defined in the formula (10);
X₁₁ is as defined in the formula (10-4); and
R_{62'} to R_{69'} are as defined in the formula (10-4), provided that any one pair of R_{66'} and R_{67'}, R_{67'} and R_{68'}, and R_{68'} and R_{69'} are bonded with each other to form a substituted or unsubstituted, saturated or unsaturated ring.

In one embodiment, the compound (10) is a compound represented by the following formula (10-8): 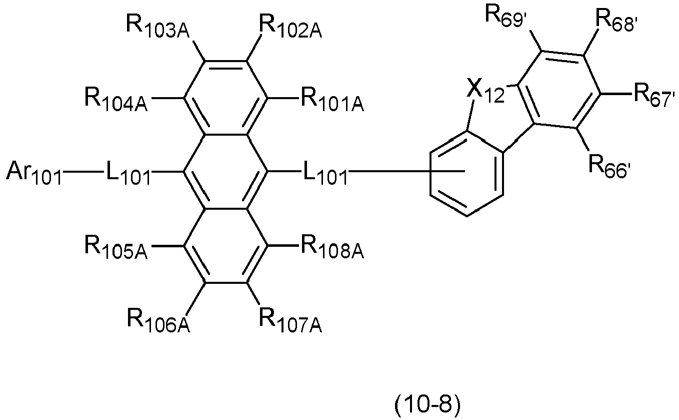 wherein in the formula (10-8),
L₁₀₁ and Ar₁₀₁ are as defined in the formula (10);
R_{101A} to R_{108A} are as defined in the formula (10-4);
X₁₂ is O or S; and
R_{66'} to R_{69'} are as defined in the formula (10-4), provided that any one pair of R_{66'} and R_{67'}, R_{67'} and R_{68'}, as well as R_{68'} and R_{69'} are bonded with each other to form a substituted or unsubstituted, saturated or unsaturated ring.

In one embodiment, the compound represented by the formula (10-8) is a compound represented by the following formula (10-8H):

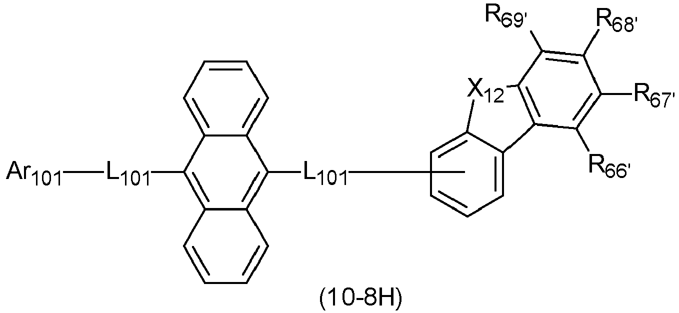

In the formula (10-8H), L₁₀₁ and Ar₁₀₁ are as defined in the formula (10).
R_{66'} to R_{69'} are as defined in the formula (10-4), provided that any one pair of R_{66'} and R_{67'}, R_{67'} and R_{68'}, as well as R_{68'} and R_{69'} are bonded with each other to form a substituted or unsubstituted, saturated or unsaturated ring. Any one pair of R_{66'} and R_{67'}, R_{67'} and R_{68'}, as well as R_{68'} and R_{69'} may preferably be bonded with each other to form an unsubstituted benzene ring; and
X₁₂ is O or S.

In one embodiment, as for the compound represented by the formula (10-7), (10-8) or (10-8H), any one pair of R_{66'} and R_{67'}, R_{67'} and R_{68'}, as well as R_{68'} and R_{69'} are bonded with each other to form a ring represented by the following formula (10-8-1) or (10-8-2), and R_{66'} to R_{69'} that do not form the ring represented by the formula (10-8-1) or (10-8-2) do not form a substituted or unsubstituted, saturated or unsaturated ring. 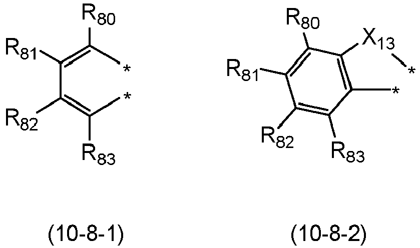 wherein in the formulae (10-8-1) and (10-8-2),
the two atomic bondings * are independently bonded with one pair of R_{66'} and R_{67'}, R_{67'} and R_{68'}, or R_{68'} and R_{69'};
R₈₀ to R₈₃ are independently a hydrogen atom, a substituted or unsubstituted alkyl group including 1 to 50 carbon atoms or a substituted or unsubstituted aryl group including 6 to 50 ring carbon atoms; and
X₁₃ is O or S.

In one embodiment, the compound (10) is a compound represented by the following formula (10-9): 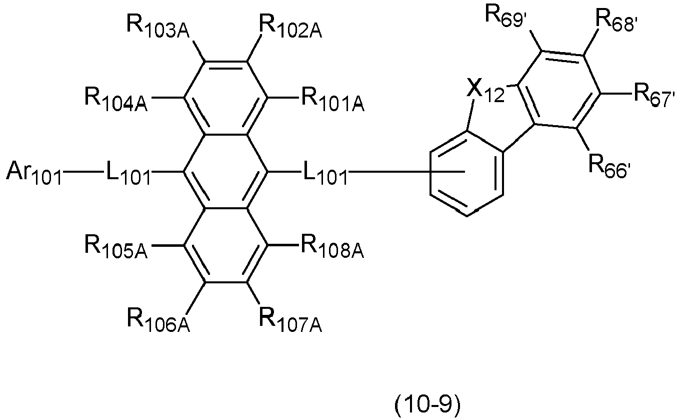 wherein in the formula (10-9),
L₁₀₁ and Ar₁₀₁ are as defined in the formula (10);
R_{101A} to R_{108A} are as defined in the formula (10-4);
R_{66'} to R_{69'} are as defined in the formula (10-4), provided that R_{66'} and R_{67'}, R_{67'} and R_{68'}, as well as R_{68'} and R_{69'} are not bonded with each other and do not form a substituted or unsubstituted, saturated or unsaturated ring; and
X₁₂ is O or S.

In one embodiment, the compound (10) is selected from the group consisting of compounds represented by the following formulae (10-10-1) to (10-10-4).

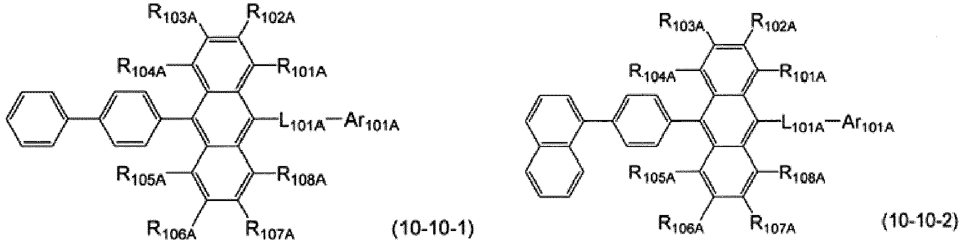

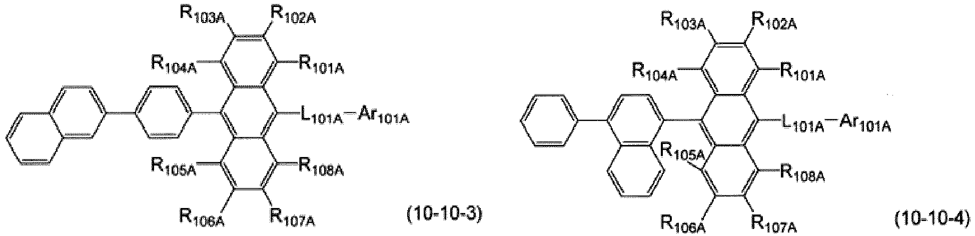

In the formulae (10-10-1H) to (10-10-4H), L_{101A} and Ar_{101A} are as defined in the formula (10-3).

In one embodiment, in the compound represented by the formula (10-1), at least one Ar₁₀₁ is a monovalent group having a structure represented by the following formula (50). 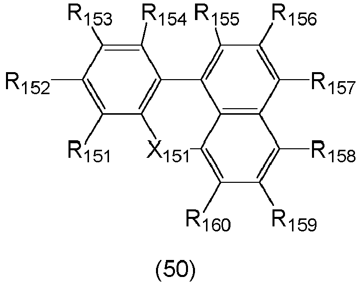 In the formula (50),
X₁₅₁ is O, S, or C(R₁₆₁)(R₁₆₂).

One of R₁₅₁ to R₁₆₀ is a single bond which bonds with L₁₀₁.

One or more sets of adjacent two or more of R₁₅₁ to R₁₅₄ and one or more sets of adjacent two or more of R₁₅₅ to R₁₆₀, which are not a single bond which bonds with L₁₀₁, form a substituted or unsubstituted, saturated or unsaturated ring by bonding with each other, or do not form a substituted or unsubstituted, saturated or unsaturated ring.

R₁₆₁ and R₁₆₂ form a substituted or unsubstituted, saturated or unsaturated ring by bonding with each other, or do not form a substituted or unsubstituted, saturated or unsaturated ring.

R₁₆₁ and R₁₆₂ which do not form the substituted or unsubstituted, saturated or unsaturated ring, and R₁₅₁ to R₁₆₀ which are not a single bond which bonds with L₁₀₁ and do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R121)(R122)(R123), -C(=O)R124, -COOR125, - N(R126)(R127), a halogen atom, a cyano group, a nitro group, a substituted or unsubstituted aryl group including 6 to 50 ring carbon atoms, or a substituted or unsubstituted monovalent heterocyclic group including 5 to 50 ring atoms.

Ar₁₀₁, which is not a monovalent group having the structure represented by the formula (50) is a substituted or unsubstituted aryl group including 6 to 50 ring carbon atoms, or a substituted or unsubstituted divalent heterocyclic group including 5 to 50 ring atoms.

The position to be the single bond which bonds with L₁₀₁ in the formula (50) is not particularly limited. In one embodiment, one of R₁₅₁ to R₁₆₀ in the formula (50) is a single bond which bonds with L₁₀₁.

In one embodiment, Ar₁₀₁ is a monovalent group represented by the following formula (50-R₁₅₂), (50-R₁₅₃), (50-R₁₅₄), (50-R₁₅₇), or (50-R₁₅₈).

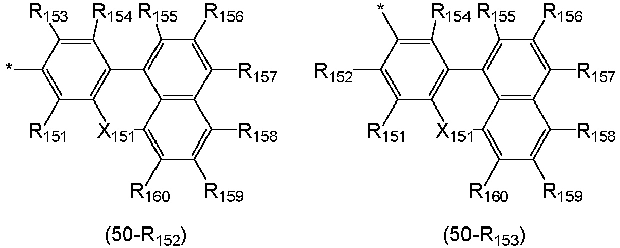

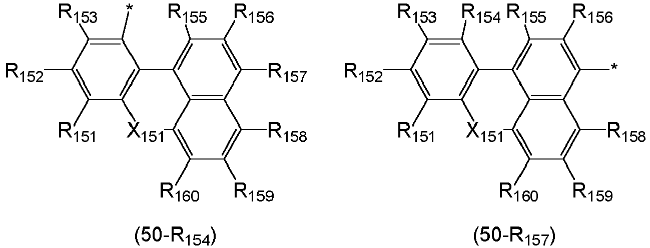

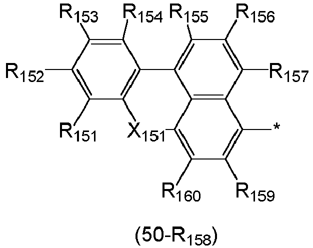

In the formulas (50-R₁₅₂), (50-R₁₅₃), (50-R₁₅₄), (50-R₁₅₇), and (50-R₁₅₈), X₁₅₁, R₁₅₁ to R₁₆₀ are as defined in the formula (50).

* is a single bond which bonds with L₁₀₁.

As for the compound represented by the formula (10), the following compounds can be given as specific examples. The compound represented by the formula (10) is not limited to these specific examples. In the following specific examples, "D" represents a deuterium atom.

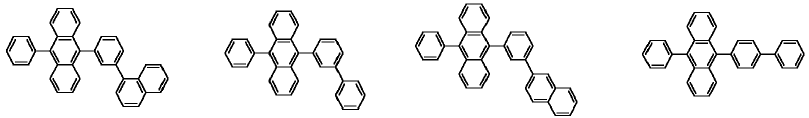

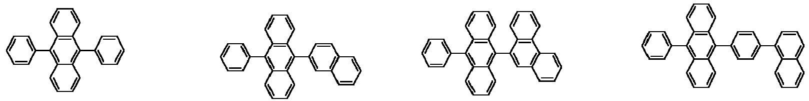

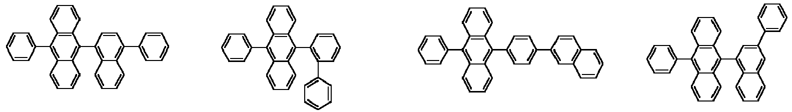

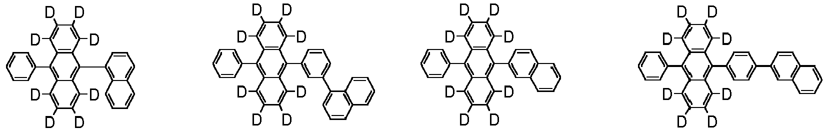

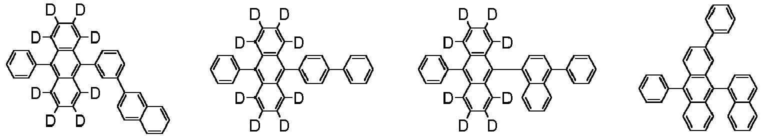

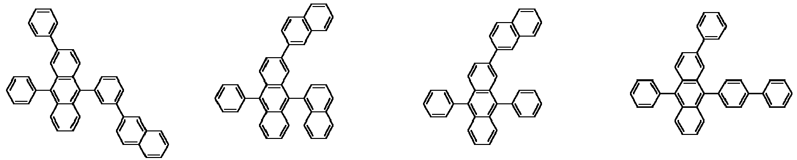

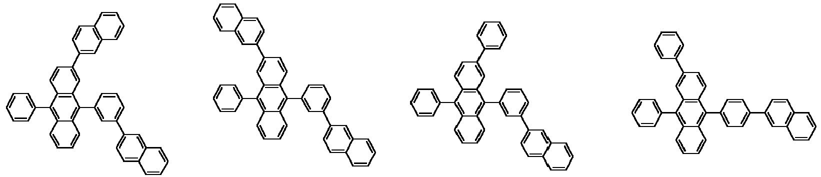

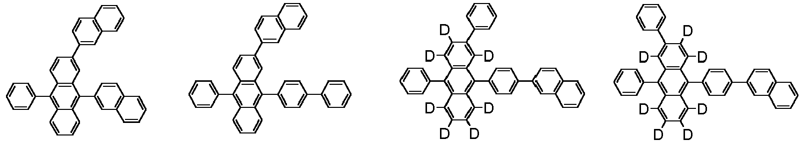

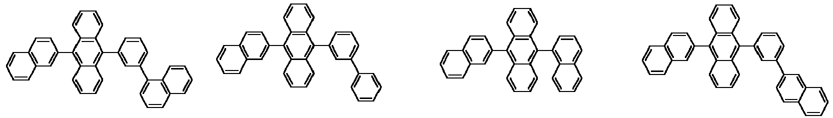

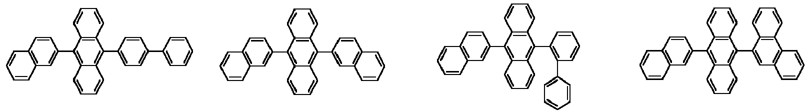

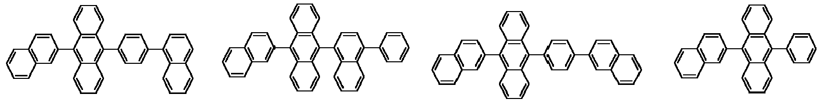

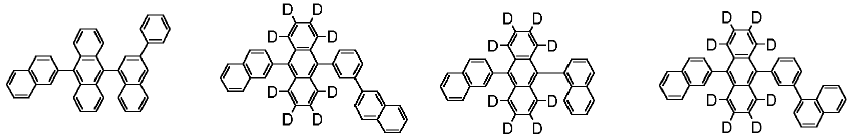

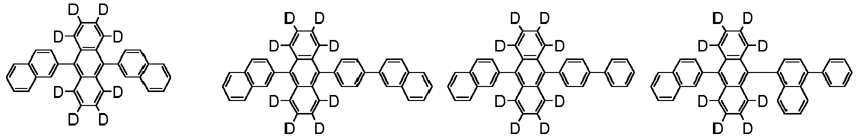

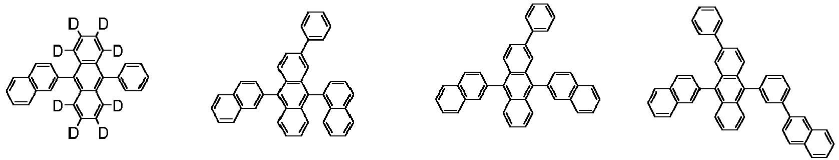

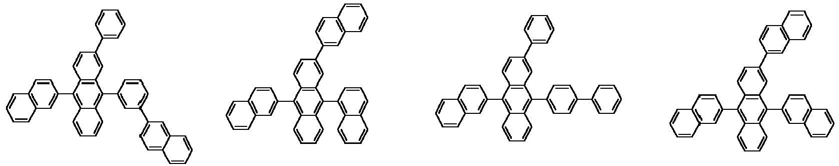

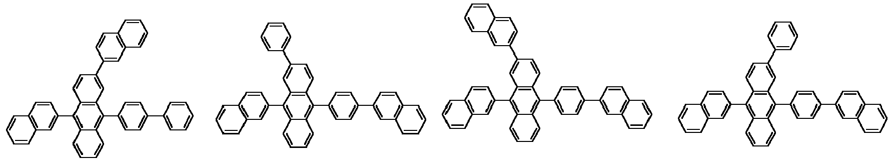

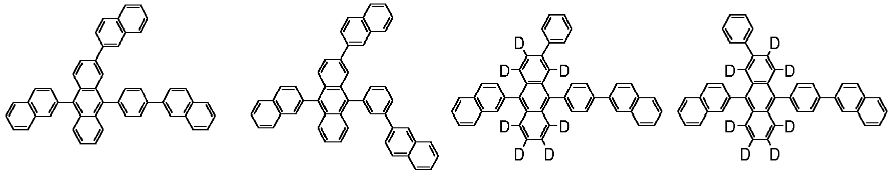

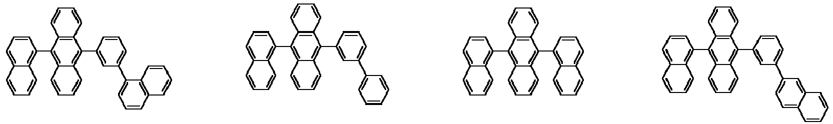

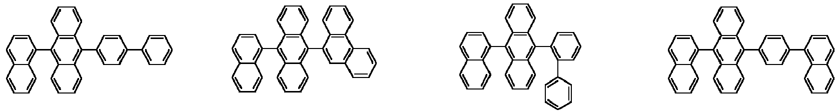

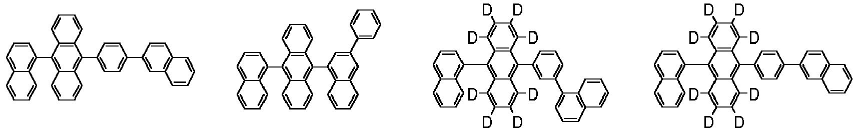

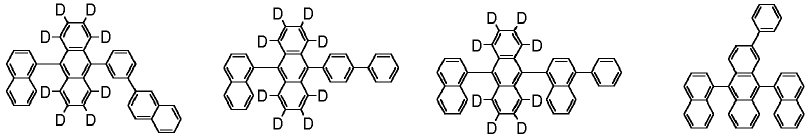

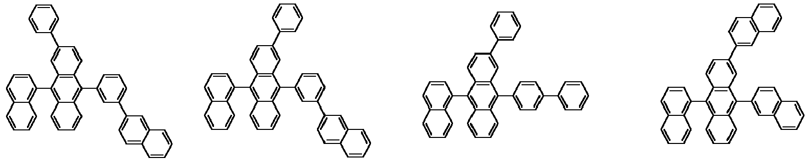

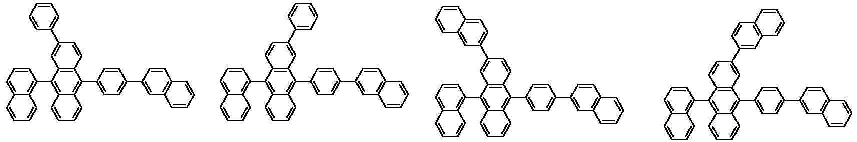

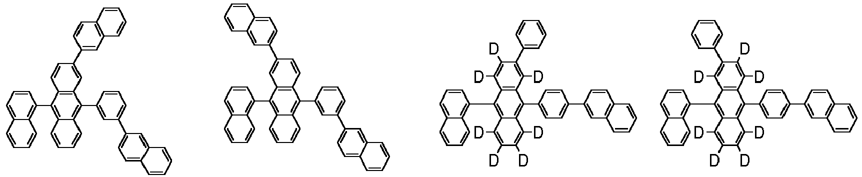

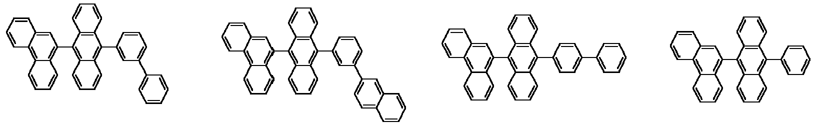

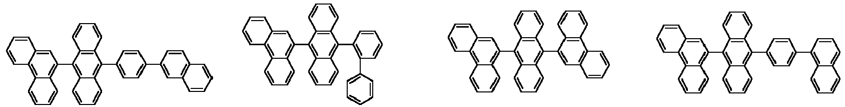

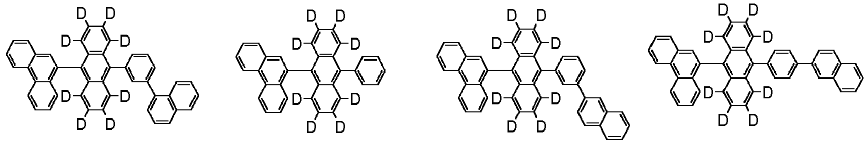

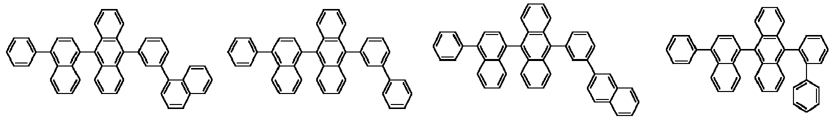

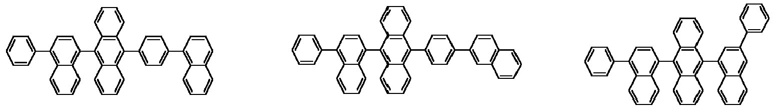

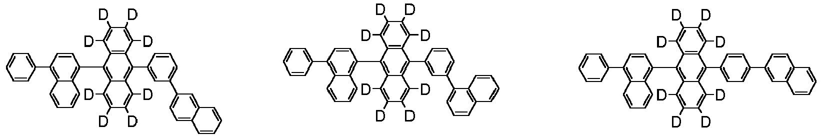

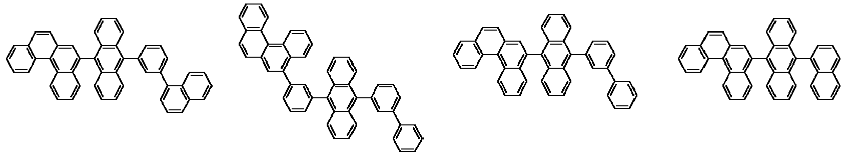

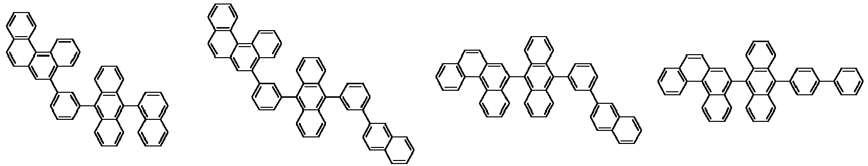

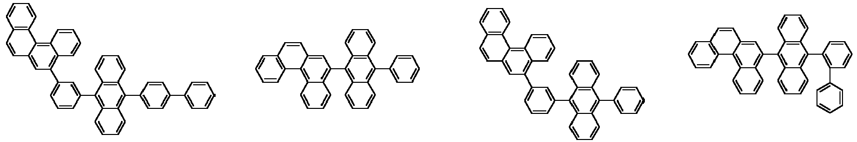

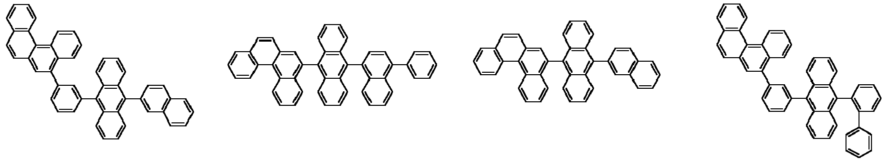

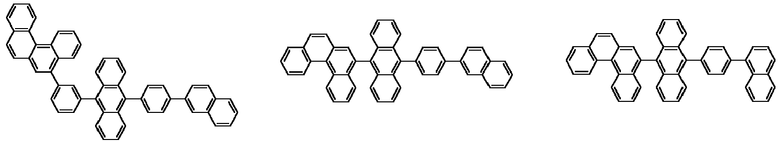

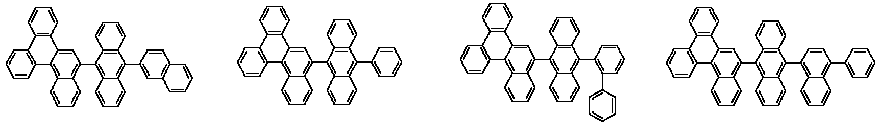

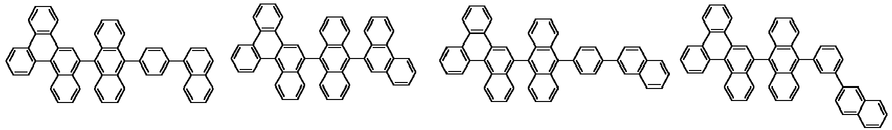

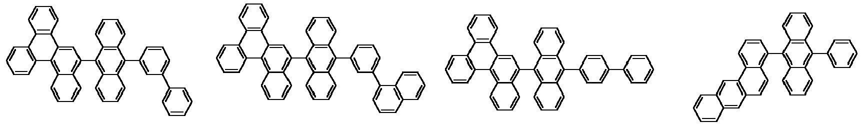

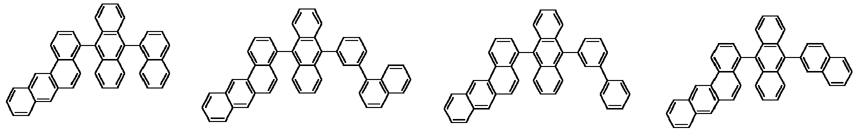

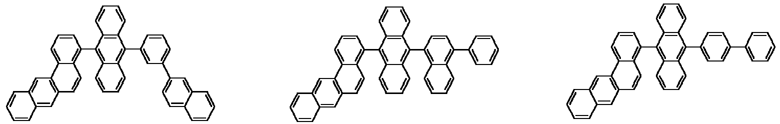

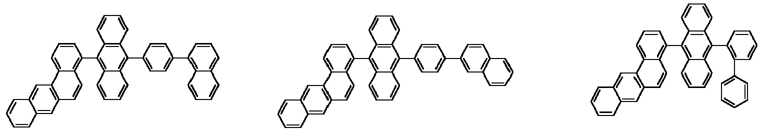

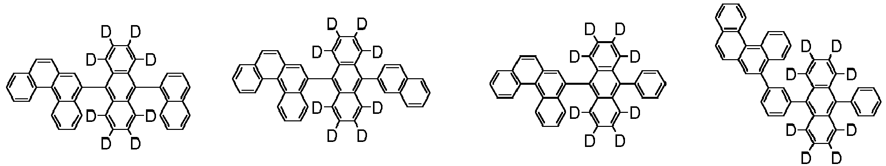

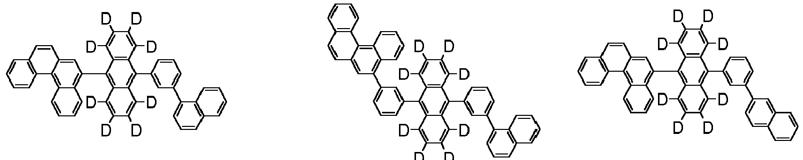

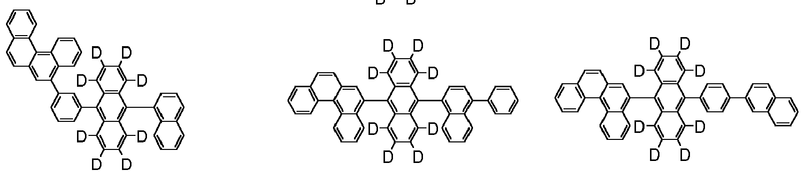

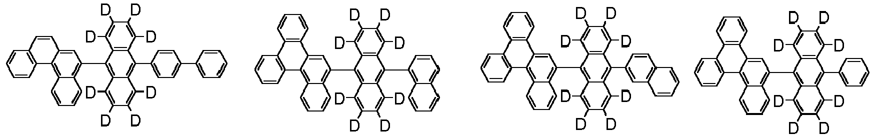

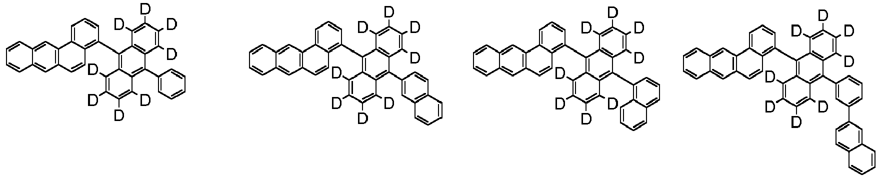

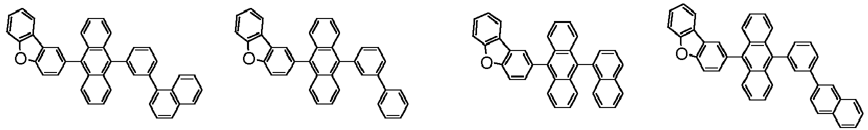

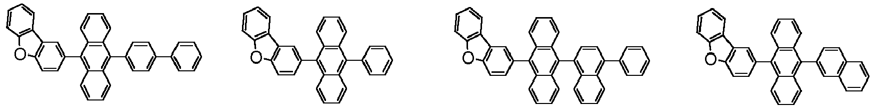

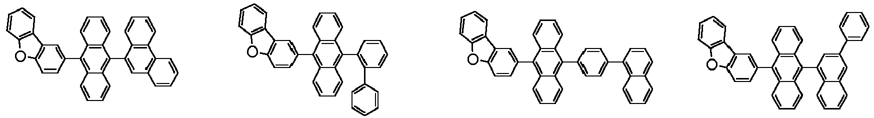

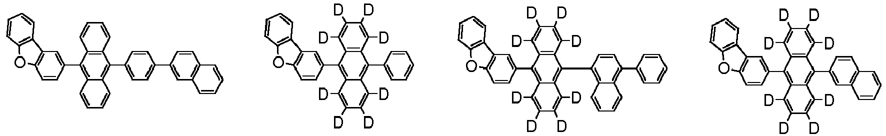

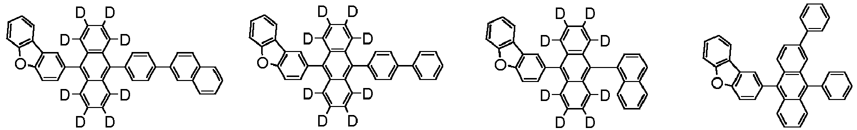

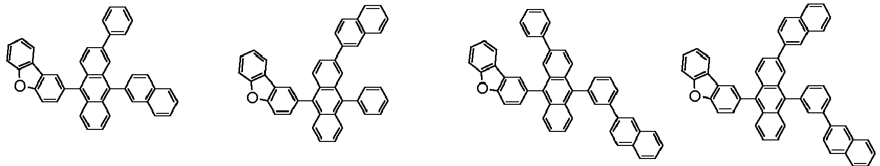

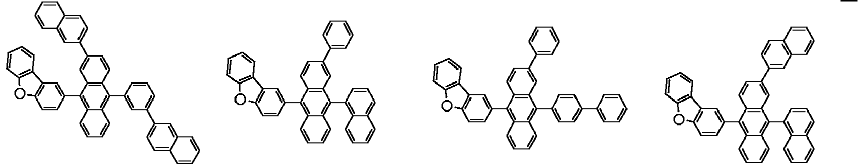

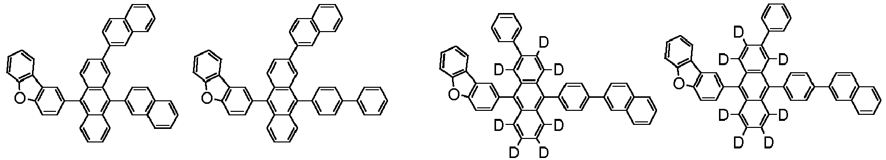

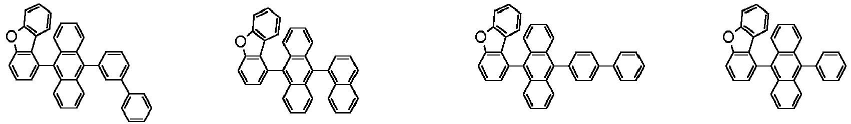

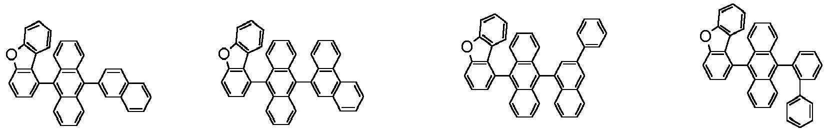

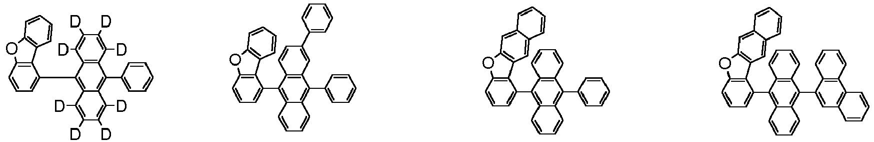

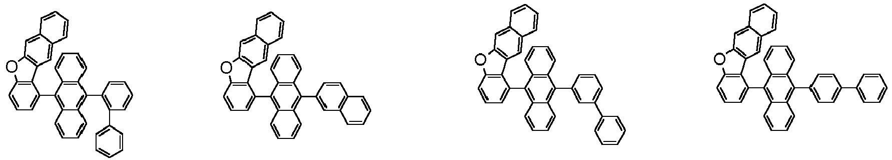

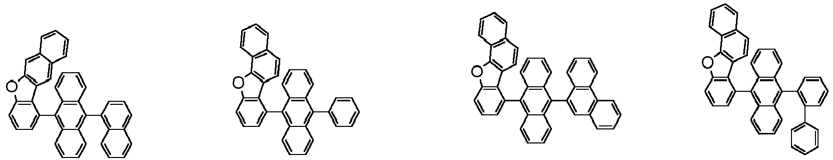

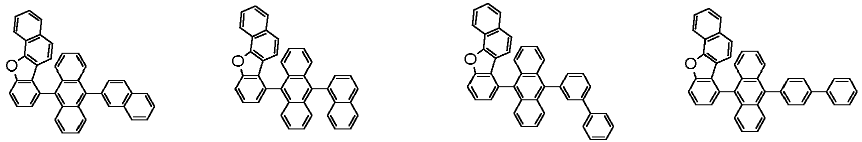

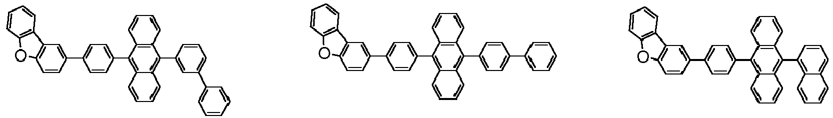

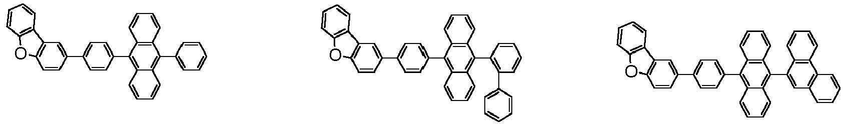

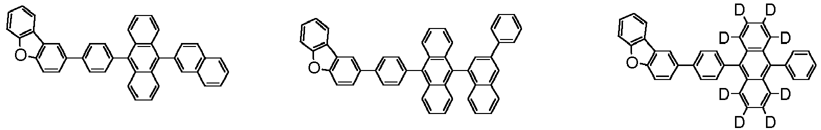

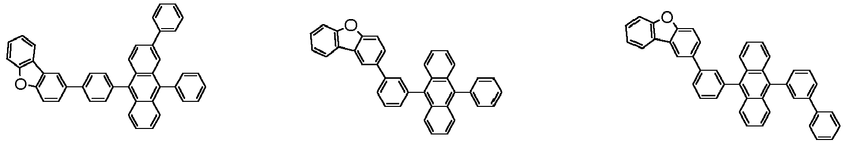

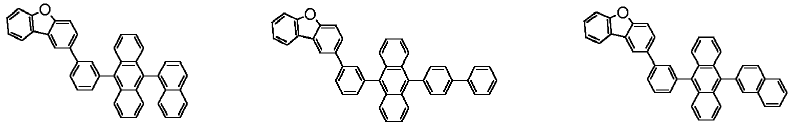

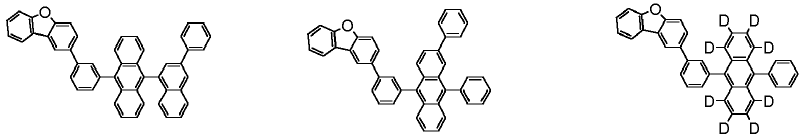

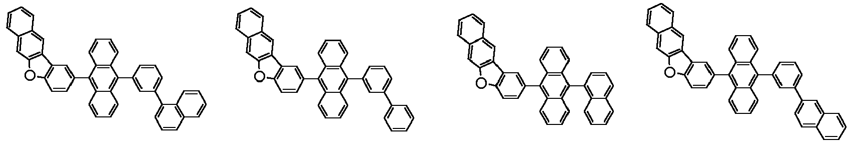

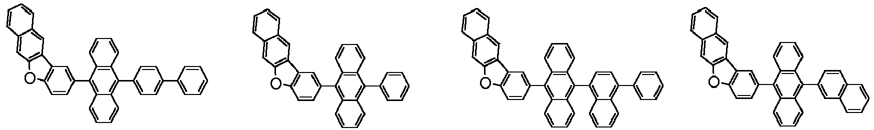

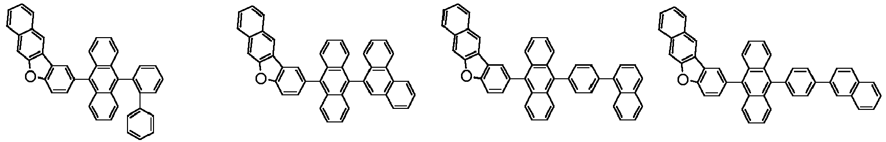

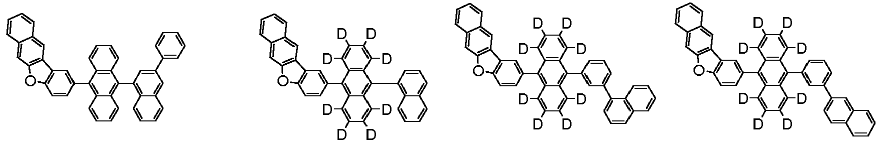

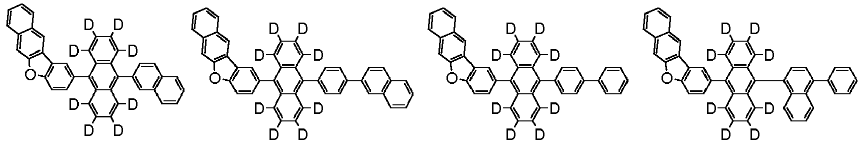

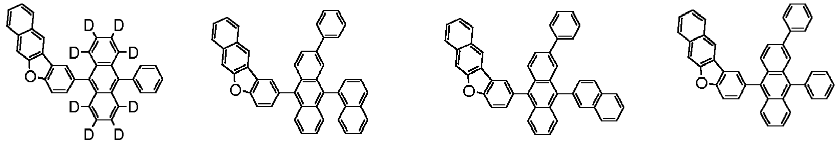

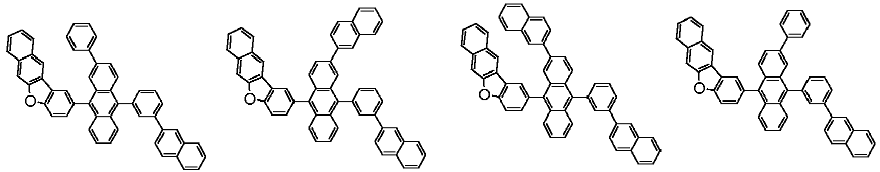

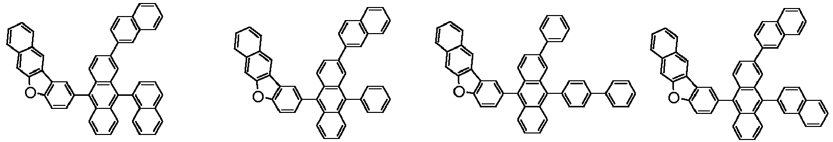

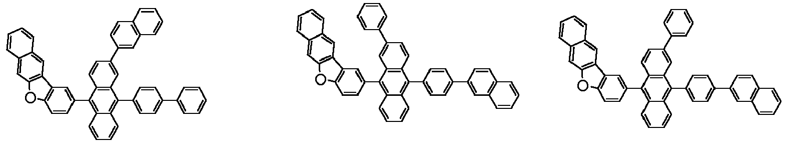

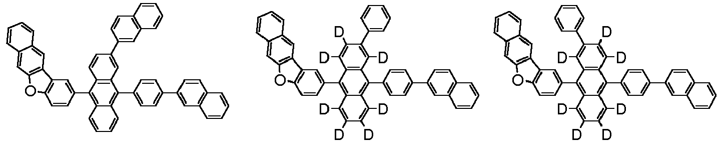

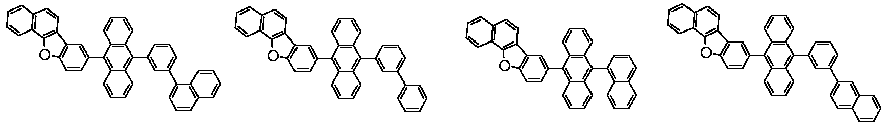

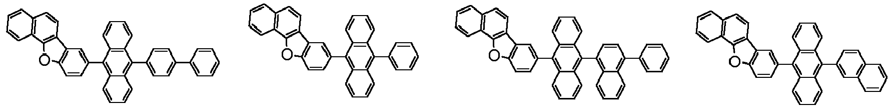

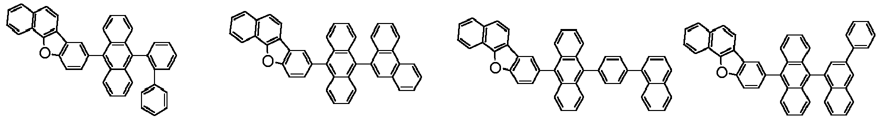

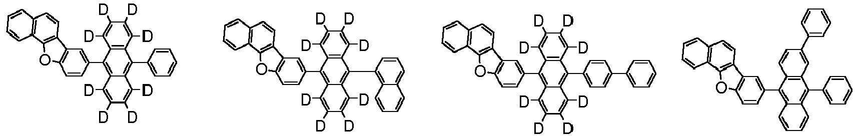

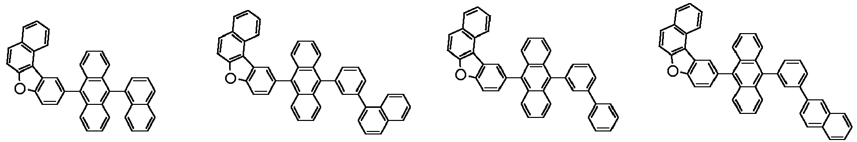

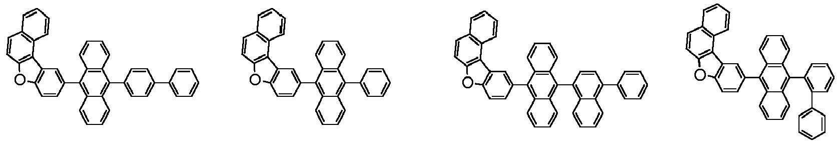

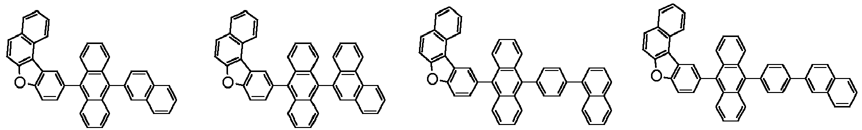

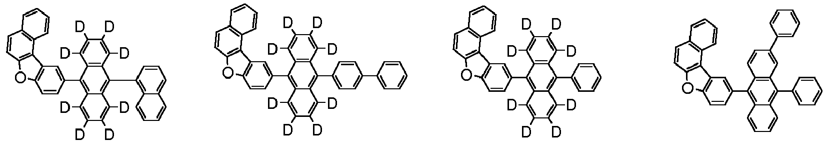

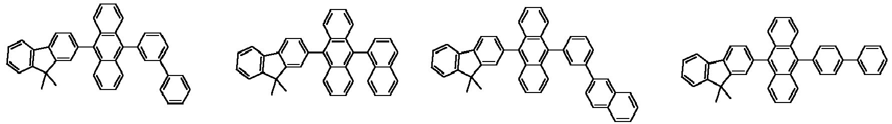

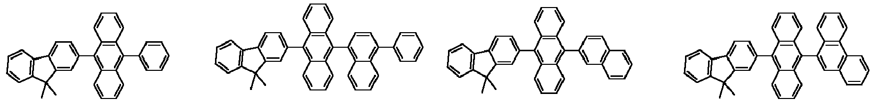

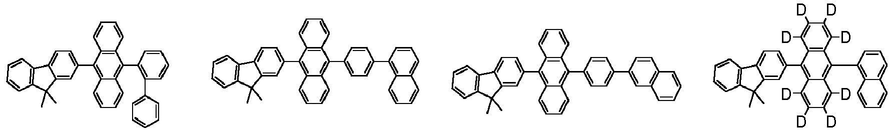

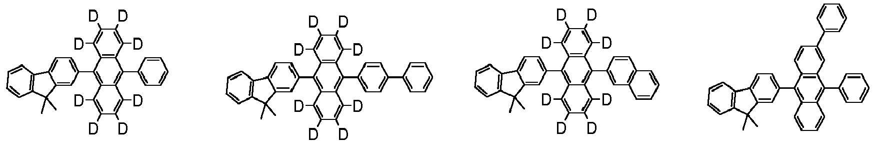

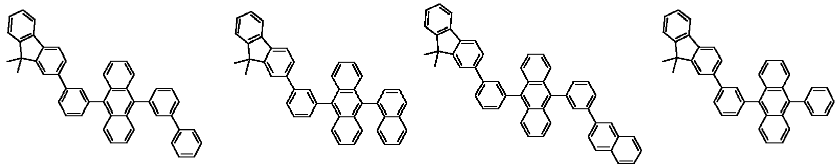

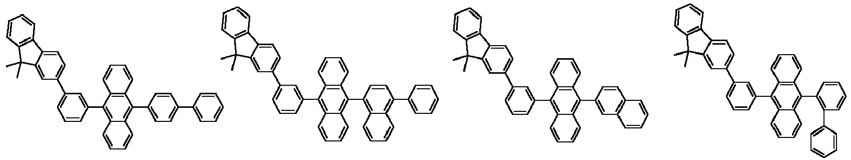

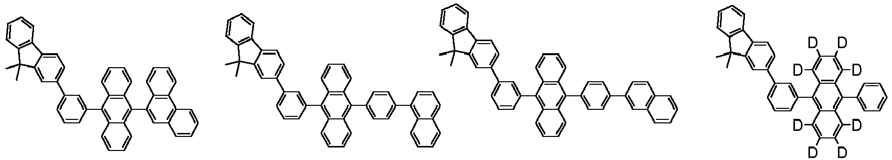

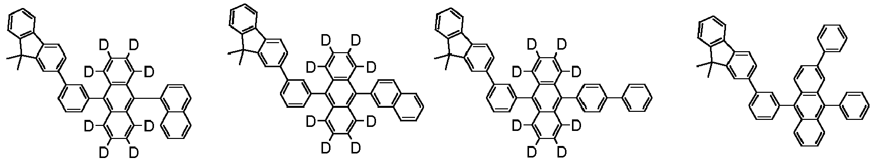

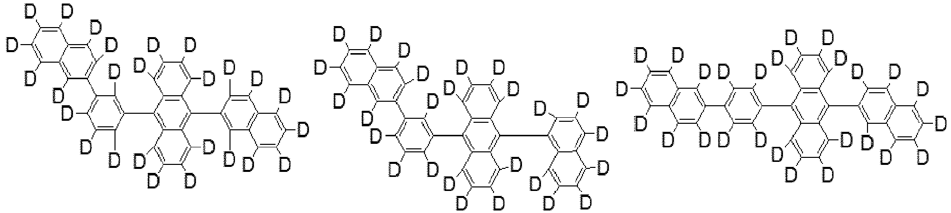

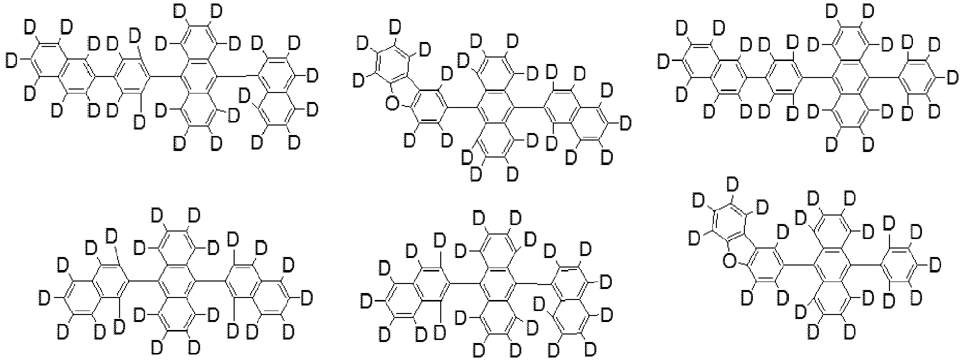

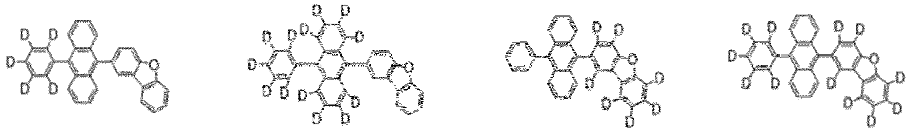

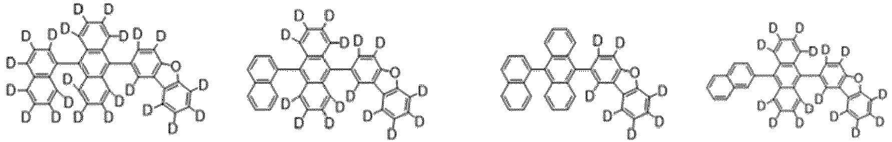

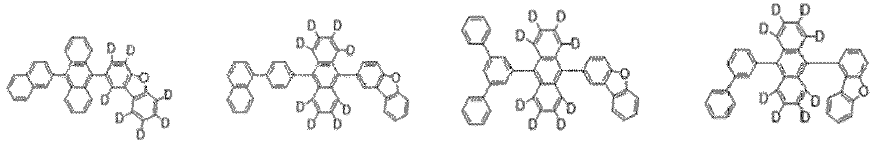

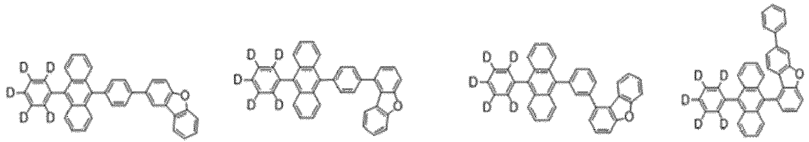

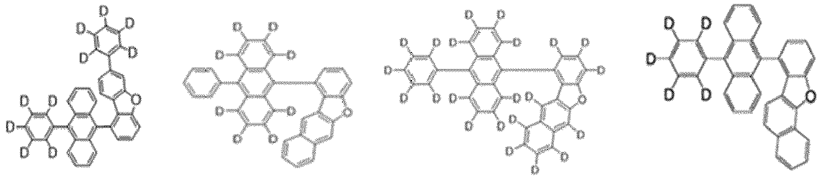

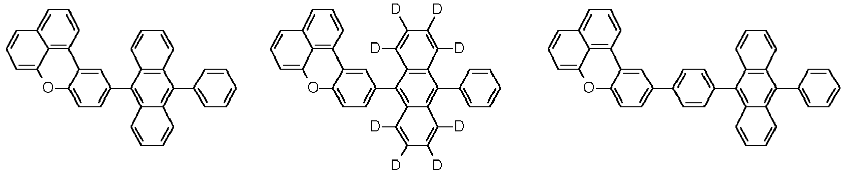

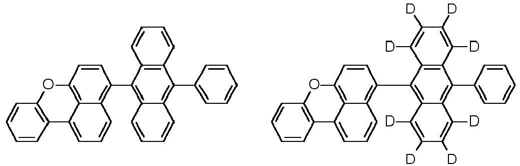

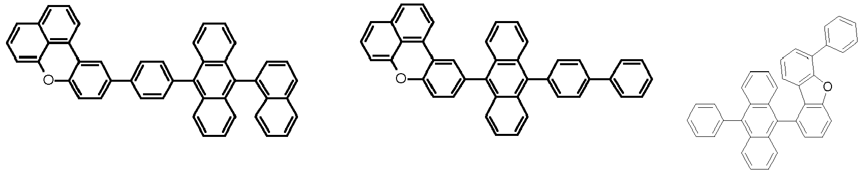

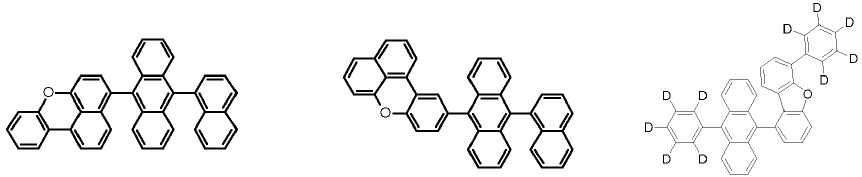

Preferred host compounds having a chrysene skeleton, a pyrene skeleton or a fluorene skeleton are described in US2021/0005826A1.

Examples are:

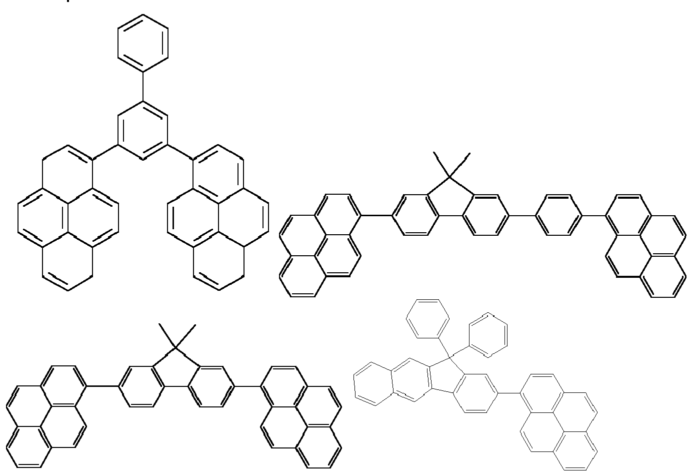

Preferred host compounds having a fluoranthene skeleton are described in US 2019/0280209 A1.

In the case that the emitting layer comprises the compound represented by formula (I) and at least one host, wherein preferred hosts are mentioned above, and the host is more preferably at least one compound represented by formula (10), the content of the at least one compound represented by formula (I) is preferably 0.5 mass% to 70 mass%, more preferably 0.5 to 30 mass%, further preferably 1 to 30 mass%, still further preferably 1 to 20 mass%, and particularly preferably 1 to 10 mass%, further particularly preferably 1 to 5 mass%, relative to the entire mass of the emitting layer.

The content of the at least one host, wherein preferred hosts are mentioned above, preferably the at least one compound represented by formula (10) is preferably 30 mass% to 99.5 mass%, more preferably 70 to 99.5 mass%, further preferably 70 to 99 mass%, still further preferably 80 to 99 mass%, and particularly preferably 90 to 99 mass%, further particularly preferably 95 to 99 mass %, relative to the entire mass of the emitting layer.

**An explanation will be made on the layer configuration of the organic EL device according to one aspect of the invention.**

An organic EL device according to one aspect of the invention comprises a cathode, an anode, and one or more organic thin film layers comprising an emitting layer disposed between the cathode and the anode. The organic layer comprises at least one layer composed of an organic compound. Alternatively, the organic layer is formed by laminating a plurality of layers composed of an organic compound. The organic layer may further comprise an inorganic compound in addition to the organic compound.

At least one of the organic layers is an emitting layer. The organic layer may be constituted, for example, as a single emitting layer, or may comprise other layers which can be adopted in the layer structure of the organic EL device. The layer that can be adopted in the layer structure of the organic EL device is not particularly limited, but examples thereof include a hole-transporting zone (comprising at least one hole-transporting layer and preferably in addition at least one of a hole-injecting layer, an electron-blocking layer, an exciton-blocking layer, etc.), an emitting layer, a spacing layer, and an electron-transporting zone (comprising at least one electron-transporting layer and preferably in addition at least one of an electron-injecting layer, a hole-blocking layer, etc.) provided between the cathode and the emitting layer.

The organic EL device according to one aspect of the invention may be, for example, a fluorescent or phosphorescent monochromatic light emitting device or a fluorescent/phosphorescent hybrid white light emitting device. Preferably, the organic EL device is a fluorescent monochromatic light emitting device, more preferably a blue fluorescent monochromatic light emitting device or a fluorescent/phosphorescent hybrid white light emitting device. Blue fluorescence means a fluorescence at 400 to 500 nm (peak maximum), preferably at 430 nm to 490 nm (peak maximum).

Further, it may be a simple type device having a single emitting unit or a tandem type device having a plurality of emitting units.

The "emitting unit" in the specification is the smallest unit that comprises organic layers, in which at least one of the organic layers is an emitting layer and light is emitted by recombination of injected holes and electrons.

In addition, the "emitting layer" described in the present specification is an organic layer having an emitting function. The emitting layer is, for example, a phosphorescent emitting layer, a fluorescent emitting layer or the like, preferably a fluorescent emitting layer, more preferably a blue fluorescent emitting layer, and may be a single layer or a stack of a plurality of layers.

The emitting unit may be a stacked type unit having a plurality of phosphorescent emitting layers or fluorescent emitting layers. In this case, for example, a spacing layer for preventing excitons generated in the phosphorescent emitting layer from diffusing into the fluorescent emitting layer may be provided between the respective light-emitting layers.

As the simple type organic EL device, a device configuration such as anode/emitting unit/cathode can be given.

Examples for representative layer structures of the emitting unit are shown below. The layers in parentheses are provided arbitrarily.
(a) (Hole-injecting layer/) Hole-transporting layer/Fluorescent emitting layer (/Electrontransporting layer/Electron-injecting layer)
(b) (Hole-injecting layer/) Hole-transporting layer/Phosphorescent emitting layer (/Electrontransporting layer/Electron-injecting layer)
(c) (Hole-injecting layer/) Hole-transporting layer/First fluorescent emitting layer/Second fluorescent emitting layer (/Electron-transporting layer/Electron-injecting layer)
(d) (Hole-injecting layer/) Hole-transporting layer/First phosphorescent layer/Second phosphorescent layer (/Electron-transporting layer/Electron-injecting layer)
(e) (Hole-injecting layer/) Hole-transporting layer/Phosphorescent emitting layer/Spacing layer /Fluorescent emitting layer (/Electron-transporting layer/Electron-injecting layer)
(f) (Hole-injecting layer/) Hole-transporting layer/First phosphorescent emitting layer/Second phosphorescent emitting layer/Spacing layer/Fluorescent emitting layer (/Electron-transporting layer/Electron-injecting layer)
(g) (Hole-injecting layer/) Hole-transporting layer/First phosphorescent layer/Spacing layer/ Second phosphorescent emitting layer/Spacing layer/Fluorescent emitting layer (/Electrontransporting layer / Electron-injecting layer)
(h) (Hole-injecting layer/) Hole-transporting layer/Phosphorescent emitting layer/Spacing layer/First fluorescent emitting layer/Second fluorescent emitting layer (/Electron-transporting Layer/Electron-injecting Layer)
(i) (Hole-injecting layer/) Hole-transporting layer/Electron-blocking layer/Fluorescent emitting layer (/Electron-transporting layer/Electron-injecting layer)
(j) (Hole-injecting layer/) Hole-transporting layer/Electron-blocking layer/Phosphorescent emitting layer (/Electron-transporting layer /Electron-injecting layer)
(k) (Hole-injecting layer/) Hole-transporting layer/Exciton-blocking layer/Fluorescent emitting layer (/Electron-transporting layer/Electron-injecting layer)
(l) (Hole-injecting layer/) Hole-transporting layer/Exciton-blocking layer/Phosphorescent emitting layer (/Electron-transporting layer/Electron-injecting layer)
(m) (Hole-injecting layer/) First hole-transporting Layer/Second hole-transporting Layer/ Fluorescent emitting layer (/Electron-transporting layer/electron-injecting Layer)
(n) (Hole-injecting layer/) First hole-transporting layer/Second hole-transporting layer/ Fluorescent emitting layer (/First electron-transporting layer/Second electron-transporting layer /Electron-injection layer)
(o) (Hole-injecting layer/) First hole-transporting layer /Second hole-transporting layer/Phosphorescent emitting layer (/Electron-transporting layer /Electron-injecting Layer)
(p) (Hole-injecting layer/) First hole-transporting layer/Second hole-transporting layer /Phosphorescent emitting layer (/First electron-transporting Layer/Second electron-transporting layer /Electron-injecting layer)
(q) (Hole-injecting layer/) Hole-transporting layer/Fluorescent emitting layer/Hole-blocking layer (/Electron-transporting layer/Electron-injecting layer)
(r) (Hole-injecting layer /) Hole-transporting layer/Phosphorescent emitting layer/ Hole-blocking layer (/ Electron-transport layer/ Electron-injecting layer)
(s) (Hole-injecting layer/) Hole-transporting layer/Fluorescent emitting layer /Exciton-blocking layer (/Electron-transporting layer/Electron-injecting layer)
(t) (Hole-injecting layer/) Hole-transporting layer/Phosphorescent emitting layer /Excitonblocking layer (/Electron-transporting layer/Electron-injecting layer)

The layer structure of the organic EL device according to one aspect of the invention is not limited to the examples mentioned above.

For example, when the organic EL device has a hole-injecting layer and a hole-transporting layer, it is preferred that a hole-injecting layer be provided between the hole-transporting layer and the anode. Further, when the organic EL device has an electron-injecting layer and an electron-transporting layer, it is preferred that an electron-injecting layer be provided between the electron-transporting layer and the cathode. Further, each of the hole-injecting layer, the hole-transporting layer, the electron-transporting layer and the electron-injecting layer may be formed of a single layer or be formed of a plurality of layers.

The plurality of phosphorescent emitting layer, and the plurality of the phosphorescent emitting layer and the fluorescent emitting layer may be emitting layers that emit mutually different colors. For example, the emitting unit (f) may include a hole-transporting layer/first phosphorescent layer (red light emission)/ second phosphorescent emitting layer (green light emission)/spacing layer/fluorescent emitting layer (blue light emission)/electron-transporting layer.

An electron-blocking layer may be provided between each light emitting layer and the hole-transporting layer or the spacing layer. Further, a hole-blocking layer may be provided between each emitting layer and the electron-transporting layer. By providing the electron-blocking layer or the hole-blocking layer, it is possible to confine electrons or holes in the emitting layer, thereby to improve the recombination probability of carriers in the emitting layer, and to improve light emitting efficiency.

As a representative device configuration of a tandem type organic EL device, for example, a device configuration such as anode/first emitting unit/intermediate layer/second emitting unit/cathode can be given.

The first emitting unit and the second emitting unit are independently selected from the above-mentioned emitting units, for example.

The intermediate layer is also generally referred to as an intermediate electrode, an intermediate conductive layer, a charge generating layer, an electron withdrawing layer, a connecting layer, a connector layer, or an intermediate insulating layer. The intermediate layer is a layer that supplies electrons to the first emitting unit and holes to the second emitting unit, and can be formed from known materials.

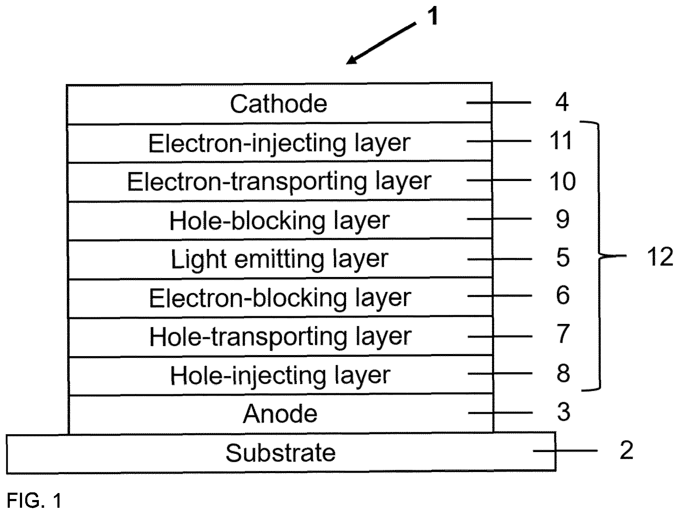

**FIG. 1** shows a schematic configuration of one example of the organic EL device of the invention. The organic EL device 1 comprises a substrate 2, an anode 3, a cathode 4 and an emitting unit 10 provided between the anode 3 and the cathode 4. The emitting unit 10 comprises an emitting layer 5 preferably comprising a host material and a dopant. A hole injecting and transporting layer 6 or the like may be provided between the emitting layer 5 and the anode 3 and an electron injecting layer 8 and an electron transporting layer 7 or the like (electron injecting and transporting unit 11) may be provided between the emitting layer 5 and the cathode 4. An electron-barrier layer may be provided on the anode 3 side of the emitting layer 5 and a hole-barrier layer may be provided on the cathode 4 side of the emitting layer 5. Due to such configuration, electrons or holes can be confined in the emitting layer 5, whereby possibility of generation of excitons in the emitting layer 5 can be improved.

**Hereinbelow, an explanation will be made on function, materials, etc. of each layer constituting the organic EL device described in the present specification.**

### (Substrate)

The substrate is used as a support of the organic EL device. The substrate preferably has a light transmittance of 50% or more in the visible light region with a wavelength of 400 to 700 nm, and a smooth substrate is preferable. Examples of the material of the substrate include sodalime glass, aluminosilicate glass, quartz glass, plastic and the like. As a substrate, a flexible substrate can be used. The flexible substrate means a substrate that can be bent (flexible), and examples thereof include a plastic substrate and the like. Specific examples of the material for forming the plastic substrate include polycarbonate, polyallylate, polyether sulfone, polypropylene, polyester, polyvinyl fluoride, polyvinyl chloride, polyimide, polyethylene naphthalate and the like. Also, an inorganic vapor deposited film can be used.

### (Anode)

As the anode, for example, it is preferable to use a metal, an alloy, a conductive compound, a mixture thereof or the like and having a high work function (specifically, 4.0 eV or more). Specific examples of the material of the anode include indium oxide-tin oxide (ITO: Indium Tin Oxide), indium oxide-tin oxide containing silicon or silicon oxide, indium oxide-zinc oxide, indium oxide containing tungsten oxide or zinc oxide, graphene and the like. In addition, it is also possible to use gold, silver, platinum, nickel, tungsten, chromium, molybdenum, iron, cobalt, copper, palladium, titanium, and nitrides of these metals (e.g. titanium oxide).

The anode is normally formed by depositing these materials on the substrate by a sputtering method. For example, indium oxide-zinc oxide can be formed by a sputtering method by using a target in which 1 to 10 mass% zinc oxide is added relative to indium oxide. Further, indium oxide containing tungsten oxide or zinc oxide can be formed by a sputtering method by using a target in which 0.5 to 5 mass% of tungsten oxide or 0.1 to 1 mass% of zinc oxide is added relative to indium oxide.

As other methods for forming the anode, a vacuum deposition method, a coating method, an inkjet method, a spin coating method or the like can be given. When silver paste or the like is used, it is possible to use a coating method, an inkjet method or the like.

The hole-injecting layer formed in contact with the anode is formed by using a material that allows easy hole injection regardless of the work function of the anode. For this reason, in the anode, it is possible to use a common electrode material, e.g. a metal, an alloy, a conductive compound and a mixture thereof. Specifically, a material having a small work function such as alkaline metals such as lithium and cesium; alkaline earth metals such as calcium and strontium; alloys containing these metals (for example, magnesium-silver and aluminumlithium); rare earth metals such as europium and ytterbium; and an alloy containing rare earth metals.

### (Hole-transporting layer) / (Hole-injecting layer)

The hole-transporting layer is an organic layer that is formed between the emitting layer and the anode, and has a function of transporting holes from the anode to the emitting layer. If the hole-transporting layer is composed of plural layers, an organic layer that is nearer to the anode may often be defined as the hole-injecting layer. The hole-injecting layer has a function of injecting holes efficiently to the organic layer unit from the anode. Said hole injection layer is generally used for stabilizing hole injection from anode to hole transporting layer which is generally consist of organic materials. Organic material having good contact with anode or organic material with p-type doping is preferably used for the hole injection layer.

p-doping usually consists of one or more p-dopant materials and one or more matrix materials. Matrix materials preferably have shallower HOMO level and p-dopant preferably have deeper LUMO level to enhance the carrier density of the layer. Specific examples for p-dopants are the below mentioned acceptor materials. Suitable matrix materials are the hole transport materials mentioned below, preferably aromatic or heterocyclic amine compounds.

Acceptor materials, or fused aromatic hydrocarbon materials or fused heterocycles which have high planarity, are preferably used as p-dopant materials for the hole injection layer. Specific examples for acceptor materials are, quinone compounds with one or more electron withdrawing groups, such as F₄TCNQ (2,3,5,6-tetrafluoro-7,7,8,8-tetracyanoquinodimethane), and 1,2,3-tris[(cyano)(4-cyano-2,3,5,6-tetrafluorophenyl)methylene]cyclopropane; hexaazatriphenylene compounds with one or more electron withdrawing groups, such as hexaazatriphenylene-hexanitrile; aromatic hydrocarbon compounds with one or more electron withdrawing groups; and aryl boron compounds with one or more electron withdrawing groups. Preferred p-dopants are quinone compounds with one or more electron withdrawing groups, such as F₄TCNQ, 1,2,3-Tris[(cyano)(4-cyano-2,3,5,6-tetrafluorophenyl)methylene]cyclopropane.

The ratio of the p-type dopant is preferably less than 20% of molar ratio, more preferably less than 10%, such as 1%, 3%, or 5%, related to the matrix material.

The hole transporting layer is generally used for injecting and transporting holes efficiently, and aromatic or heterocyclic amine compounds are preferably used.

Specific examples for compounds for the hole transporting layer are represented by the general formula (H), 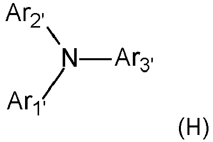 wherein
Ar_{1'} to Ar_{3'} each independently represents substituted or unsubstituted aryl group having 5 to 50 carbon atoms or substituted or unsubstituted heterocyclic group having 5 to 50 cyclic atoms, preferably phenyl group, biphenyl group, terphenyl group, naphthyl group, phenanthryl group, triphenylenyl group, fluorenyl group, spirobifluorenyl group, indenofluorenyl group, carbazolyl group, dibenzofuranyl group, dibenzothiophenyl group, carbazole substituted aryl group, dibenzofuran substituted aryl group or dibenzothiophene substituted aryl group; two or more substituents selected among Ar_{1'} to Ar_{3'} may be bonded to each other to form a ring structure, such as a carbazole ring structure, or a acridane ring structure.

Preferably, at least one of Ar_{1'} to Ar_{3'} have additional one aryl or heterocyclic amine substituent, more preferably Ar_{1'} has an additional aryl amino substituent, at the case of that it is preferable that Ar_{1'} represents substituted or unsubstituted biphenylene group, substituted or unsubstituted fluorenylene group. Specific examples for the hole transport material are 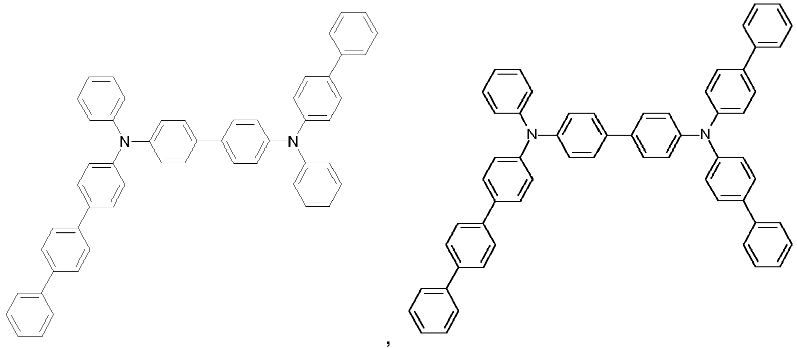 and 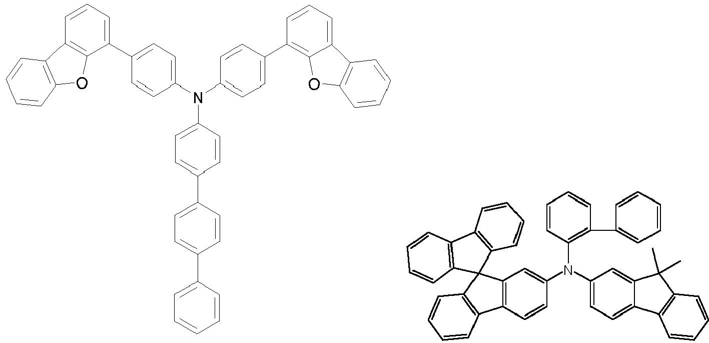 and the like.

A second hole transporting layer is preferably inserted between the first hole transporting layer and the emitting layer to enhance device performance by blocking excess electrons or excitons. Specific examples for second hole transporting layer are the same as for the first hole transporting layer. It is preferred that second hole transporting layer has higher triplet energy to block triplet excitons, especially for phosphorescent devices, such as bicarbazole compounds, biphenylamine compounds, triphenylenyl amine compounds, fluorenyl amine compounds, carbazole substituted arylamine compounds, dibenzofuran substituted arylamine compounds, and dibenzothiophene substituted arylamine compounds.

### (Emitting layer)

The emitting layer is a layer containing a substance having a high emitting property (emitter material or dopant material). As the dopant material, various materials can be used. For example, a fluorescent emitting compound (fluorescent dopant), a phosphorescent emitting compound (phosphorescent dopant) or the like can be used. A fluorescent emitting compound is a compound capable of emitting light from the singlet excited state, and an emitting layer containing a fluorescent emitting compound is called a fluorescent emitting layer. Further, a phosphorescent emitting compound is a compound capable of emitting light from the triplet excited state, and an emitting layer containing a phosphorescent emitting compound is called a phosphorescent emitting layer.

Preferably, the emitting layer in the organic EL device of the present application comprises a compound of formula (I) as a dopant material.

The emitting layer preferably comprises at least one dopant material and at least one host material that allows it to emit light efficiently. In some literatures, a dopant material is called a guest material, an emitter or an emitting material. In some literatures, a host material is called a matrix material.

A single emitting layer may comprise plural dopant materials and plural host materials. Further, plural emitting layers may be present.

In the present specification, a host material combined with the fluorescent dopant is referred to as a "fluorescent host" and a host material combined with the phosphorescent dopant is referred to as the "phosphorescent host". Note that the fluorescent host and the phosphorescent host are not classified only by the molecular structure. The phosphorescent host is a material for forming a phosphorescent emitting layer containing a phosphorescent dopant, but does not mean that it cannot be used as a material for forming a fluorescent emitting layer. The same can be applied to the fluorescent host.

In one embodiment, it is preferred that the emitting layer comprises the compound represented by formula (I) according to the present invention (hereinafter, these compounds may be referred to as the "compound (I)"). More preferably, it is contained as a dopant material. Further, it is preferred that the compound (I) be contained in the emitting layer as a fluorescent dopant. Even further, it is preferred that the compound (I) be contained in the emitting layer as a blue fluorescent dopant.

In one embodiment, no specific restrictions are imposed on the content of the compound (I) as the dopant material in the emitting layer. In respect of sufficient emission and concentration quenching, the content is preferably 0.5 to 70 mass%, more preferably 0.8 to 30 mass%, further preferably 1 to 30 mass%, still further preferably 1 to 20 mass%, and particularly preferably 1 to 10 mass%, further particularly preferably 1 to 5 mass%, even further particularly preferably 2 to 4 mass%, related to the mass of the emitting layer.

### (Fluorescent dopant)

As a fluorescent dopant other than the compound (I), a fused polycyclic aromatic compound, a styrylamine compound, a fused ring amine compound, a boron-containing compound, a pyrrole compound, an indole compound, a carbazole compound can be given, for example. Among these, a fused ring amine compound, a boron-containing compound, carbazole compound may be present. Preferably, no further dopant other than the compound of formula (I) is present in the inventive organic electroluminescence device.

As the fused ring amine compound, a diaminopyrene compound, a diaminochrysene compound, a diaminoanthracene compound, a diaminofluorene compound, a diaminofluorene compound with which one or more benzofuro skeletons are fused, or the like can be given.

As the boron-containing compound, a pyrromethene compound, a triphenylborane compound or the like can be given.

As a blue fluorescent dopant, pyrene compounds, styrylamine compounds, chrysene compounds, fluoranthene compounds, fluorene compounds, diamine compounds, triarylamine compounds and the like can be given, for example. Specifically, N,N'-bis[4-(9H-carbazol-9-yl)phenyl]-N,N'-diphenylstilbene-4,4'-diamine (abbreviation: YGA2S), 4-(9H-carbazol-9-yl)-4'-(10-phenyl-9-anthryl)triphenyamine (abbreviation: YGAPA), 4-(10-phenyl-9-anthryl)-4'-(9-phenyl-9H-carbazole-3-yl)triphenylamine (abbreviation: PCBAPA) or the like can be given.

As a green fluorescent dopant, an aromatic amine compound or the like can be given, for example. Specifically, N-(9,10-diphenyl-2-anthryl)-N,9-diphenyl-9H-carbazole-3-amine (abbreviation: 2PCAPA), N-[9,10-bis(1,1'-biphenyl-2-yl)-2-anthryl]-N,9-diphenyl-9H-carbazole-3-amine (abbreviation: 2PCABPhA), N-(9,10-diphenyl-2-anthryl)-N,N',N'-triphenyl-1,4-phenylenediamine (abbreviation: 2DPAPA), N-[9,10-bis(1,1'-biphenyl-2-yl)-2-anthryl]-N,N',N'-triphenyl-1,4-phenylenediamine (abbreviation: 2DPABPhA), N-[9,10-bis(1,1'-biphenyl-2-yl)]-N-[4-(9H-carbazole-9-yl)phenyl]-N-phenylanthracene-2-amine (abbreviation: 2YGABPhA), N,N,9-triphenylanthracene-9-amine (abbreviation: DPhAPhA) or the like can be given, for example.

As a red fluorescent dopant, a tetracene compound, a diamine compound or the like can be given. Specifically, N,N,N',N'-tetrakis(4-methylphenyl)tetracene-5,11-diamine (abbreviation: p-mPhTD), 7,14-diphenyl-N,N,N',N'-tetrakis(4-methylphenyl)acenaphtho[1,2-a]fluoranthene-3,10-diamine (abbreviation: p-mPhAFD) or the like can be given.

### (Phosphorescent dopant)

As a phosphorescent dopant, a phosphorescent emitting heavy metal complex and a phosphorescent emitting rare earth metal complex compound may be present. Preferably, no further dopant other than the compound of formula (I) is present in the inventive organic electroluminescence devic.

As the heavy metal complex, an iridium complex, an osmium complex, a platinum complex or the like can be given. The heavy metal complex is for example an ortho-metalated complex of a metal selected from iridium, osmium and platinum.

Examples of rare earth metal complexes include terbium complexes, europium complexes and the like. Specifically, tris(acetylacetonate)(monophenanthroline)terbium(III) (abbreviation: Tb(acac)₃(Phen)), tris(1,3-diphenyl-1,3-propandionate)(monophenanthroline)europium(III) (abbreviation: Eu(DBM)₃(Phen)), tris[1-(2-thenoyl)-3,3,3-trifluoroacetonate](monophenanthroline)europium(III) (abbreviation: Eu(TTA)₃(Phen)) or the like can be given. These rare earth metal complexes are preferable as phosphorescent dopants since rare earth metal ions emit light due to electronic transition between different multiplicity.

As a blue phosphorescent dopant, an iridium complex, an osmium complex, a platinum complex, or the like can be given, for example. Specifically, bis[2-(4',6'-difluorophenyl)pyridinate-N,C2']iridium(III) tetrakis(1-pyrazolyl)borate (abbreviation: Flr6), bis[2-(4',6'-difluorophenyl) pyridinato-N,C2']iridium(III) picolinate (abbreviation: Ir(CF₃ppy)₂(pic)), bis[2-(4',6'-difluorophenyl)pyridinato-N,C2']iridium(III) acetylacetonate (abbreviation: Flracac) or the like can be given.

As a green phosphorescent dopant, an iridium complex or the like can be given, for example. Specifically, tris(2-phenylpyridinato-N,C2') iridium(III) (abbreviation: Ir(ppy)₃), bis(1,2-diphenyl-1H-benzimidazolato)iridium(III) acetylacetonate (abbreviation: Ir(pbi)₂(acac)), bis(benzo[h]quinolinato)iridium(III) acetylacetonate (abbreviation: Ir(bzq)₂(acac)) or the like can be given.

As a red phosphorescent dopant, an iridium complex, a platinum complex, a terbium complex, a europium complex or the like can be given. Specifically, bis[2-(2'-benzo[4,5-α]thienyl)pyridinato-N,C3']iridium(III) acetylacetonate (abbreviation: Ir(btp)₂(acac)), bis(1-phenylisoquinolinato-N,C2')iridium(III) acetylacetonate (abbreviation: Ir(piq)₂(acac)), (acetylacetonato)bis[2,3-bis(4-fluorophenyl)quinoxalinato]iridium(III) (abbreviation: Ir(Fdpq)₂(acac)), 2,3,7,8,12,13,17,18-octaethyl-21H,23H-porphyrin platinum(II) (abbreviation PtOEP) or the like can be given.

As mentioned above, the emitting layer preferably comprises at least one compound (I) as a dopant.

### (Host material)

As host material, generally, the following materials are suitable: metal complexes such as aluminum complexes, beryllium complexes and zinc complexes; heterocyclic compounds such as indole compounds, pyridine compounds, pyrimidine compounds, triazine compounds, quinoline compounds, isoquinoline compounds, quinazoline compounds, dibenzofuran compounds, dibenzothiophene compounds, oxadiazole compounds, benzimidazole compounds, phenanthroline compounds; fused polyaromatic hydrocarbon (PAH) compounds such as a naphthalene compound, a triphenylene compound, a carbazole compound, an anthracene compound, a phenanthrene compound, a pyrene compound, a chrysene compound, a naphthacene compound, a fluoranthene compound; and aromatic amine compound such as triarylamine compounds and fused polycyclic aromatic amine compounds can be given, for example. Plural types of host materials can be used in combination.

As a fluorescent host, a compound having a higher singlet energy level than a fluorescent dopant is preferable. For example, a heterocyclic compound, a fused aromatic compound or the like can be given. As a fused aromatic compound, an anthracene compound, a pyrene compound, a chrysene compound, a naphthacene compound or the like are preferable. An anthracene compound is preferentially used as blue fluorescent host.

As a phosphorescent host, a compound having a higher triplet energy level as compared with a phosphorescent dopant is preferable. For example, a metal complex, or the like can be given.

Preferred host materials are substituted or unsubstituted polyaromatic hydrocarbon (PAH) compounds or substituted or unsubstituted polyheteroaromatic compounds. Preferred host materials are mentioned above. Most preferred are anthracene compounds represented by formula (10), as mentioned above.

### (Electron-transporting layer) / (Electron-injecting layer)

The electron-transporting layer is an organic layer that is formed between the emitting layer and the cathode and has a function of transporting electrons from the cathode to the emitting layer. When the electron-transporting layer is formed of plural layers, an organic layer or an inorganic layer that is nearer to the cathode is often defined as the electron injecting layer (see for example layer 8 in FIG. 1, wherein an electron injecting layer 8 and an electron transporting layer 7 form an electron injecting and transporting unit 11). The electron injecting layer has a function of injecting electrons from the cathode efficiently to the organic layer unit. Preferred electron injection materials are alkali metal, alkali metal compounds, alkali metal complexes, the alkaline earth metal complexes and the rare earth metal complexes.

According to one embodiment, it is preferred that the electron-transporting layer further comprises one or more layer(s) like a second electron-transporting layer, an electron injection layer to enhance efficiency and lifetime of the device, a hole blocking layer, an exciton blocking layer or a triplet blocking layer.

According to one embodiment, it is preferred that an electron-donating dopant be contained in the interfacial region between the cathode and the emitting unit. Due to such a configuration, the organic EL device can have an increased luminance or a long life. Here, the electron-donating dopant means one having a metal with a work function of 3.8 eV or less. As specific examples thereof, at least one selected from an alkali metal, an alkali metal complex, an alkali metal compound, an alkaline earth metal, an alkaline earth metal complex, an alkaline earth metal compound, a rare earth metal, a rare earth metal complex and a rare earth metal compound or the like can be mentioned.

As the alkali metal, Li (work function: 2.9 eV), Na (work function: 2.36 eV), K (work function: 2.28 eV), Rb (work function: 2.16 eV), Cs (work function: 1.95 eV) and the like can be given. One having a work function of 2.9 eV or less is particularly preferable. Among them, K, Rb and Cs are preferable. Rb or Cs is further preferable. Cs is most preferable. As the alkaline earth metal, Ca (work function: 2.9 eV), Sr (work function: 2.0 eV to 2.5 eV), Ba (work function: 2.52 eV) and the like can be given. One having a work function of 2.9 eV or less is particularly preferable. As the rare-earth metal, Sc, Y, Ce, Tb, Yb and the like can be given. One having a work function of 2.9 eV or less is particularly preferable.

Examples of the alkali metal compound include an alkali oxide such as Li₂O, Cs₂O or K₂O, and an alkali halide such as LiF, NaF, CsF and KF. Among them, LiF, Li₂O and NaF are preferable. Examples of the alkaline earth metal compound include BaO, SrO, CaO, and mixtures thereof such as BaₓSr₁₋ₓO (0<x<1) and BaₓCa₁₋ₓO (0<x<1). Among them, BaO, SrO and CaO are preferable. Examples of the rare earth metal compound include YbF₃, ScF₃, ScO₃, Y₂O₃, Ce₂O₃, GdF₃ and TbF₃. Among these, YbF₃, ScF₃ and TbF₃ are preferable.

The alkali metal complexes, the alkaline earth metal complexes and the rare earth metal complexes are not particularly limited as long as they contain, as a metal ion, at least one of alkali metal ions, alkaline earth metal ions, and rare earth metal ions. Meanwhile, preferred examples of the ligand include, but are not limited to, quinolinol, benzoquinolinol, acridinol, phenanthridinol, hydroxyphenyloxazole, hydroxyphenylthiazole, hydroxydiaryloxadiazole, hydroxydiarylthiadiazole, hydroxyphenylpyridine, hydroxyphenylbenzimidazole, hydroxybenzotriazole, hydroxyfluoroborane, bipyridyl, phenanthroline, phthalocyanine, porphyrin, cyclopentadiene, β-diketones, and azomethines.

Regarding the addition form of the electron-donating dopant, it is preferred that the electron-donating dopant be formed in a shape of a layer or an island in the interfacial region. A preferred method for the formation is a method in which an organic compound (a light emitting material or an electron-injecting material) for forming the interfacial region is deposited simultaneously with deposition of the electron-donating dopant by a resistant heating deposition method, thereby dispersing the electron-donating dopant in the organic compound.

In a case where the electron-donating dopant is formed into the shape of a layer, the light-emitting material or electron-injecting material which serves as an organic layer in the interface is formed into the shape of a layer. After that, a reductive dopant is solely deposited by the resistant heating deposition method to form a layer preferably having a thickness of from 0.1 nm to 15 nm. In a case where the electron-donating dopant is formed into the shape of an island, the emitting material or the electron-injecting material which serves as an organic layer in the interface is formed into the shape of an island. After that, the electron-donating dopant is solely deposited by the resistant heating deposition method to form an island preferably having a thickness of from 0.05 nm to 1 nm. As the electron-transporting material used in the electron-transporting layer other than a compound of the formula (I), an aromatic heterocyclic compound having one or more hetero atoms in the molecule may preferably be used. In particular, a nitrogen-containing heterocyclic compound is preferable.

According to one embodiment, it is preferable that the electron-transporting layer comprises a nitrogen-containing heterocyclic metal chelate.

According to the other embodiment, it is preferable that the electron-transporting layer comprises a substituted or unsubstituted nitrogen containing heterocyclic compound. Specific examples of preferred heterocyclic compounds for the electron-transporting layer are, 6-membered azine compounds; such as pyridine compounds, pyrimidine compounds, triazine compounds, pyrazine compounds, preferably pyrimidine compounds or triazine compounds; 6-membered fused azine compounds, such as quinolone compounds, isoquinoline compounds, quinoxaline compounds, quinazoline compounds, phenanthroline compounds, benzoquinoline compounds, benzoisoquinoline compounds, dibenzoquinoxaline compounds, preferably quinolone compounds, isoquinoline compounds, phenanthroline compounds; 5-membered heterocyclic compounds, such as imidazole compounds, oxazole compounds, oxadiazole compounds, triazole compounds, thiazole compounds, thiadiazole compounds; fused imidazole compounds, such as benzimidazole compounds, imidazopyridine compounds, naphthoimidazole compounds, benzimidazophenanthridine compounds, benzimidzobenzimidazole compounds, preferably benzimidazole compounds, imidazopyridine compounds or benzimidazophenanthridine compounds.

According to another embodiment, it is preferable the electron-transporting layer comprises a phosphine oxide compound represented as Arₚ₁Arₚ₂Ar_{P3}P=O.

Arₚ₁ to Arₚ₃ are the substituents of phosphor atom and each independently represent substituted or unsubstituted above mentioned aryl group or substituted or unsubstituted above mentioned heterocyclic group.

According to another embodiment, it is preferable that the electron-transporting layer comprises aromatic hydrocarbon compounds. Specific examples of preferred aromatic hydrocarbon compounds for the electron-transporting layer are, oligo-phenylene compounds, naphthalene compounds, fluorene compounds, fluoranthenyl group, anthracene compounds, phenanthrene compounds, pyrene compounds, triphenylene compounds, benzanthracene compounds, chrysene compounds, benzphenanthrene compounds, naphthacene compounds, and benzochrysene compounds, preferably anthracene compounds, pyrene compounds and fluoranthene compounds.

### (Cathode)

For the cathode, a metal, an alloy, an electrically conductive compound, and a mixture thereof, each having a small work function (specifically, a work function of 3.8 eV or less) are preferably used. Specific examples of a material for the cathode include an alkali metal such as lithium and cesium; an alkaline earth metal such as magnesium, calcium, and strontium; aluminum, an alloy containing these metals (for example, magnesium-silver, aluminum-lithium); a rare earth metal such as europium and ytterbium; and an alloy containing a rare earth metal.

The cathode is usually formed by a vacuum vapor deposition or a sputtering method. Further, in the case of using a silver paste or the like, a coating method, an inkjet method, or the like can be employed.

Moreover, various electrically conductive materials such as silver, ITO, graphene, indium oxidetin oxide containing silicon or silicon oxide, selected independently from the work function, can be used to form a cathode. These electrically conductive materials are made into films using a sputtering method, an inkjet method, a spin coating method, or the like.

### (Insulating layer)

In the organic EL device, pixel defects based on leakage or a short circuit are easily generated since an electric field is applied to a thin film. In order to prevent this, it is preferred to insert an insulating thin layer between a pair of electrodes. Examples of materials used in the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture thereof may be used in the insulating layer, and a laminate of a plurality of layers that include these materials can be also used for the insulating layer.

### (Spacing layer)

A spacing layer is a layer provided between a fluorescent emitting layer and a phosphorescent emitting layer when a fluorescent emitting layer and a phosphorescent emitting layer are stacked in order to prevent diffusion of excitons generated in the phosphorescent emitting layer to the fluorescent emitting layer or in order to adjust the carrier balance. Further, the spacing layer can be provided between the plural phosphorescent emitting layers.

Since the spacing layer is provided between the emitting layers, the material used for the spacing layer is preferably a material having both electron-transporting capability and hole-transporting capability. In order to prevent diffusion of the triplet energy in adjacent phosphorescent emitting layers, it is preferred that the spacing layer have a triplet energy of 2.6 eV or more. As the material used for the spacing layer, the same materials as those used in the above-mentioned hole-transporting layer can be given.

### (Electron-blocking layer, hole-blocking layer, exciton-blocking layer)

An electron-blocking layer, a hole-blocking layer, an exciton (triplet)-blocking layer, and the like may be provided in adjacent to the emitting layer.

The electron-blocking layer has a function of preventing leakage of electrons from the emitting layer to the hole-transporting layer. The hole-blocking layer has a function of preventing leakage of holes from the emitting layer to the electron-transporting layer. In order to improve hole blocking capability, a material having a deep HOMO level is preferably used. The exciton-blocking layer has a function of preventing diffusion of excitons generated in the emitting layer to the adjacent layers and confining the excitons within the emitting layer. In order to improve triplet block capability, a material having a high triplet level is preferably used.

### (Method for forming a layer)

The method for forming each layer of the organic EL device of the invention is not particularly limited unless otherwise specified. A known film-forming method such as a dry film-forming method, a wet film-forming method or the like can be used. Specific examples of the dry film-forming method include a vacuum deposition method, a sputtering method, a plasma method, an ion plating method, and the like. Specific examples of the wet film-forming method include various coating methods such as a spin coating method, a dipping method, a flow coating method, an inkjet method, and the like.

### (Film thickness)

The film thickness of each layer of the organic EL device of the invention is not particularly limited unless otherwise specified. If the film thickness is too small, defects such as pinholes are likely to occur to make it difficult to obtain a sufficient luminance. If the film thickness is too large, a high driving voltage is required to be applied, leading to a lowering in efficiency. In this respect, the film thickness is preferably 0.1 nm to 10 µm, and more preferably 5 nm to 0.2 µm.

### (Electronic apparatus (electronic equipment))

The present invention further relates to an electronic equipment (electronic apparatus) comprising the organic electroluminescence device according to the present application. Examples of the electronic apparatus include display parts such as an organic EL panel module; display devices of television sets, mobile phones, smart phones, and personal computer, and the like; and emitting devices of a lighting device and a vehicle lighting device.

### Examples

The following examples are included for illustrative purposes only and do not limit the scope of the claims. Unless otherwise stated, all parts and percentages are by weight.

The percentages and ratios mentioned in the examples below - unless stated otherwise - are % by weight and weight ratios.

### Synthesis Examples

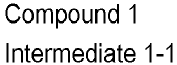

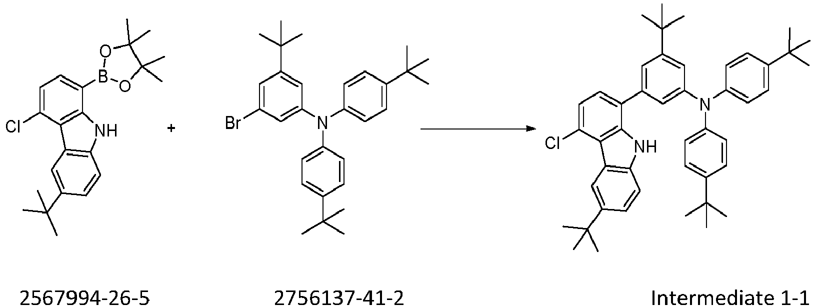

6.45 g (16.8 mmol) of 6-(tert-butyl)-4-chloro-1-(4,4,5,5-tetramethyl-1 ,3,2-dioxaborolan-2-yl)-9H-carbazole (CAS: 2567994-26-5), 6.90 g (14.0 mmol) of 3-bromo-5-(tert-butyl)-N,N-bis(4-(tert-butyl)phenyl)aniline (CAS: 2756137-41-2), 324 mg (2 mol%) of tetrakis(triphenylphosphine)-palladium(0), and 8.92 g (42.0 mmol) potassium phosphate were added to a previously degassed mixture of 125 mL toluene, 50 mL of tetrahydrofuran, and 25 mL of water. The reaction was then evacuated and backfilled with nitrogen three times, and the yellow emulsion was heated to 60 °C for 4 hours. The reaction was diluted with saturated ammonium chloride solution, extracted twice with toluene, and the organic extracts were combined and washed with brine. The organics were then dried over magnesium sulfate and evaporated to dryness. The residue was dissolved in dichloromethane, and ethanol was then added. The brown solution was concentrated until an off-white precipitated started to form. The suspension was then stirred at 35 °C for 1 hour and then filtered. The white solid was washed with cold ethanol to give 7.64 g of Intermediate 1-1 (81% yield).

LC-MS: 669.7 [M+H]⁺

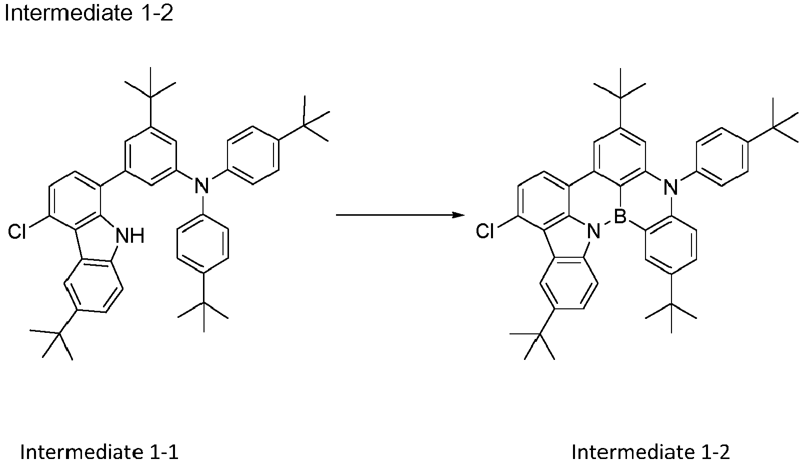

7.60 g (11.35 mmol) of Intermediate 1-1 was dissolved in 670 mL dry, degassed tert-butylbenzene, and to this was added 5.00 mL (12.5 mmol) of n-butyllithium (2.5M solution in hexanes) dropwise. After stirring at room temperature for 1 hour, the yellow solution was cooled to 0 °C and 2.15 mL (21.7 mmol) of boron tribromide was added. The yellow greenish reaction mixture was then heated to 155 °C for 18 hours. The reaction was then cooled to room temperature, quenched with saturated sodium hydrogencarbonate, and extracted with ethyl acetate. The organic phase was washed with brine, dried over magnesium sulfate, and evaporated to dryness. The crude product was purified by silica-gel column chromatography using a gradient of 1-3% ethyl acetate in heptane as eluent. The product was further purified by precipitation from heptane/ethanol, followed by dichloromethane/acetonitrile to give 3.70 g of Intermediate 1-2 as a bright yellow solid (48% yield).

LC-MS: 677.8 [M+H]⁺

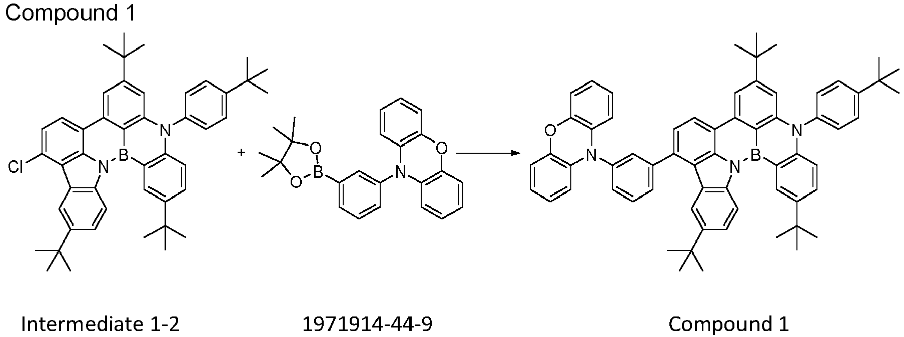

1.20 g (1.77 mmol) of Intermediate 1-2, 1.36 g (3.54 mmol) of 10-(3-(4,4,5,5-tetramethyl-1,3,2-dioxaborolan-2-yl)phenyl)-10H-phenoxazine (CAS: 1971914-44-9), 1.16 g (3.54 mmol) of cesium carbonate, 37 mg (5 mol%) of dicyclohexyl(2',6'-dimethoxy-[1,1'-biphenyl]-2-yl)phosphane, and 10 mg (2.5 mol%) of palladium(II) acetate were added to a previously degassed mixture of 54 mL toluene, 18 mL of ethanol, and 9 mL of water. The reaction was then evacuated and backfilled with nitrogen three times, and heated to 70 °C for 1 hour. The reaction was then cooled to room temperature, diluted with water and extracted with ethyl acetate. The organic extracts were then washed with brine, dried over magnesium sulfate, and evaporated to dryness. The crude product was purified by silica-gel column chromatography using a gradient of 0-30% dichloromethane in heptane as eluent to give 1.2 g of Compound 1 as a yellow solid (75% yield).

LC-MS: 900.8 [M+H]⁺

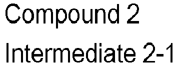

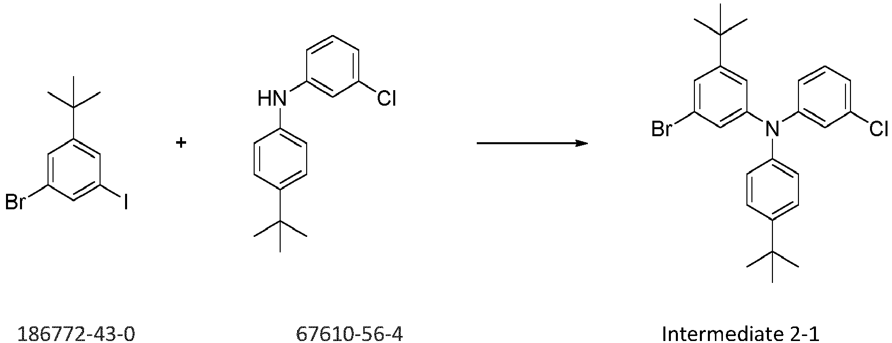

2.00 g (5.90 mmol) of 1-Bromo-3-(1,1-dimethylethyl)-5-iodobenzene (CAS: 186772-43-0), 1.38 g (5.31 mmol) of (3-Chloro-*N*-[4-(1,1-dimethylethyl)phenyl]benzenamine (CAS: 67610-56-4), 612 mg (6.37 mmol) of sodium tert-butoxide, 123 mg (4 mol%) of xantphos and 49 mg (1 mol%) of tris(dibenzylideneacetone)dipalladium(0) were added to 54 mL of previously degassed toluene. The reaction was then evacuated and backfilled with nitrogen three times, and heated to 100 °C for 16 hours. The reaction was then cooled to room temperature, diluted with water and extracted with toluene. The reaction was cooled to room temperature and diluted with toluene and water. The aqueous layer was extracted with toluene. The organic extracts were then washed with brine, dried over magnesium sulfate, and evaporated to dryness. The crude product was purified by silica-gel column chromatography using cyclohexane as eluent to give 1.98 g of Intermediate 2-1 as a white foam (79% yield).

LC-MS: 471.9 [M+H]⁺

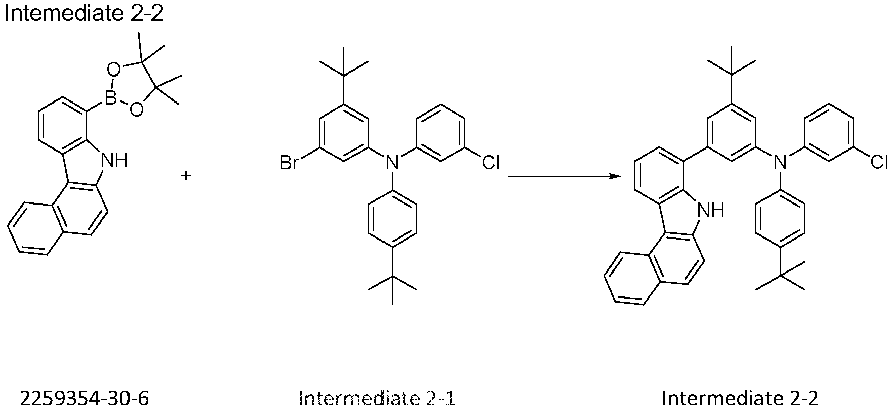

The procedure for the synthesis of Intermediate 1-1 was repeated except for using 1.66 g (4.84 mmol) of 8-(4,4,5,5-Tetramethyl-1,3,2-dioxaborolan-2-yl)-7H-benzo[c]carbazole (CAS: 2259354-30-6) and 1.90 g (4.03 mmol) of Intermediate 2-1 instead. 1.83 g of Intermediate 2-2 was obtained as an off-white solid (75% yield).

LC-MS: 607.5 [M+H]⁺

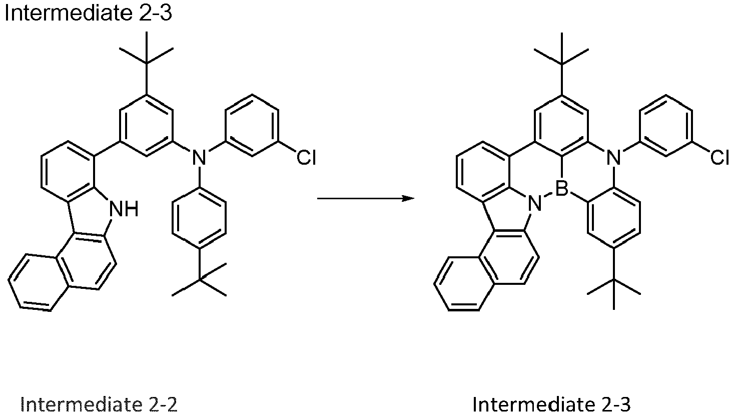

The procedure for Intermediate 1-2 was repeated except for using 1.00 g (1.64 mmol) of Intermediate 2-2. 0.55g of Intermediate 2-3 was obtained as a bright yellow solid (54% yield). LC-MS: 616.4 [M+H]⁺

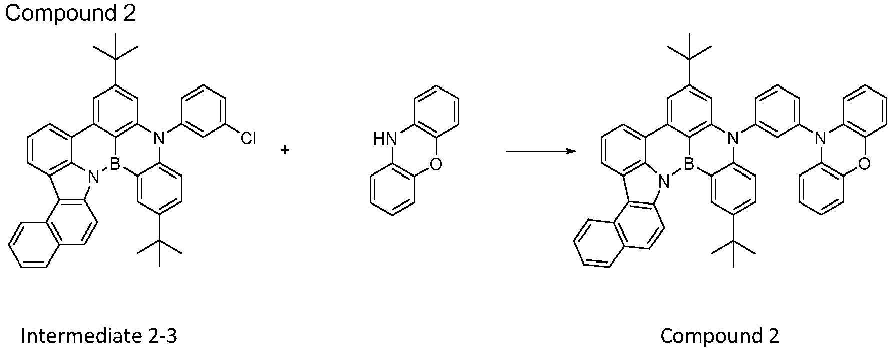

100 mg (0.163 mmol) of Intermediate 2-3, 32 mg (0.179 mmol) of phenoxazine, 3.0 mg (2 mol%) of tris(dibenzylideneacetone)dipalladium(0), and 6.2 mg (8 mol%) of 2-Dicyclohexylphosphino-2',4',6'-triisopropylbiphenyl were added to 3 mL of previously degassed toluene. The reaction was then evacuated and backfilled with nitrogen three times, and heated to 50 °C, before 0.35 mL (0.35 mmol) of lithium bis(trimethylsilyl)amide (1M solution in toluene) was added, and the reaction heated to 60 °C. After 3h, the reaction was cooled to room temperature and quenched with saturated ammonium chloride solution, and extracted with toluene. The crude product was purified by silica-gel column chromatography using a gradient of 0-30% dichloromethane in heptane as eluent to give 36 mg of Compound 2 as a yellow solid (29% yield).

LC-MS: 762.4 [M+H]⁺

### Comparative Compound 1

Prepared according to the procedure outlined in WO2021255698A1 for Compound 20.

### Application Examples

Fluorescence is measured in toluene solution at a concentration below 5 x 10⁻⁶ M. The photoluminescence quantum yield is measured with an integrating sphere (Hamamatsu Quantaurus-QY Absolute PL Quantum Yield Spectrometer C11347) at a temperature of 295K.

The ionization potential is measured with cyclic voltammetry in dimethylformamide, using the formula: 1.4 X (E_{sample oxidation onset} - Eferrocene oxidation onset) + 4.6 eV, according to Org. Electron. 2005, 6, 11-20. Attaching Ar₁Ar₂N leads to lower ionization potential, corroborating the computational results.

FWHM - (Full width at half maximum) is a measurement of the width of the fluorescence spectrum being generated at half its amplitude and is determined as shown in the example below:

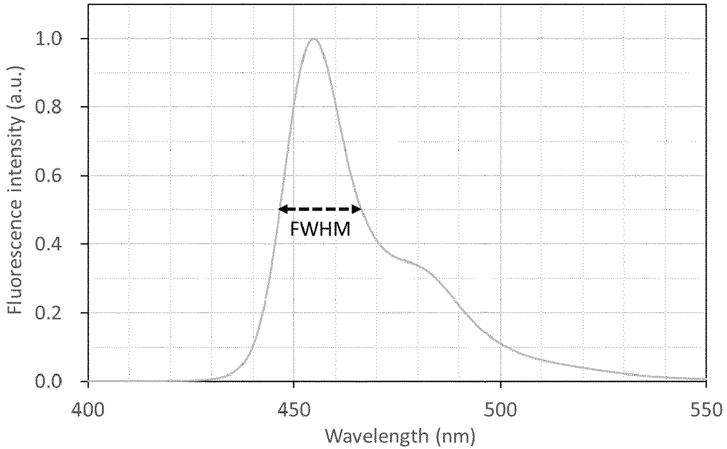

Molecular orbitals and excited state transitions are computed with the Gaussian 16 software, B3LYP functional and 6-31 g(d) basis set at the optimized ground state geometry in vacuum. Contribution of an orbital pair (HOMO→LUMO or HOMO-1→LUMO) to a transition (S₁ or S₂) is derived from the square of the coefficient multiplied by two, as in Angew. Chem. Int. Ed. 2019, 58, 16912 - 16917 and Chem. Sci. 2022, 13, 5622 - 5630.

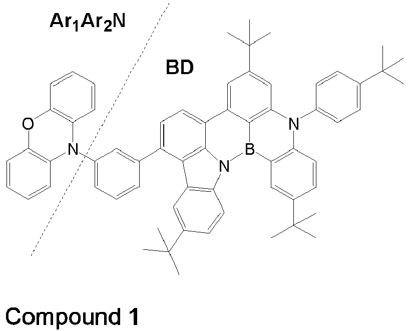

**Table 1: DFT and TD-DFT computation data of Compound 1**

| | **Ar₁Ar₂N** | **BD** |
|---|---|---|
| Molecular orbital (MO) | HOMO (4.54 eV) with 80% electron density | HOMO-1 (4.94 eV) with 98% electron density |
| | 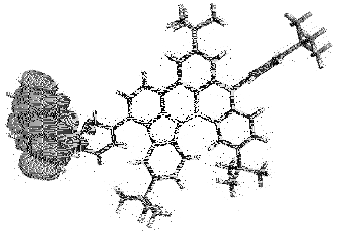 | 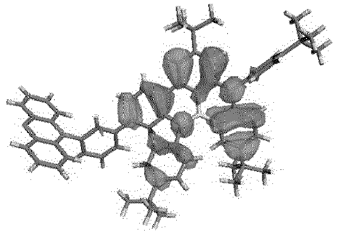 |
| | | LUMO with 96% electron density |
| | | 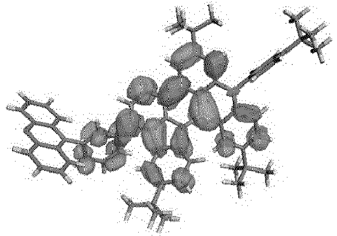 |
| Singlet excited state | S₁ with oscillator strength f = 0.0063, with 95% contribution from HOMO→LUMO (coefficient 0.69069) | S₂ with oscillator strength f = 0.4169, with 97% contribution from HOMO-1→LUMO (coefficient 0.69488) |

**Table 2: Physical data of Compound 1 measured in organic solvents**

| | Fluorescence peak (nm) | Fluorescence FWHM (nm) | Photoluminescence quantum yield (%) | Ionization potential (eV) |
|---|---|---|---|---|
| **Compound 1** | 446 | 23 | 97 | 5.03 |

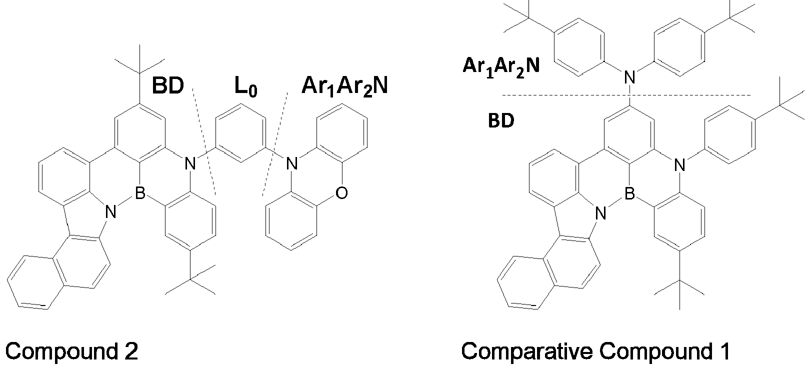

**Table 3: DFT and TD-DFT computation data of Compound 2**

| | **Ar₁Ar₂N-L₀** | **BD** |
|---|---|---|
| Molecular orbital (MO) | HOMO (4.77 eV) with 85% electron density | HOMO-1 (5.05 eV) with 84% electron density |
| | 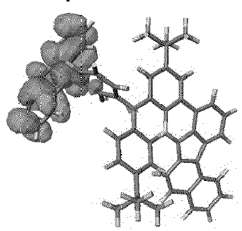 | 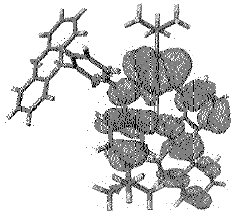 |
| | | LUMO with 94% electron density |
| | | 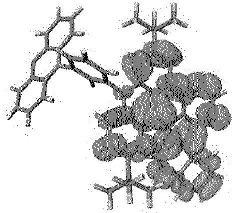 |
| Singlet excited state | S₁ with oscillator strength f = 0.0234, with 97% contribution from HOMO→LUMO (coefficient 0.69702) | S₃ with oscillator strength f = 0.3145, with 93% contribution from HOMO-1→LUMO (coefficient 0.68052) |

**Table 4: DFT and TD-DFT computation data of Comparative Compound 1**

| | **Ar₁Ar₂N** | **BD** |
|---|---|---|
| Molecular orbital (MO) | 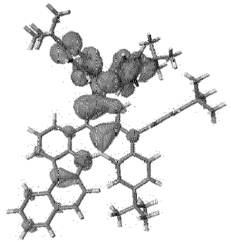 HOMO (4.86 eV) with 53% electron density | HOMO-1 (4.93 eV) with 77% electron density |
| | | 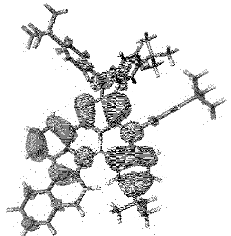 |
| | | LUMO with 85% electron density |
| | | 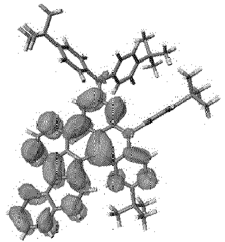 |
| Singlet excited state | S₁ with oscillator strength f = 0.2737, with 96% contribution from HOMO→LUMO (coefficient 0.69256) | S₂ with oscillator strength f = 0.1874, with 94% contribution from HOMO-1→LUMO coefficient 0.68390 |

**Table 5: Physical data of Compound 2 and Comparative Compound 1 measured in organic solvents**

| | Fluorescence peak (nm) | Fluorescence FWHM (nm) | Photoluminescence quantum yield (%) | Ionization potential (eV) |
|---|---|---|---|---|
| **Compound 2** | 441 | 18 | 92 | 5.09 |
| **Comparative Compound 1** | 442 | 16 | 67 | 5.28 |

When Ar₁Ar₂N and BD are not connected via designated L and the computed parameters are not fulfilled, as in **Comparative Compound 1,** interaction between Ar₁Ar₂N and BD leads to deteriorated fluorescence properties.

### Device Data

### Application Example

A glass substrate with 130 nm-thick indium-tin-oxide (ITO) transparent electrode (manufactured by Geomatec Co., Ltd.) used as an anode was first treated with N2 plasma for 100 sec. This treatment also improved the hole-injection properties of the ITO. The cleaned substrate was mounted on a substrate holder and loaded into a vacuum chamber. Thereafter, the organic materials specified below were applied by vapor deposition to the ITO substrate at a rate of approx. 0.02-1 Å/sec at about 10⁻⁶-10⁻⁸ mbar. As a hole-injection layer, 10 nm-thick mixture of Compound HT-1 and 3% by weight of Compound HI were applied. Then 80 nm-thick of Compound HT-1 and 10 nm of Compound HT-2 were applied as hole-transporting layer and electron-blocking layer, respectively. Subsequently, a mixture of BH:**BD** (according to table 6) was applied to form a 25 nm-thick fluorescent-emitting layer (EL layer). On the emitting layer, 10 nm-thick Compound ET-1 was applied as an hole-blocking layer and 15 nm of Compound ET-2 as electron transporting layer. Finally, 1 nm LiF was deposited and 50 nm-thick Al was then deposited as a cathode to complete the device. The device was sealed with a glass lid and a getter in an inert nitrogen atmosphere with less than 1 ppm of water and oxygen. To characterize the OLED, electroluminescence spectra were recorded at various currents and voltages. In addition, the current-voltage characteristic was measured in combination with the luminance to determine luminous efficiency and external quantum efficiency (EQE). Voltage and efficiency are reported at 10 mA/cm². The device results are shown in Table 6.

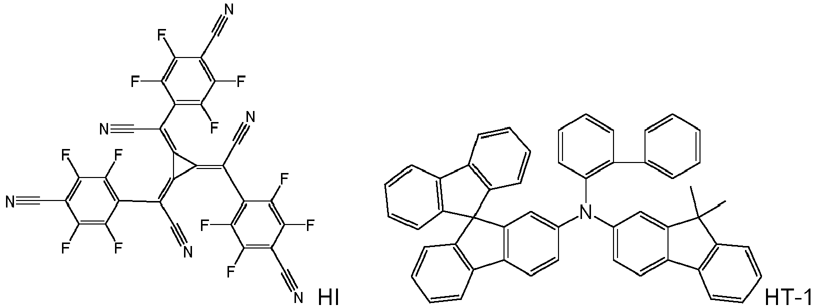

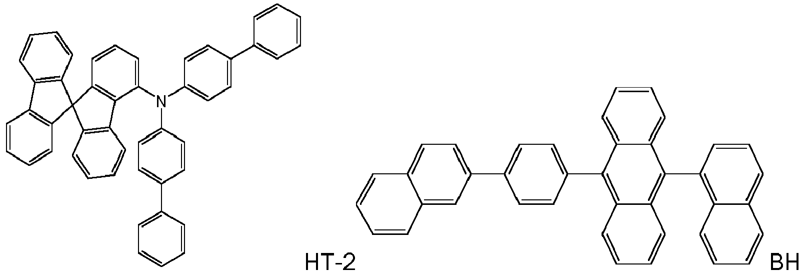

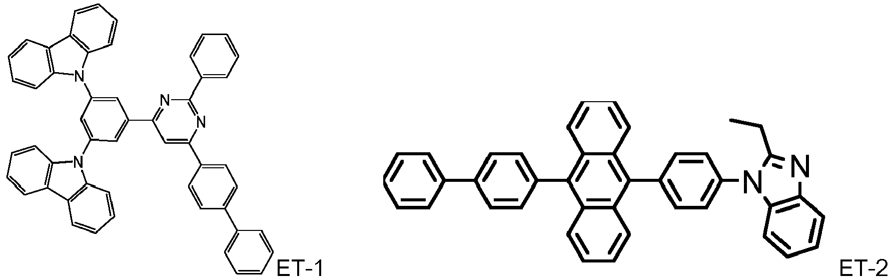

**Table 6: Results of the application examples ITO(130 nm)/HT-1:HI(10 nm; 3%)/HT-1(80 nm)/HT-2(10 nm)/BH:BD(25 nm)/ET-1(10 nm)/ET-2(15 nm)/LiF(1 nm)/AI(50 nm)**

| Example | BD | ELₘₐₓ (nm) | FHWM (nm) | EQE (%) |
|---|---|---|---|---|
| Ex. 1 | **Compound 1** | 450 | 24 | 9.0 |
| Com. Ex. 1 | **Comparative Compound 1** | 448 | 19 | 6.4 |

| | | | | |
|---|---|---|---|---|
| ELₘₐₓ, FHWM and EQE are reported at the current density of 10 mA/cm². | | | | |

## Claims

1. A compound represented by formula (I) 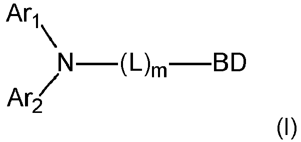 wherein
BD represents an organic fluorescent chromophore whose fluorescence peak maximum is found between 435 nm and 470 nm, preferably between 440 nm and 465 nm and more preferably between 445 nm and 460 nm, whose fluorescence full width at half maximum is smaller than 30 nm and whose photoluminescence quantum yield is higher than 70%, preferably higher than 80%;
wherein the compound of formula (I) having a HOMO of more than 70%, preferably more than 80% electron density localized on the Ar₁Ar₂N-(L)ₘ unit and having an energy of lower than 4.9 eV in absolute numbers;
a HOMO-1 having more than 70%, preferably more than 80% electron density localized on the BD unit and has an energy of higher than 4.75 eV in absolute numbers; and
a LUMO having more than 70%, preferably more than 80% electron density localized on the BD unit;
L represents a direct bond or a linking group; L in a form of the linking group is preferably selected from the group consisting of a substituted or unsubstituted aromatic hydrocarbon group having 6 to 30 ring carbon atoms; a substituted or unsubstituted heterocyclic group having 5 to 30 ring atoms and a substituted or unsubstituted group 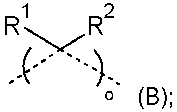
o is 1, 2 or 3, preferably 1; wherein in the case that o is 2 or 3, group (B) is in each case the same or different;
R¹ and R² each independently represents hydrogen, an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted; and/or
two residues R¹ and R² together form a ring structure which is unsubstituted or substituted;
the dotted lines in group (B) are bonding sites;
m is 1, 2 or 3, preferably 1; wherein in the case that m is 2 or 3, L is in each case the same or different;
Ar₁ and Ar₂ each independently represents a substituted or unsubstituted aryl group having 6 to 50 ring carbon atoms, a substituted or unsubstituted heterocyclic ring group having 5 to 50 ring atoms, a substituted or unsubstituted alkyl group having 1 to 30 carbon atoms, a substituted or unsubstituted aralkyl group having 7 to 50 ring carbon atoms; Ar₁ and Ar₂ may be connected together to form a saturated or unsaturated ring, wherein HOMO, HOMO-1 and LUMO are computed in vacuum at the optimized ground state geometry by density-functional theory using the Gaussian 16 software, B3LYP as the functional and 6-31 g(d) as the basis set; and
wherein the photoluminescence quantum yield is measured in toluene solution at a concentration of 5 x 10⁻⁶ M with an integrating sphere at a temperature of 295K.

2. The compound according to claim 1 having a lowest energy singlet emissive state computed by time-dependent DFT with an oscillator strength larger than 0.15, preferably larger than 0.2 and more preferably larger than 0.25, which is **characterized by** HOMO-1→LUMO transition with a contribution of larger than 72%, preferably larger than 80% and more preferably larger than 90% in vacuum from the optimized ground state geometry; and whose singlet excited state **characterized by** HOMO→LUMO transition with a contribution of larger than 72%, preferably larger than 80% and more preferably larger than 90% is non-emissive, having an oscillator strength smaller than 0.05, preferably smaller than 0.03 and more preferably smaller than 0.01.

3. The compound according to claim 1 or 2, wherein
BD is a group of formula (21) 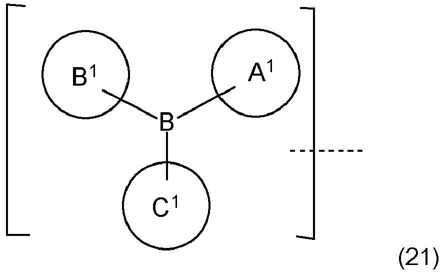 wherein, in the formula (21),
ring A¹ and ring B¹ each independently represents a substituted or unsubstituted aromatic hydrocarbon ring having 6 to 50 ring carbon atoms, or a substituted or unsubstituted heterocyclic ring having 5 to 50 ring atoms;
ring C¹ represents a substituted or unsubstituted aromatic hydrocarbon ring having 6 to 50 ring carbon atoms, or a substituted or unsubstituted heterocyclic ring having 5 to 50 ring atoms; wherein the ring C¹ is connected
(i) via a group X¹ to the ring A¹; or
C¹ and A¹ are connected and form the following group 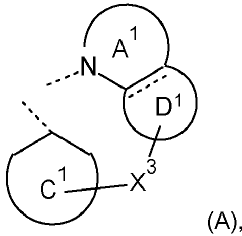 and
(ii) via a group X² to the ring B¹;
X¹, X² and X³ are each O, S, NR²³, SiR²⁴R²⁵ or CR²⁷R²⁸,;
R²³, R²⁴, R²⁵, R²⁷ and R²⁸ each independently represents an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted; and/or
two residues R²⁴ and R²⁵ and/or two residues R²⁷ and R²⁸ together form a ring structure which is unsubstituted or substituted,
and/or
one or more residues R²³ may be bonded to the ring B¹ and/or to the ring C¹ and/or to the ring A¹ to form a ring structure which is unsubstituted or substituted; and
in the case that X¹ and X² are NR²³, exactly one residue R²³ may be bonded to the ring B¹ or to the ring C¹ or to the ring A¹ to form a ring structure which is unsubstituted or substituted;
wherein the dotted lines in formula (A) are bonding sites to B;
wherein the dotted line in formula (21) is a bonding site to L.

4. The compound according to claim 3, wherein BD is a group selected from the group consisting of 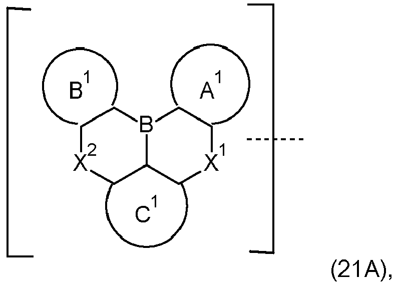 preferably a compound of formula (21Aa) or (21Ab) 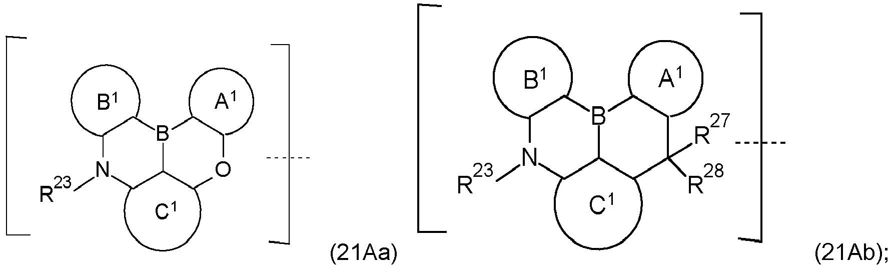 and 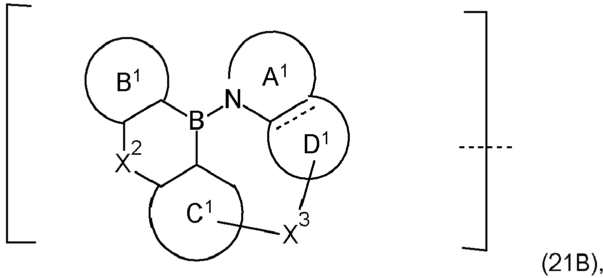 preferably a compound of formula (21Ba) or (21 Bb) 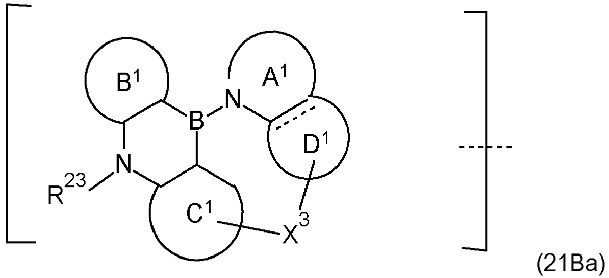 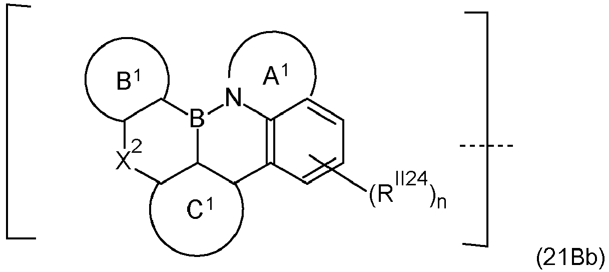 wherein,
the dotted line is a bonding site to L, and ring D¹ represents a substituted or unsubstituted aromatic hydrocarbon ring having 6 to 50 ring carbon atoms, or a substituted or unsubstituted heterocyclic ring having 5 to 50 ring atoms, which is fused via a single bond or via a double bond with ring A¹;
R^{II24} represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
n is 0, 1, 2 or 3, preferably 0 or 1.

5. The compound according to claim 4, wherein BD is a group selected from the groups consisting of 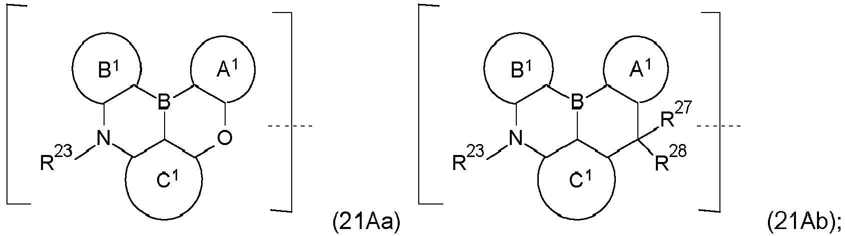 and

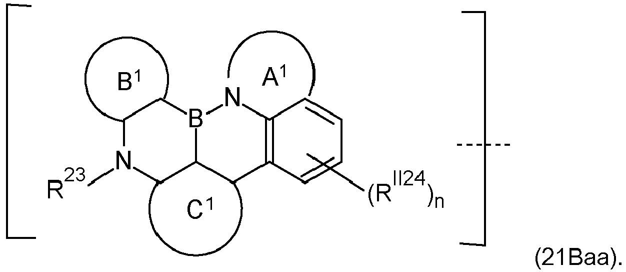

6. The compound according to any one of claims 1 to 5, wherein L represents a direct bond, an unsubstituted or substituted aromatic hydrocarbon group containing 6 to 25 ring atoms, preferably 6 to 18 ring atoms, or an unsubstituted or substituted heteroaromatic group containing 3 to 24 ring atoms, preferably 3 to 18 ring atoms or a substituted or unsubstituted group 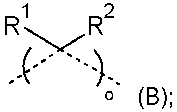
o is 1, 2 or 3, preferably 1; wherein in the case that o is 2 or 3, group (B) is in each case the same or different;
R¹ and R² each independently represents hydrogen or an alkyl group having from 1 to 50 carbon atoms which is unsubstituted or substituted;
the dotted lines in group (B) are bonding sites;
preferably, L represents a direct bond, an unsubstituted or substituted phenylene group, an unsubstituted or substituted naphthylene group, an unsubstituted or substituted divalent anthryl group, an unsubstituted or substituted divalent phenanthryl group, an unsubstituted or substituted divalent triphenylenyl group, an unsubstituted or substituted divalent 9,9-dimethyl fluorene group, an unsubstituted or substituted divalent 9,9-diphenyl fluorene group, an unsubstituted or substituted divalent 9,9-spirobifluorene group, an unsubstituted or substituted divalent heteroaromatic group containing 3 to 24 ring atoms, preferably 3 to 14 ring atoms or -C(CH₃)₂-; more preferably, L represents a direct bond, unsubstituted or substituted phenylene, e.g. unsubstituted or substituted 1,2-phenylene, unsubstituted or substituted 1,4-phenylene, unsubstituted or substituted 1,3-phenylene, unsubstituted or substituted naphthalene, e.g. unsubstituted or substituted 1,4-naphthalene, unsubstituted or substituted 1,5-naphthalene, unsubstituted or substituted 1,6-naphthalene, unsubstituted or substituted 2,6-naphthalene, unsubstituted 2,7-9,9-diphenyl-fluorene, unsubstituted 2,5-9,9-diphenyl-fluorene, unsubstituted 2,7-9,9-dimethyl-fluorene, unsubstituted 2,5-9,9-dimethyl-fluorene, unsubstituted 2,7-triphenylene, or an unsubstituted or substituted divalent heteroaromatic group containing 3 to 24 ring atoms, preferably 3 to 14 ring atoms; most preferably, L represents a direct bond, unsubstituted or substituted phenylene, e.g. unsubstituted 1,2-phenylene, unsubstituted 1,4-phenylene, unsubstituted 1,3-phenylene, 1,2-phenylene substituted with phenyl, naphthyl or phenanthryl, 1,4-phenylene substituted with phenyl, naphthyl or phenanthryl, 1,3-phenylene substituted with phenyl, naphthyl or phenanthryl, unsubstituted or substituted naphthalene, e.g. unsubstituted 1,4-naphthalene, unsubstituted 1,5-naphthalene, unsubstituted 1,6-naphthalene, unsubstituted 2,6-naphthalene, unsubstituted 2,7-9,9-diphenyl-fluorene, unsubstituted 2,5-9,9-diphenyl-fluorene, unsubstituted 2,7-9,9-dimethyl-fluorene, unsubstituted 2,5-9,9-dimethyl-fluorene, unsubstituted 2,7-triphenylene, or an unsubstituted divalent heteroaromatic group containing 3 to 24 ring atoms, preferably 3 to 14 ring atoms; further most preferably, L represents a direct bond, or unsubstituted or substituted phenylene, e.g. unsubstituted or substituted 1,2-phenylene, substituted 1,4-phenylene, unsubstituted or substituted 1,3-phenylene, even further most preferably, L represents substituted 1,4-phenylene, or unsubstituted or substituted 1,3-phenylene, even further most preferably, L represents unsubstituted or substituted 1,3-phenylene.

7. The compound according to any one of claims 1 to 6, wherein Ar₁ and Ar₂ each independently represents a substituted or unsubstituted phenyl group, a substituted or unsubstituted biphenyl group, a substituted or unsubstituted terphenyl group, a substituted or unsubstituted naphthyl group, a substituted or unsubstituted phenanthryl group, a substituted or unsubstituted triphenylenyl group, a substituted or unsubstituted fluorenyl group, a substituted or unsubstituted spirobifluorenyl group, a substituted or unsubstituted indenofluorenyl group, a substituted or unsubstituted carbazolyl group, a substituted or unsubstituted dibenzofuranyl group, a substituted or unsubstituted dibenzothiophenyl group, or the groups Ar₁ and Ar₂ are bonded to each other to form together with N a ring structure, such as a phenoxazine ring structure, a phenothiazine ring structure, a carbazole ring structure, or a acridane ring structure.

8. A compound represented by formula (I), 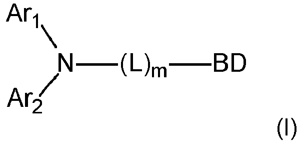 wherein
BD is a group selected from the groups consisting of 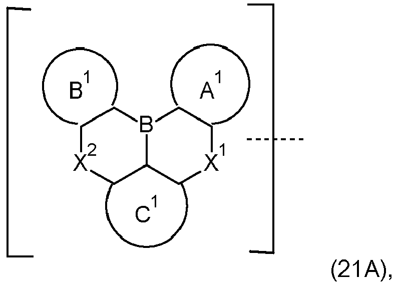 preferably a compound of formula (21Aa) or (21Ab) 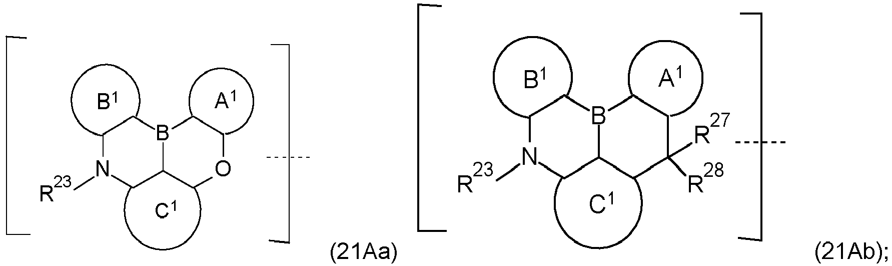 and 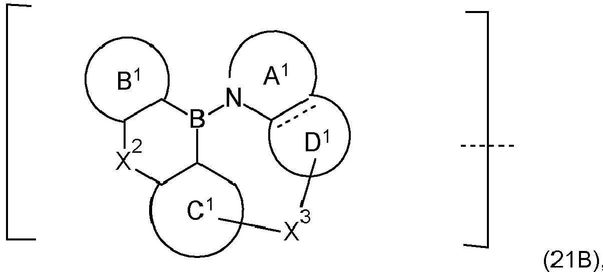 , preferably a compound of (21Ba) or (21 Bb) 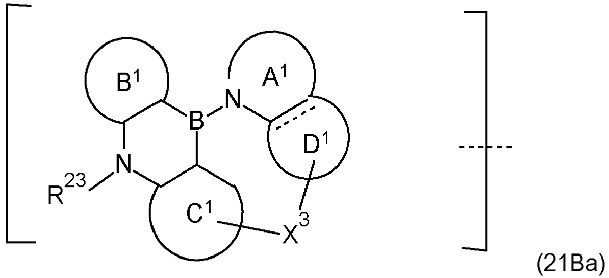 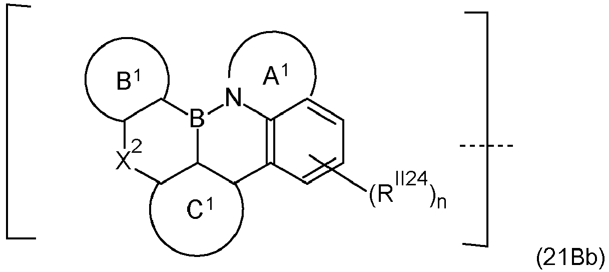 wherein
A¹ ring and B¹ ring each independently represents a substituted or unsubstituted aromatic hydrocarbon ring having 6 to 50 ring carbon atoms, or a substituted or unsubstituted heterocyclic ring having 5 to 50 ring atoms;
C¹ represents a substituted or unsubstituted aromatic hydrocarbon ring having 6 to 50 ring carbon atoms, or a substituted or unsubstituted heterocyclic ring having 5 to 50 ring atoms;
X¹, X² and X³ are each O, S, NR²³, SiR²⁴R²⁵ or CR²⁷R²⁸, ;
R^{II24} represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
ring D¹ represents a substituted or unsubstituted aromatic hydrocarbon ring having 6 to 50 ring carbon atoms, or a substituted or unsubstituted heterocyclic ring having 5 to 50 ring atoms, which is fused via a single bond or via a double bond with ring A¹;
n is 0, 1, 2 or 3, preferably 0 or 1;
R²³, R²⁴, R²⁵, R²⁷ and R²⁸ each independently represents an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
and/or
two residues R²⁴ and R²⁵ and/or two residues R²⁷ and R²⁸ together form a ring structure which is unsubstituted or substituted,
and/or
one or more residues R²³ may be bonded to the ring B¹ and/or to the ring C¹ and/or to the ring A¹ to form a ring structure which is unsubstituted or substituted;
in the case that X¹ and X² are NR²³, exactly one residue R²³ may be bonded to the ring B¹ or to the ring C¹ or to the ring A¹ to form a ring structure which is unsubstituted or substituted;;
wherein the dotted line in formula (21A) and (21B) is a bonding site to L;
L represents a linking group, preferably selected from the group consisting of a substituted or unsubstituted aromatic hydrocarbon group having 6 to 30 ring carbon atoms, a substituted or unsubstituted heterocyclic group having 5 to 30 ring atoms, and a substituted or unsubstituted group 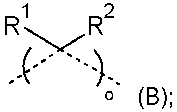
o is 1, 2 or 3, preferably 1; wherein in the case that o is 2 or 3, group (B) is in each case the same or different;
R¹ and R² each independently represents hydrogen, an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted; and/or
two residues R¹ and R² together form a ring structure which is unsubstituted or substituted;
the dotted lines in group (B) are bonding sites;
or
in the case that N of the group NAr₁Ar₂ is part of a 6-membered ring, L represents a direct bond or a linking group as defined above;
m is 1, 2 or 3, preferably 1; wherein in the case that m is 2 or 3 L is in each case the same or different;
Ar₁ and Ar₂ each independently represents a substituted or unsubstituted aryl group having 6 to 50 ring carbon atoms, a substituted or unsubstituted heterocyclic ring group having 5 to 50 ring atoms, a substituted or unsubstituted alkyl group having 1 to 30 carbon atoms, a substituted or unsubstituted aralkyl group having 7 to 50 ring carbon atoms; or Ar₁ and Ar₂ may be bonded together to form a saturated or unsaturated ring.

9. The compound according to any one of claims 1 to 8, having a molecular weight of at most 1500, preferably less than 1350 and more more preferably less than 1200.

10. A material, preferably an emitter material, for an organic electroluminescence device, comprising at least one compound according to any one of claims 1 to 9.

11. An organic electroluminescence device comprising at least one compound according to any one of claims 1 to 9.

12. The organic electroluminescence device according to claim 11, comprising a cathode, an anode and one or more organic thin film layers comprising an emitting layer disposed between the cathode and the anode, wherein at least one layer of the organic thin film layers comprises at least one compound according to any one of claims 1 to 9.

13. The organic electroluminescence device according to claim 12, wherein the light emitting layer comprises at least one compound according to any one of claims 1 to 9.

14. The organic electroluminescence device according to claim 13, wherein the light emitting layer comprises at least one host and at least one dopant, wherein the dopant comprises at least one compound according to any one of claims 1 to 9.

15. The organic electroluminescence device according to claim 14, wherein the host comprises at least one substituted or unsubstituted fused aromatic hydrocarbon compound and/or at least one substituted or unsubstituted anthracene compound.

16. The organic electroluminescence device according to claim 15, wherein the anthracene compound is represented by the following formula (10): 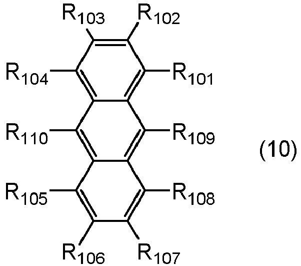 wherein
one or more pairs of two or more adjacent R₁₀₁ to R₁₁₀ may form a substituted or unsubstituted, saturated or unsaturated ring;
R₁₀₁ to R₁₁₀ that do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R₁₂₁)(R₁₂₂)(R₁₂₃),-C(=O)R₁₂₄, -COOR₁₂₅, -N(R₁₂₆)(R₁₂₇), a halogen atom, a cyano group, a nitro group, a substituted or unsubstituted aryl group including 6 to 50 ring carbon atoms, a substituted or unsubstituted monovalent heterocyclic group including 5 to 50 ring atoms, or a group represented by the following formula (31);
R₁₂₁ to R₁₂₇ are independently a hydrogen atom, a substituted or unsubstituted alkyl group including 1 to 50 carbon atoms, a substituted or unsubstituted cycloalkyl group including 3 to 50 ring carbon atoms, a substituted or unsubstituted aryl group including 6 to 50 ring carbon atoms or a substituted or unsubstituted monovalent heterocyclic group including 5 to 50 ring atoms; when each of R₁₂₁ to R₁₂₇ is present in plural, each of the plural R₁₂₁ to R₁₂₇ may be the same or different;
provided that at least one of R₁₀₁ to R₁₁₀ that do not form the substituted or unsubstituted, saturated or unsaturated ring is a group represented by the following formula (31). If two or more groups represented by the formula (31) are present, each of these groups may be the same or different;
-L₁₀₁-Ar₁₀₁ (31)
wherein in the formula (31),
L₁₀₁ is a single bond, a substituted or unsubstituted arylene group including 6 to 30 ring carbon atoms or a substituted or unsubstituted divalent heterocyclic group including 5 to 30 ring atoms;
Ar₁₀₁ is a substituted or unsubstituted aryl group including 6 to 50 ring carbon atoms or a substituted or unsubstituted monovalent heterocyclic group including 5 to 50 ring atoms.

17. The organic electroluminescence device according to any one of claims 13 to 16, wherein the the light emitting layer comprises 0.5 to 5 wt.% of at least one compound according to any one of claims 1 to 9, based on the total amount of the light emitting layer.

18. An electronic equipment comprising the organic electroluminescence device according to any one of claims 11 to 17.

19. A light emitting layer comprising at least one host and at least one dopant, wherein the dopant comprises at least one compound according to any one of claims 1 to 9.

20. Use of a compound of formula (I) according to any one of claims 1 to 9 in an organic electroluminescence device.
